(19) Europäisches Patentamt
European Patent Office
Office européen des brevets

(11) **EP 2 219 210 A1**

(12) **EUROPEAN PATENT APPLICATION**
published in accordance with Art. 153(4) EPC

(43) Date of publication:
**18.08.2010 Bulletin 2010/33**

(51) Int Cl.:
***H01L 21/336*** (2006.01)   ***H01L 29/78*** (2006.01)

(21) Application number: **07850094.9**

(22) Date of filing: **05.12.2007**

(86) International application number:
**PCT/JP2007/073452**

(87) International publication number:
**WO 2009/072192 (11.06.2009 Gazette 2009/24)**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **Unisantis Electronics (Japan) Ltd.
Chuo-ku
Tokyo 104-0033 (JP)**

(72) Inventors:
• **MASUOKA, Fujio
Tokyo 104-0033 (JP)**
• **KUDO, Tomohiko
Tokyo 104-0033 (JP)**

(74) Representative: **Röthinger, Rainer
Wuesthoff & Wuesthoff
Patent- und Rechtsanwälte
Schweigerstrasse 2
81541 München (DE)**

(54) **SEMICONDUCTOR DEVICE**

(57)   It is intended to solve a problem of increase in power consumption and reduction in operating speed due to an increase in parasitic capacitance of a surrounding gate transistor (SGT) as a three-dimensional semiconductor device, to provide an SGT achieving an increase in speed and power consumption reduction in a semiconductor circuit. The semiconductor device comprises a second-conductive type impurity region (510) formed in a part of a first-conductive type semiconductor substrate (100), a first silicon pillar (810) of an arbitrary cross-sectional shape formed on the second-conductive type impurity region, a first insulating body (310) surrounding a part of a surface of the first silicon pillar, a gate (210) surrounding the first insulating body, and a second silicon pillar (820) which is formed on the first silicon pillar and which includes a second-conductive type impurity region (540). The gate is disposed to be separated from the semiconductor substrate by a second insulating body and is disposed to be separated from the second silicon pillar by the second insulating body. The capacitance between the gate and the semiconductor substrate is less than a gate capacitance, and the capacitance between the gate and the second silicon pillar is less than the gate capacitance.

FIG. 2

**Description**

TECHNICAL FIELD

The present invention relates to a semiconductor device, and more specifically to a surrounding gate transistor (SGT) and a production method therefor.

BACKGROUND ART

A miniaturized planar transistor is used in a wide range of fields, such as computers, communication apparatuses, measurement instruments, automatic control units and domestic appliances, as a fundamental element of low-power consumption, low-cost and high-throughput microprocessors, ASICs and microcomputers and low-cost and large-capacity memories. However, the planar transistor is formed on a semiconductor substrate in a planar configuration, i.e., in a configuration where a source, a gate and drain are horizontally arranged along a surface of a silicon substrate. In contrast, an SGT has a structure where a source, a gate and a drain are arranged in a direction perpendicular to a silicon substrate, and wherein the gate is disposed to surround a convex-shaped semiconductor layer (see, for example, the following Non-Patent Document 1; FIG. 113). Thus, as compared with the planar transistor, the SGT is capable of significantly reducing a transistor occupancy area. However, in a conventional SGT structure, along with the progress in reducing the scale of the SGT structure, an area ratio of a gate electrode to a total transistor occupancy area becomes larger. In addition, due to reducing the scale of a silicon pillar, a resistance in each of source and drain regions formed in the silicon pillar is increased, and thereby an ON current is reduced.

For this reason, a buried-gate SGT (BG-SGT) has been proposed which has an SGT structure where a gate is buried in a silicon pillar (see, for example, the following Non-Patent Document 2; FIG. 114). In this structure, a silicon pillar can be formed to have a small-diameter channel region and large-diameter source and drain regions, so as to simultaneously meet a need for suppressing short-channel effects and a need for reducing a resistance in each of the source and drain regions, i.e., achieve a reduction in OFF-current and an increase in ON-current.

However, as regards to a need for ensuring a low parasitic capacitance to achieve an increase in speed and power consumption reduction in an LSI circuit, the conventional BG-SGT is incapable of achieving such a low parasitic capacitance between the gate and the source or between the gate and the drain.

In this connection, as a technique for reducing a gate-drain parasitic capacitance and a gate-source parasitic capacitance to achieve an increase in speed of the circuit, a vertical replacement gate (VRG)-MOSFET has been known (see, for example, the following Non-Patent Document 3 and Patent Document 1; FIG. 115) and other techniques (see, for example, the following Patent Document 2; FIG. 116).

FIG. 115 shows the VRG-MOSFET (the Patent Document 1). A gate adjacent a silicon pillar faces not only a silicon pillar through a gate oxide layer but also each of a source region and a drain region through an interlayer insulating film. Thus, in addition to a gate capacitance between the gate and the silicon pillar, parasitic capacitances are produced between the gate and the source and between the gate and the drain, respectively. A structure proposed here is intended to increase a film thickness of the interlayer insulating film between the gate and the source to increase a distance therebetween and increase a film thickness of the interlayer insulating film between the gate and the drain to increase a distance therebetween, so as to reduce the respective parasitic capacitances.

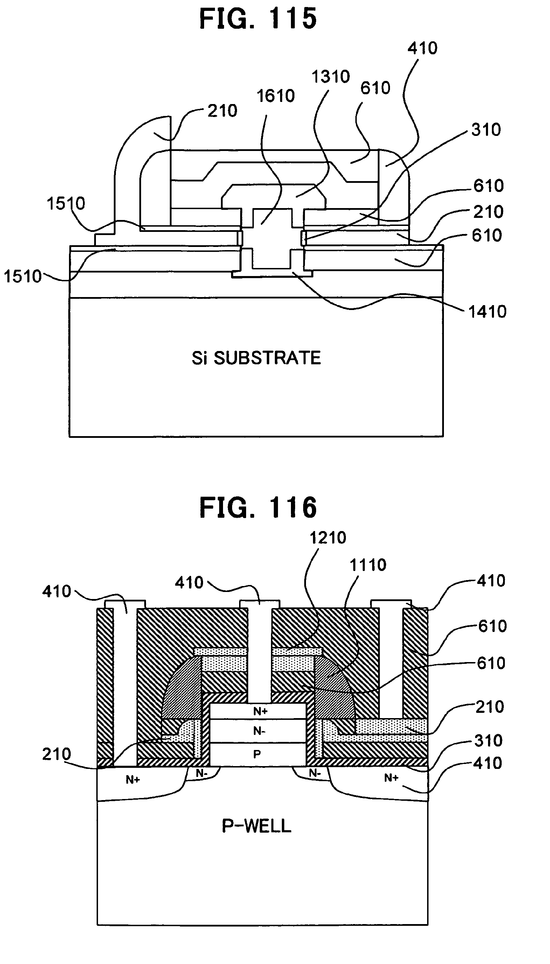

FIG. 116 shows an SGT having a structure intended to reduce a parasitic capacitance between a gate and a source, as disclosed in the Patent Document 2. A gate adjacent a silicon pillar faces not only a silicon pillar through a gate oxide layer but also a source region through an interlayer insulating film. Thus, in addition to a gate capacitance between the gate and the silicon pillar, a parasitic capacitance is produced between the gate and the source. A structure proposed here is intended to increase a film thickness of the interlayer insulating film between the gate and the source to increase a distance between the gate and the source, so as to reduce the parasitic capacitance.

Non-Patent Document 1: H. Takato et al, IEEE transaction on electron devices, Vol. 38, No. 3, March 1991, p 573-578
Non-Patent Document 2: M. Iwai et al, Extended Abstracts of the 2003 International Conference on Solid State Devices and Materials, Tokyo, 2003, p 630-631
Non-Patent Document 3: IEDM 1999 John M. Hergenrother
Patent Document 1: U.S. Patent No. 6,027,975 (Feb. 22, 2000, John M. Hergenrother)
Patent Document 2: U.S. Patent No. 5,504,359 (Apr. 2, 1996, Mark S. Rodder)

DISCLOSURE OF THE INVENTION

[PROBLEM TO BE SOLVED BY THE INVENTION]

In order to allow an SGT constituting an LST to actually achieve an increase in speed thereof, it is desirable that a parasitic capacitance be less than a gate capacitance. Although the SGT structure (such as the Patent Document 2) is intended to reduce a parasitic capacitance by a technique capable of reducing the parasitic capacitance as compared with the conventional structure (such as the Non-Patent Document 1), it may be assumed that the resulting parasitic capacitance is not less than a gate capacitance, or not sufficiently less than a gate capacitance. In the Patent Document 1 where the thickness of the interlayer film between the gate and the source is increased to reduce the parasitic capacitance as compared with the conventional structure, there is a problem that a parasitic capacitance less than a gate capacitance cannot be obtained without reducing an area of the gate facing the source region. In the Patent Document 2 where the thickness of the interlayer film between the gate and the source is greater than a thickness of the gate oxide film, there is also a problem that a parasitic capacitance less than a gate capacitance cannot be obtained without reducing an area of the gate facing the source region.
In view of the above problems, it is an object of the present invention to provide a semiconductor device designed to reduce a parasitic capacitance to solve the problem of reduction in operating speed of an SGT.

[MEANS FOR SOLVING THE PROBLEM]

In order to achieve the above object, according to a first aspect of the present invention, there is provided a semiconductor device which comprises: a second-conductive type impurity region formed in a part of a first-conductive type semiconductor substrate; a first silicon pillar of an arbitrary cross-sectional shape formed on the second-conductive type impurity region; a first insulating body surrounding a part of a surface of the first silicon pillar; a gate surrounding the first insulating body; and a second silicon pillar which is formed on the first silicon pillar and which includes a second-conductive type impurity region, wherein: the gate is disposed to be separated from the semiconductor substrate by the first insulating body and is disposed to be separated from the second silicon pillar by a second insulating body; and the capacitance between the gate and the semiconductor substrate is less than a gate capacitance, and the capacitance between the gate and the second silicon pillar is less than the gate capacitance.
Preferably, the capacitance between the gate and the semiconductor substrate is sufficiently less than the gate capacitance, and the capacitance between the gate and the second silicon pillar is sufficiently less than the gate capacitance.
Preferably, a cross-sectional area (unit: $nm^2$) of the gate is less than the value derived by multiplying a distance (unit: nm) between the gate and the semiconductor substrate separated by the second insulating body, by $2 \times 10^9$, and is less than the value derived by multiplying a distance (unit: nm) between the gate and the second silicon pillar separated by the second insulating body, by $2 \times 10^9$.
In another embodiment of the present invention, the first silicon pillar is comprised of a cross-sectionally circular-shaped silicon pillar, and each of the first insulating body surrounding the part of the surface of the first silicon pillar and the gate surrounding the first insulating body has a cross-sectionally circular ring shape.
In this case, the thickness $T_{gate1}$ (unit: $\mu$m) of one of opposite ends of the gate, and a distance $T_{space1}$ (unit: $\mu$m) between the gate and the semiconductor substrate separated by the second insulating body, satisfy the following relational expression:

$$2.0e6 \cdot T_{space1} < \pi T_{gate1}^{\;2} + 1.0e2 T_{gate1},$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$2.0e6 \cdot T_{space2} < \pi T_{gate2}^{\;2} + 1.0e2 T_{gate2}.$$

The one end and the other end of the gate may be a semiconductor substrate-side end and a second silicon pillar-side end of the gate, respectively.
In yet another embodiment of the present invention, the first silicon pillar is comprised of a cross-sectionally square-shaped silicon pillar, and each of the first insulating body surrounding the part of the surface of the first silicon pillar and the gate surrounding the first insulating body has a cross-sectionally square shape.

In this case, the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$2.0e6 \cdot T_{space1} < 4T_{gate1}^{\ 2} + 1.0e2T_{gate1},$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$2.0e6 \cdot T_{space2} < 4T_{gate2}^{\ 2} + 1.0e2T_{gate2}.$$

In still another embodiment of the present invention, the first silicon pillar is comprised of a cross-sectionally rectangular-shaped silicon pillar and each of the first insulating body surrounding the part of the surface of the first silicon pillar, and the gate surrounding the first insulating body has a cross-sectionally rectangular shape.

In this case, the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$3.0e6 \cdot T_{space1} < 4T_{gate1}^{\ 2} + 1.5e2T_{gate1},$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$3.0e6 \cdot T_{space2} < 4T_{gate2}^{\ 2} + 1.5e2T_{gate2}.$$

In a preferred embodiment of the present invention, the second insulating body may be made of $SiO_2$ or SiN, or has a layered structure of $SiO_2$ and SiN.

The first insulating body may be made of one selected from the group consisting of $SiO_2$, $HfO_2$, and SiON.

The gate may be made of a material selected from the group consisting of TaN, TiN, NiSi, $Ni_3Si$, $Ni_2Si$, PtSi, $Pt_3Si$, and W.

In a preferred embodiment of the present invention, the first silicon pillar may include a second-conductive type high-concentration impurity region adjacent the second-conductive type impurity region formed in the part of the semiconductor substrate, and a second-conductive type high-concentration impurity region adjacent the second silicon pillar.

The semiconductor device may further comprise a second-conductive type high-concentration impurity region formed in a part of the second silicon pillar.

The semiconductor device may further comprise a silicide region formed in a part of the second-conductive type impurity region formed in the part of the semiconductor substrate, and a silicide region formed in a part of a second-conductive type high-concentration impurity region of the second silicon pillar.

EFFECT OF THE INVENTION

The present invention can reduce a parasitic capacitance of a semiconductor device to provide a semiconductor device for a high-speed and low-power consumption ULSI (ultra large-scale integration) circuit.

BEST MODE FOR CARRYING OUT THE INVENTION

With reference to the drawings, a semiconductor device of the present invention will now be specifically described. As shown in the following Table, first to sixteen embodiments are different from each other in at least one of a cross-sectional shape of a first silicon pillar, a material of a second insulating body (interlayer film), and a material of a first insulating body (gate oxide layer).

| Embodiment | Cross-sectional shape of first silicon pillar | Second insulating body (interlayer film) 610, 620 | First insulating body (gate oxide layer) 310, 320 | FIGS. |
|---|---|---|---|---|
| 1 | Arbitrary shape | $SiO_2$ | $SiO_2$ | 1 - 7 |
| 2 | | SiN | $SiO_2$ | 8 - 14 |
| 3 | | $SiO_2$ | $HfO_2$ | 15 - 21 |
| 4 | | SiN | $HfO_2$ | 22 - 28 |
| 5 | Circular shape | $SiO_2$ | $SiO_2$ | 29 - 35 |
| 6 | | SiN | $SiO_2$ | 36 - 42 |
| 7 | | $SiO_2$ | $HfO_2$ | 43 - 49 |
| 8 | | SiN | $HfO_2$ | 50 - 56 |
| 9 | Square shape | $SiO_2$ | $SiO_2$ | 57 - 63 |
| 10 | | SiN | $SiO_2$ | 64 - 70 |
| 11 | | $SiO_2$ | $HfO_2$ | 71 - 77 |
| 12 | | SiN | $HfO_2$ | 78 - 84 |
| 13 | Rectangular shape | $SiO_2$ | $SiO_2$ | 85 - 91 |
| 14 | | SiN | $SiO_2$ | 92 - 98 |
| 15 | | $SiO_2$ | $HfO_2$ | 99 - 105 |
| 16 | | SiN | $HfO_2$ | 106 - 112 |

FIRST EMBODIMENT: SEMICONDUCTOR DEVICE

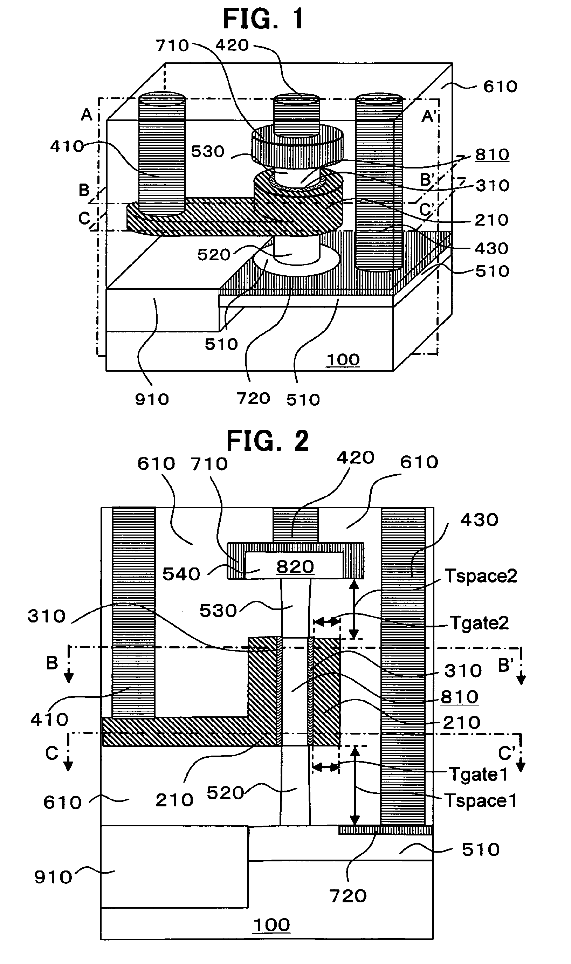

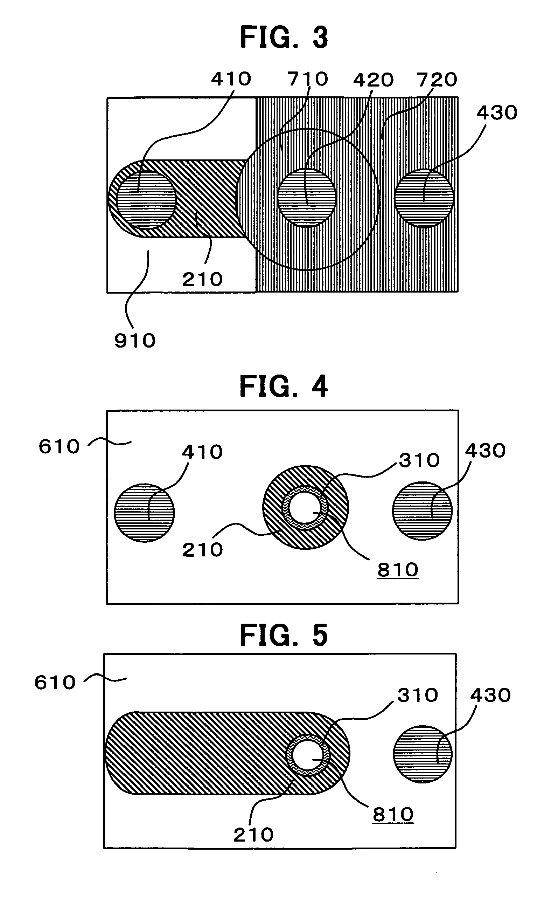

Each of first to fourth embodiments of the present invention is an example where a first silicon pillar 810 has an arbitrary shape in cross-section. FIG. 1 is a schematic bird's-eye view showing a transistor in a semiconductor device according to the first embodiment of the present invention. FIG. 2 is a schematic sectional view taken along the cutting-plane line A-A' in FIG. 1, and FIG. 3 is a top view of the transistor in FIG. 1. FIG. 4 is a schematic sectional view taken along the cutting-plane line B-B' in FIG. 2, and FIG. 5 is a schematic sectional view taken along the cutting-plane line C-C' in FIG. 2. The semiconductor device according to the first embodiment comprises a first silicon pillar 810 of an arbitrary cross-sectional shape formed on a first-conductive type semiconductor substrate 100, a first insulating body 310 surrounding a part of a surface of the first silicon pillar 810, a gate 210 surrounding the first insulating body 310, and a second silicon pillar 820 formed on a top of the first silicon pillar 810. The gate 210 is disposed to be separated from the semiconductor substrate 100 by a second insulating body 610. Further, the gate 210 is disposed to be separated from the second silicon pillar 820 by the second insulating body 610.

The semiconductor device further comprises a second-conductive type high-concentration impurity region 520 formed in a part of the first silicon pillar 810, a second-conductive type high-concentration impurity region 530 formed in a part of the first silicon pillar 810, a second-conductive type high-concentration impurity region 510 formed in a part of the semiconductor substrate 100, a second-conductive type high-concentration impurity region 540 formed in a part of the second silicon pillar 820, a silicide region 720 formed in a part of the second-conductive type high-concentration impurity region 510, a silicide region 710 formed in the second-conductive type high-concentration impurity region 540, a contact 430 formed on the silicide region 720, a contact 420 formed on the silicide region 710, a contact 410 formed on the gate 210, and an element isolation region 910 formed in the semiconductor substrate 100. Thus, the first silicon pillar 810 includes the high-concentration impurity region 520 and the high-concentration impurity region 530. The second silicon pillar 820 includes the high-concentration impurity region 540 and the silicide region 710. The first insulating body 310 (gate oxide layer) is made of $SiO_2$ and the second insulating body 610 (interlayer film) is made of $SiO_2$.

In order to reduce a parasitic capacitance in the first embodiment, it is desirable that a parasitic capacitance $C_{ov1}$ between the gate 210 and the semiconductor substrate 100 is less than a gate capacitance $C_g$, as shown in the following formula (1-1):

$$C_{ov1} < C_g \qquad (1\text{-}1)$$

Specifically, given that: a length of the gate 210 is 20 nm; a peripheral length of the first silicon pillar 810 is 31.4 nm; an equivalent film thickness $T_{ox}$ of the gate oxide layer 310 is 1 nm; and the interlayer film is made of $SiO_2$. A relationship of the capacitance $C_{ov1}$ between the gate 210 and the semiconductor substrate 100, a dielectric constant $\varepsilon_X$ of the interlayer film 610, a cross-sectional area S1 of a first one of opposite ends of the gate 210, and a distance $T_{space1}$ between the gate 210 and the semiconductor substrate 100, is expressed as the following formula (1-2), and then the formula (1-2) is assigned to the formula (1-1) to obtain the following formula (1-3):

$$C_{ov1} = \frac{\varepsilon_x S1}{T_{space1}} \qquad (1\text{-}2)$$

$$S1 < \frac{C_g}{\varepsilon_x} T_{space1} \qquad (1\text{-}3)$$

The gate capacitance $C_g$ is expressed as the following formula (1-4) which is a relational expression of a dielectric constant $\varepsilon_{0X}$ of $SiO_2$ which is a material of the gate oxide layer 310, the length 1 of the gate 210, the peripheral length w of the first silicon pillar 810, and the equivalent film thickness $T_{ox}$ of the gate oxide layer 310, and then the formula (1-4) is assigned to the formula (1-3) to obtain the following conditional formula (1-5) representing a relationship between the cross-sectional area S1 of the gate 210, and the distance $T_{space1}$ between the gate 210 and the semiconductor substrate 100:

$$C_g \approx \frac{\varepsilon_{ox} l w}{T_{ox}} \qquad (1\text{-}4)$$

$$S1 < \frac{\varepsilon_{ox} l w}{\varepsilon_x T_{ox}} T_{space1} = 6.3e2 T_{space1} \qquad (1\text{-}5)$$

As used herein, the term "gate capacitance" means the capacitance between two electrodes made up of the gate 210 and the first silicon pillar 810 through the gate oxide layer 310 interposed therebetween.

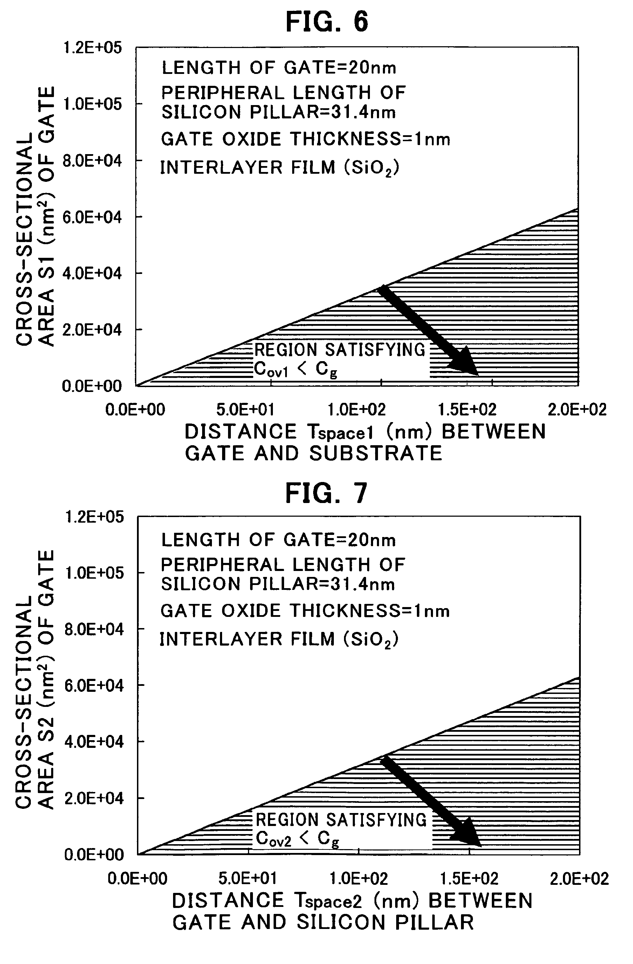

If the conditional formula (1-5) is satisfied, the formula (1-1) is satisfied. Thus, the following formula (1-6) is obtained (unit in the formulas (1-5) and (1-6): nm) (Fig. 6):

$$S1 < 6.3e2 T_{space\ 1} \Rightarrow C_{ov1} < C_g \qquad (1\text{-}6)$$

Typically, the peripheral length of the first silicon pillar 810 is set in the range of 1 nm to 100 μm, and the equivalent film thickness of the gate oxide layer 310 is set in the range of 0.5 to 100 nm, because an $SiO_2$ film or a high-dielectric constant film is used as the gate oxide layer 310. Further, the length of the gate 210 is set in the range of 5 nm to 10 μm, and the dielectric constant $\varepsilon_X$ of the interlayer film is set in the range of 3.8 to 7.6, because the interlayer film is made of $SiO_2$ or SiN. In this structure, conditions satisfying the formula (1-1) will be calculated. Given that: the peripheral length of the first silicon pillar 810 is 100 μm; the film thickness of the gate oxide layer 310 is 0.5 nm; the length of the gate 210 is 10 μm, and the dielectric constant $\varepsilon_X$ of the interlayer film is 3.9. The gate capacitance $C_g$ is expressed as the following formula (1-8) which is a relational expression of the dielectric constant $\varepsilon_{0X}$ of $SiO_2$ whichis a material of the gate oxide layer 310, the length 1 of the gate 210, the peripheral length w of the first silicon pillar 810, and the equivalent film thickness $T_{ox}$ of the gate oxide layer 310, and then the formula (1-8) is assigned to the formula (1-3) to obtain the following conditional formula (1-9) representing a relationship between the cross-sectional area S1 of the gate 210, and the distance $T_{space1}$ between the gate 210 and the semiconductor substrate 100:

$$C_g \approx \frac{\varepsilon_{ox} l w}{T_{ox}} \tag{1-8}$$

$$S1 < \frac{l w}{T_{ox}} T_{space1} = 2e9 T_{space1} \tag{1-9}$$

, wherein 2e9 is $2 \times 10^9$.

If the conditional formula (1-9) is satisfied, the formula (1-1) is satisfied. Thus, the following formula (1-10) is obtained, and then the following formula (1-11) is obtained from the formula (1-10) (unit in the formulas (1-9), (1-10) and (1-11): nm):

$$S1 < 2e9 T_{space1} \Rightarrow C_{ov1} < C_g \tag{1-10}$$

$$S1 \ll 2e9 T_{space1} \Rightarrow C_{ov1} \ll C_g \tag{1-11}$$

In FIG. 6, $C_{ov1}$ becomes less than $C_g$ in a region on the side of the arrowed direction.

Further, in order to reduce the parasitic capacitance in the first embodiment, it is desirable that a parasitic capacitance $C_{ov2}$ between the gate 210 and the second silicon pillar 820 is less than the gate capacitance $C_g$, as shown in the following formula (1-12):

$$C_{ov2} < C_g \tag{1-12}$$

Specifically, given that: the length of the gate 210 is 20 nm; the peripheral length of the first silicon pillar 810 is 31.4 nm; the equivalent film thickness $T_{ox}$ of the gate oxide layer 310 is 1 nm; and the interlayer film is made of $SiO_2$. A relationship of the capacitance $C_{ov2}$ between the gate 210 and the second silicon pillar 820, the dielectric constant $\varepsilon_X$ of the interlayer film 610, a cross-sectional area S2 of the other, second, end of the gate 210, and a distance $T_{space2}$ between the gate 210 and the second silicon pillar 820, is expressed as the following formula (1-13), and then the formula (1-13) is assigned to the formula (1-12) to obtain the following formula (1-14):

$$C_{ov2} = \frac{\varepsilon_x S2}{T_{space2}} \tag{1-13}$$

$$S2 < \frac{C_g}{\varepsilon_x} T_{space2} \qquad (1\text{-}14)$$

The gate capacitance $C_g$ is expressed as the following formula (1-15) which is a relational expression of the dielectric constant $\varepsilon_{0X}$ of $SiO_2$ as a material of the gate oxide layer 310, the length 1 of the gate 210, the peripheral length w of the first silicon pillar 810, and the equivalent film thickness $T_{ox}$ of the gate oxide layer 310, and then the formula (1-15) is assigned to the formula (1-14) to obtain the following conditional formula (1-16) representing a relationship of the cross-sectional area S2 of the gate 210, and the distance $T_{space2}$ between the gate 210 and the second silicon pillar 820 (unit in the formula (1-16): nm) (FIG. 7):

$$C_g \approx \frac{\varepsilon_{ox} lw}{T_{ox}} \qquad (1\text{-}15)$$

$$S2 < \frac{\varepsilon_{ox} lw}{\varepsilon_x T_{ox}} T_{space2} = 6.3e2 T_{space2} \qquad (1\text{-}16)$$

Typically, the peripheral length of the first silicon pillar 810 is set in the range of 1 nm to 100 $\mu$m, and the equivalent film thickness of the gate oxide layer 310 is set in the range of 0.5 to 100 nm, because an $SiO_2$ film or a high-dielectric constant film is used as the gate oxide layer 310. Further, the length of the gate 210 is set in the range of 5 nm to 10 $\mu$m, and the dielectric constant $\varepsilon_X$ of the interlayer film is set in the range of 3.8 to 7.6, because the interlayer film is made of $SiO_2$ or $SiN$. In this structure, conditions satisfying the formula (1-12) will be calculated. Given that: the peripheral length of the first silicon pillar 810 is 100 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (1-17) which is a relational expression of the dielectric constant $\varepsilon_{0X}$ of $SiO_2$ as a material of the gate oxide layer 310, the length 1 of the gate 210, the peripheral length w of the first silicon pillar 810, and the equivalent film thickness $T_{ox}$ of the gate oxide layer 310, and then the formula (1-17) is assigned to the formula (1-14) to obtain the following conditional formula (1-18) representing a relationship of the cross-sectional area S2 of the gate 210, and the distance $T_{space2}$ between the gate 210 and the second silicon pillar 820:
$$C_g \approx \frac{\varepsilon_{ox} lw}{T_{ox}} \qquad (1\text{-}17)$$

$$S2 < \frac{lw}{T_{ox}} T_{space2} = 2e9 T_{space2} \qquad (1\text{-}18)$$

If the conditional formula (1-18) is satisfied, the formula (1-12) is satisfied. Thus, the following formula (1-19) is obtained, and then the following formula (1-20) is obtained from the formula (1-19) (unit in the formulas (1-18), (1-19) and (1-20): nm):

$$S2 < 2e9 T_{space2} \Rightarrow C_{ov2} < C_g \qquad (1\text{-}19)$$

$$S2 \ll 2e9T_{space2} \Rightarrow C_{ov2} \ll C_g \qquad (1\text{-}20)$$

In FIG. 7, $C_{ov2}$ becomes less than $C_g$ in a region on the side of the arrowed direction.

SECOND EMBODIMENT: SEMICONDUCTOR DEVICE

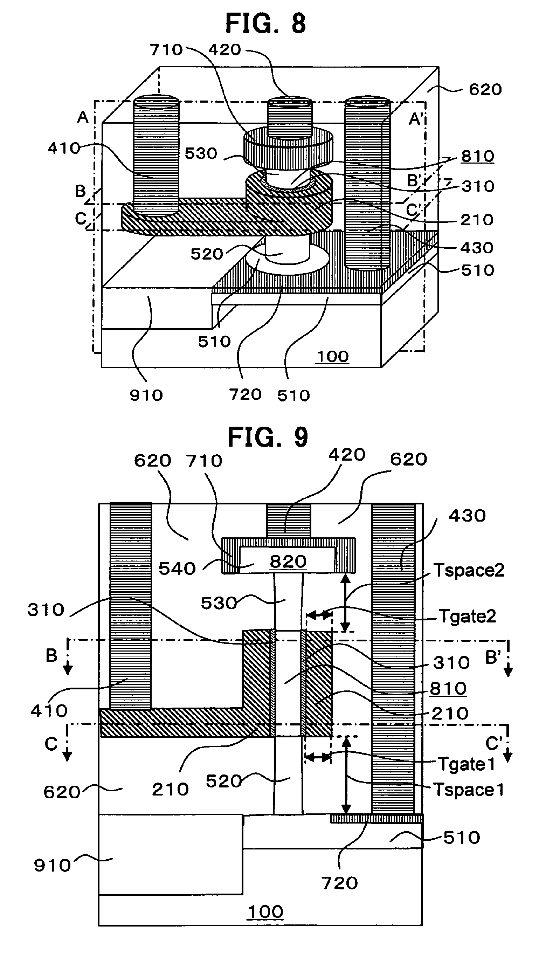

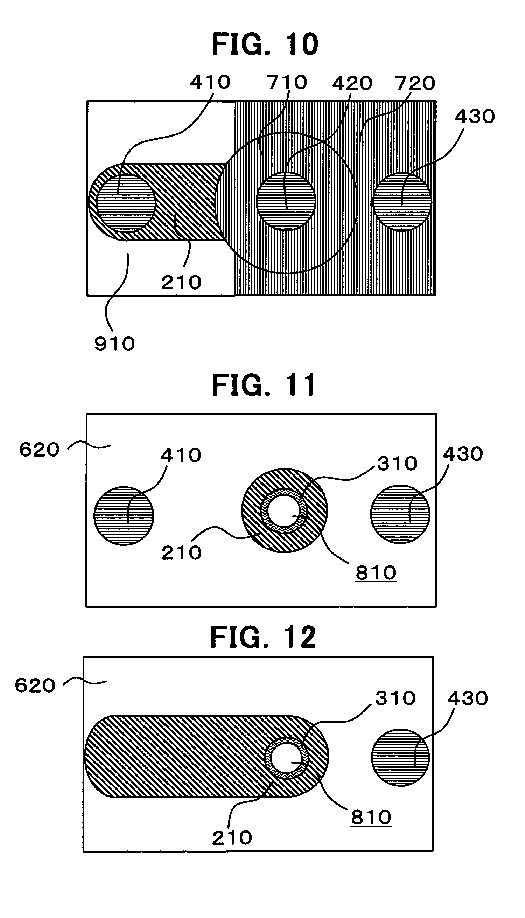

FIG. 8 is a schematic bird's-eye view showing a transistor in a semiconductor device according to the second embodiment of the present invention, wherein the semiconductor device according to the second embodiment is the same as that in the first embodiment, except that the interlayer film (second insulating body) 610 made of $SiO_2$ is replaced by an interlayer film 620 made of SiN. FIG. 9 is a schematic sectional view taken along the cutting-plane line A-A' in FIG. 8, and FIG. 10 is a top view of the transistor in FIG. 8. FIG. 11 is a schematic sectional view taken along the cutting-plane line B-B' in FIG. 9, and FIG. 12 is a schematic sectional view taken along the cutting-plane line C-C' in FIG. 9. As with the first embodiment, in order to reduce a parasitic capacitance in the second embodiment, it is desirable that the parasitic capacitance $C_{ov1}$ between the gate 210 and the semiconductor substrate 100 is less than the gate capacitance $C_g$, as shown in the following

$$C_{ov1} < C_g \qquad (2\text{-}1)$$

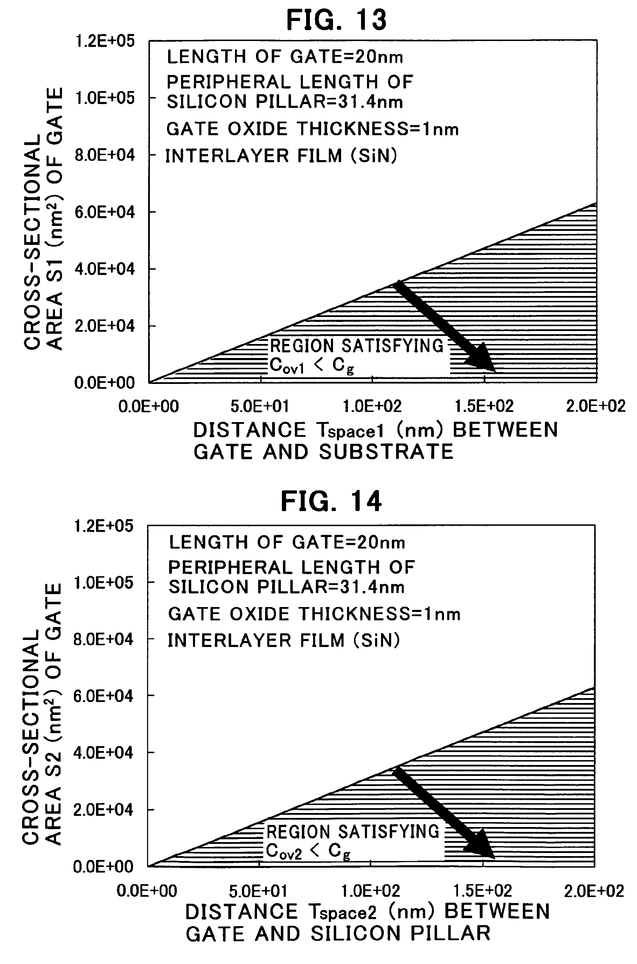

Specifically, given that: the length of the gate 210 is 20 nm; the peripheral length of the first silicon pillar 810 is 31.4 nm; the equivalent film thickness $T_{ox}$ of the gate oxide layer 310 is 1 nm; and the interlayer film is made of SiN. Based on the formula (1-5) in the first embodiment, the following conditional formula (2-2) representing a relationship of the cross-sectional area S1 of the gate 210, and the distance $T_{space1}$ between the gate 210 and the semiconductor substrate 100, is obtained (unit in the formulas (2-2): nm) (FIG. 13):

$$S1 < \frac{\varepsilon_{ox} lw}{\varepsilon_x T_{ox}} T_{space1} = 3.1e2 T_{space1} \qquad (2\text{-}2)$$

In FIG. 13, $C_{ov1}$ becomes less than $C_g$ in a region on the side of the arrowed direction.
Further, as with the first embodiment, in order to reduce the parasitic capacitance in the second embodiment where the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (2-3):

$$C_{ov2} < C_g \qquad (2\text{-}3)$$

Based on the formula (1-16) in the first embodiment, the following conditional formula (2-4) representing a relationship between the cross-sectional area S2 of the gate 210, and the distance $T_{space2}$ between the gate 210 and the second silicon pillar 820, is obtained (unit in the formula (2-4): nm (FIG. 14):

$$S2 < \frac{\varepsilon_{ox} lw}{\varepsilon_x T_{ox}} T_{space2} = 3.1e2 T_{space2} \qquad (2\text{-}4)$$

In FIG. 14, $C_{ov2}$ becomes less than $C_g$ in a region on the side of the arrowed direction.

THIRD EMBODIMENT: SEMICONDUCTOR DEVICE

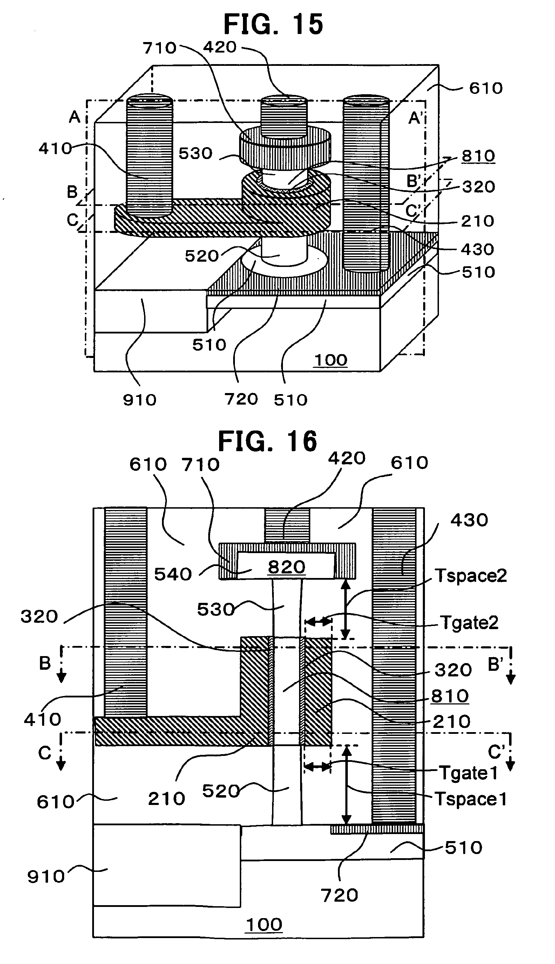

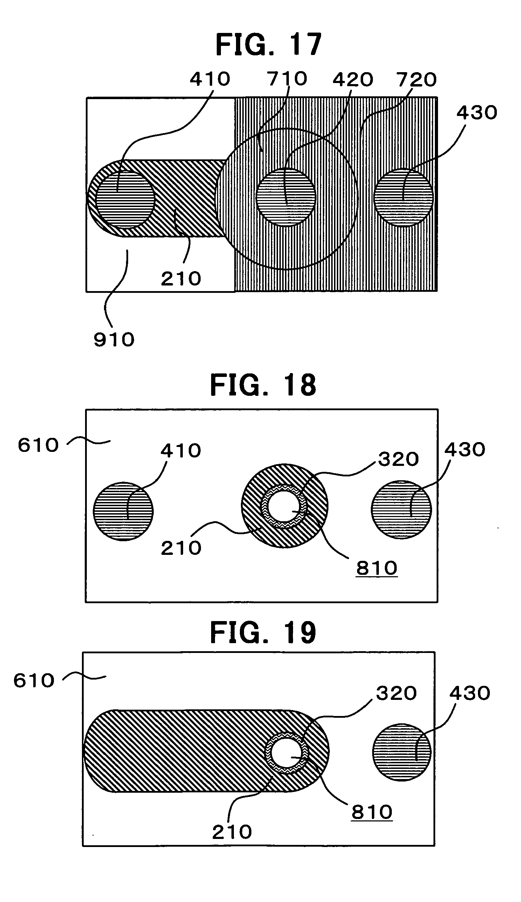

FIG. 15 is a schematic bird's-eye view showing a transistor in a semiconductor device according to the third embodiment of the present invention, wherein the semiconductor device according to the third embodiment is the same as that in the first embodiment, except that the gate oxide layer (first insulating body) 310 made of $SiO_2$ is replaced by a gate oxide layer 320 made of $HfO_2$. FIG. 16 is a schematic sectional view taken along the cutting-plane line A-A' in FIG. 15, and FIG. 17 is a top view of the transistor in FIG. 15. FIG. 18 is a schematic sectional view taken along the cutting-plane line B-B' in FIG. 16, and FIG. 19 is a schematic sectional view taken along the cutting-plane line C-C' in FIG. 16. As with the first embodiment, in order to reduce a parasitic capacitance in the third embodiment, it is desirable that the parasitic capacitance $C_{ov1}$ between the gate 210 and the semiconductor substrate 100 is less than the gate capacitance $C_g$, as shown in the following formula (3-1):

$$C_{ov1} < C_g \qquad\qquad (3\text{-}1)$$

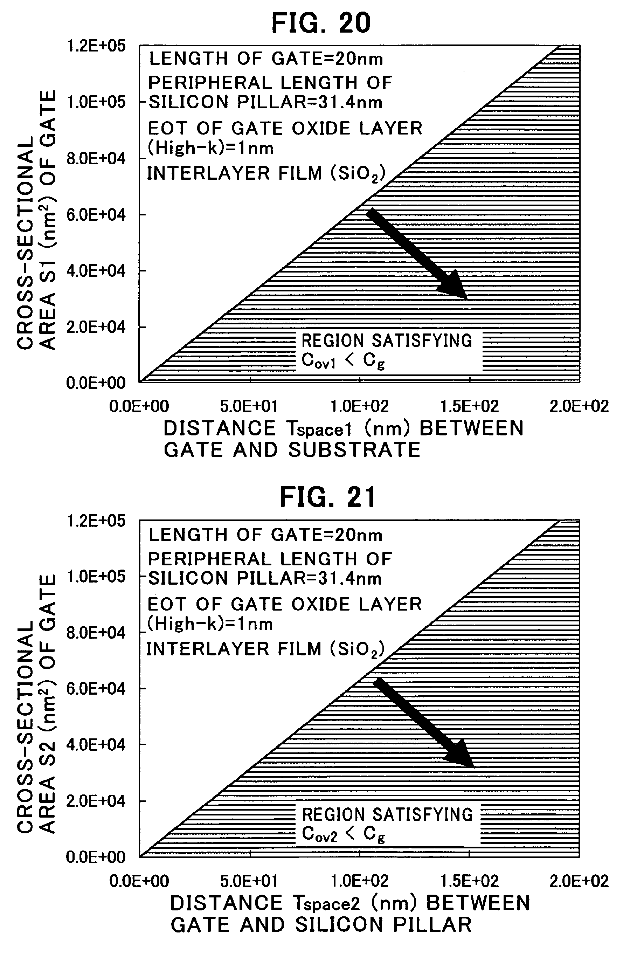

Specifically, given that: the length of the gate 210 is 20 nm; the peripheral length of the first silicon pillar 810 is 31.4 nm; the equivalent film thickness $T_{ox}$ of the gate oxide layer 320 is 1 nm; and the interlayer film is made of $SiO_2$. Based on the formula (1-5) in the first embodiment, the following conditional formula (3-2) representing a relationship between the cross-sectional area S1 of the gate 210, and the distance $T_{space1}$ between the gate 210 and the semiconductor substrate 100, is obtained (unit in the formulas (3-2): nm) (FIG. 20):

$$S1 < \frac{\varepsilon_{ox} lw}{\varepsilon_x T_{ox}} T_{space1} = 6.3e2 T_{space1} \qquad\qquad (3\text{-}2)$$

In FIG. 20, $C_{ov1}$ becomes less than $C_g$ in a region on the side of the arrowed direction.

Further, as with the first embodiment, in order to reduce the parasitic capacitance in the third embodiment where the interlayer film 610 is made of $SiO_2$ and the gate oxide layer 320 is made of $HfO_2$, it is desirable that the parasitic capacitance $C_{vo2}$ between the gate 210 and the second silicon pillar 820 is less than the gate capacitance $C_g$, as shown in the following formula (3-3):

$$C_{ov2} < C_g \qquad\qquad (3\text{-}3)$$

Based on the formula (1-16) in the first embodiment, the following conditional formula (3-4) representing a relationship between the cross-sectional area S2 of the gate 210, and the distance $T_{space2}$ between the gate 210 and the second silicon pillar 820, is obtained (unit in the formula (3-4): nm) (FIG. 21):

$$S2 < \frac{\varepsilon_{ox} lw}{\varepsilon_x T_{ox}} T_{space2} = 6.3e2 T_{space2} \qquad\qquad (3\text{-}4)$$

In FIG. 21, $C_{ov2}$ becomes less than $C_g$ in a region on the side of the arrowed direction.

FOURTH EMBODIMENT: SEMICONDUCTOR DEVICE

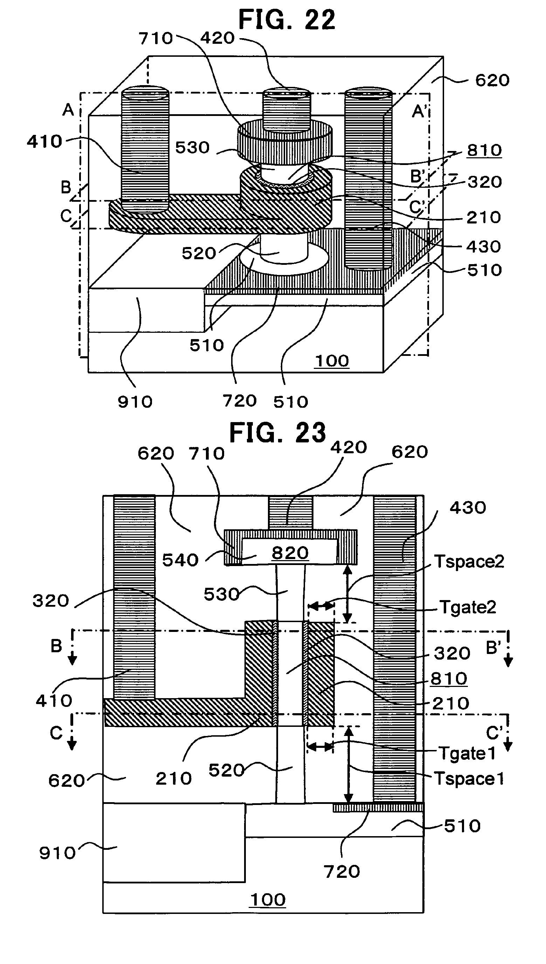

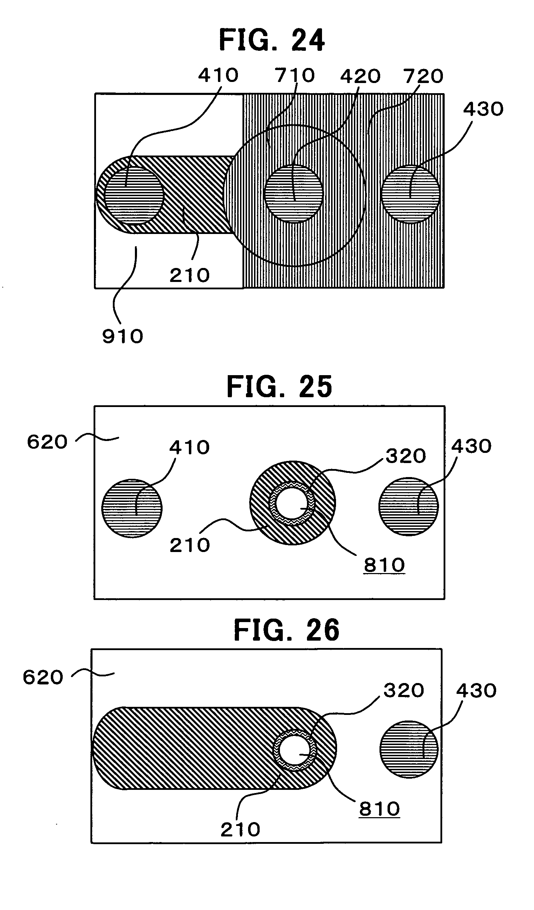

FIG. 22 is a schematic bird's-eye view showing a transistor in a semiconductor device according to the fourth embodiment of the present invention, wherein the semiconductor device according to the fourth embodiment is the same as that in the first embodiment, except that the interlayer film 610 made of $SiO_2$ is replaced by an interlayer film 620 made of SiN, and the gate oxide layer 310 made of $SiO_2$ is replaced by a gate oxide layer 320 made of $HfO_2$. FIG. 23 is a schematic sectional view taken along the cutting-plane line A-A' in FIG. 22, and FIG. 24 is a top view of the transistor in FIG. 22. FIG. 25 is a schematic sectional view taken along the cutting-plane line B-B' in FIG. 23, and FIG. 26 is a schematic sectional view taken along the cutting-plane line C-C' in FIG. 23. As with the first embodiment, in order to reduce a parasitic capacitance in the fourth embodiment, it is desirable that the parasitic capacitance $C_{ov1}$ between the gate 210 and the semiconductor substrate 100 is less than the gate capacitance $C_g$, as shown in the following formula (4-1):

$$C_{ov1} < C_g \qquad\qquad (4\text{-}1)$$

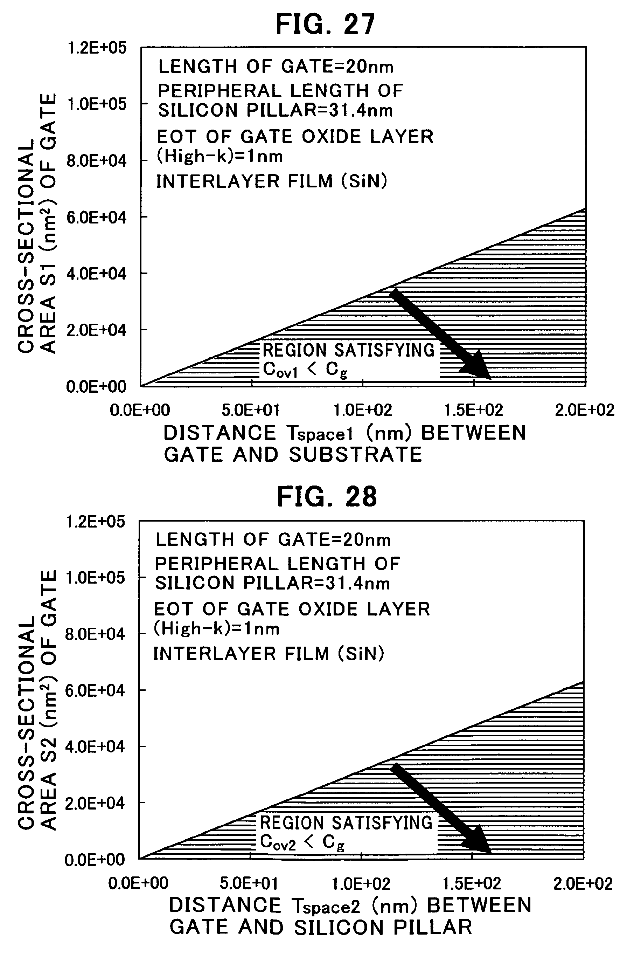

Specifically, given that: the length of the gate 210 is 20 nm; the peripheral length of the first silicon pillar 810 is 31.4 nm; the equivalent film thickness $T_{ox}$ of the gate oxide layer 320 is 1 nm; and the interlayer film is made of SiN. Based on the formula (1-5) in the first embodiment, the following conditional formula (4-2) representing a relationship between the cross-sectional area S1 of the gate 210, and the distance $T_{space1}$ between the gate 210 and the semiconductor substrate 100, is obtained (unit in the formulas (4-2): nm) (FIG. 27):

$$S1 < \frac{\varepsilon_{ox} lw}{\varepsilon_x T_{ox}} T_{space1} = 3.1e2 T_{space1} \qquad\qquad (4\text{-}2)$$

In FIG. 27, $C_{ov1}$ becomes less than $C_g$ in a region on the side of the arrowed direction.
Further, as with the first embodiment, in order to reduce the parasitic capacitance in the fourth embodiment where the interlayer film 620 is made of SiN and the gate oxide layer 320 is made of $HfO_2$, it is desirable that the parasitic capacitance $C_{ov2}$ between the gate 210 and the second silicon pillar 820 is less than the gate capacitance $C_g$, as shown in the following formula (4-3):

$$C_{ov2} < C_g \qquad\qquad (4\text{-}3)$$

Based on the formula (1-16) in the first embodiment, the following conditional formula (4-4) representing a relationship between the cross-sectional area S2 of the gate 210, and the distance $T_{space2}$ between the gate 210 and the second silicon pillar 820, is obtained (unit in the formula (4-4): nm) (FIG. 28):

$$S2 < \frac{\varepsilon_{ox} lw}{\varepsilon_x T_{ox}} T_{space2} = 3.1e2 T_{space2} \qquad\qquad (4\text{-}4)$$

In FIG. 28, $C_{ov2}$ becomes less than $C_g$ in a region on the side of the arrowed direction.

FIFTH EMBODIMENT: SEMICONDUCTOR DEVICE

Each of fifth to eighth embodiments of the present invention is an example where a first silicon pillar 810 has a circular shape in cross-section.
In the fifth embodiment, an after-mentioned first insulating body 310 (gate oxide layer) is made of $SiO_2$, and an after-mentioned second insulating body 610 (interlayer film) is made of $SiO_2$.

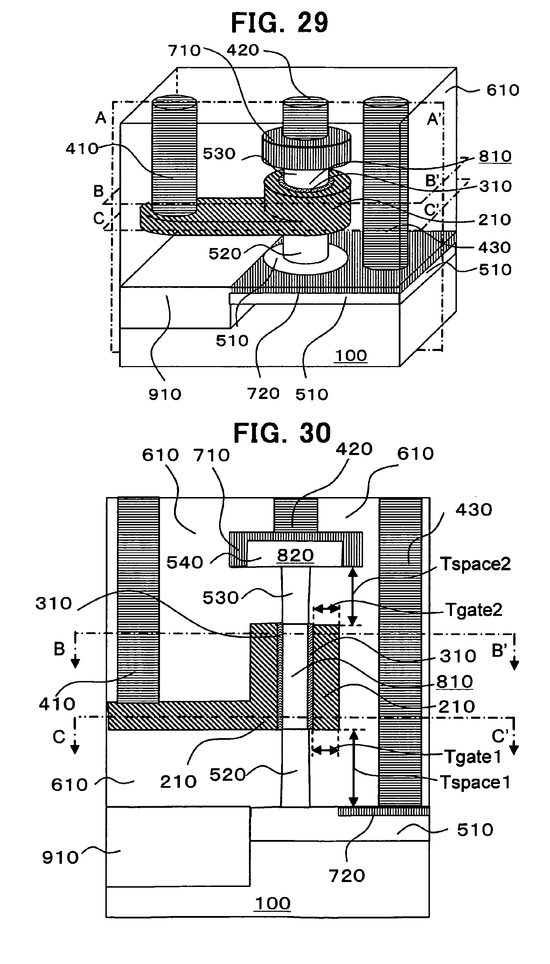

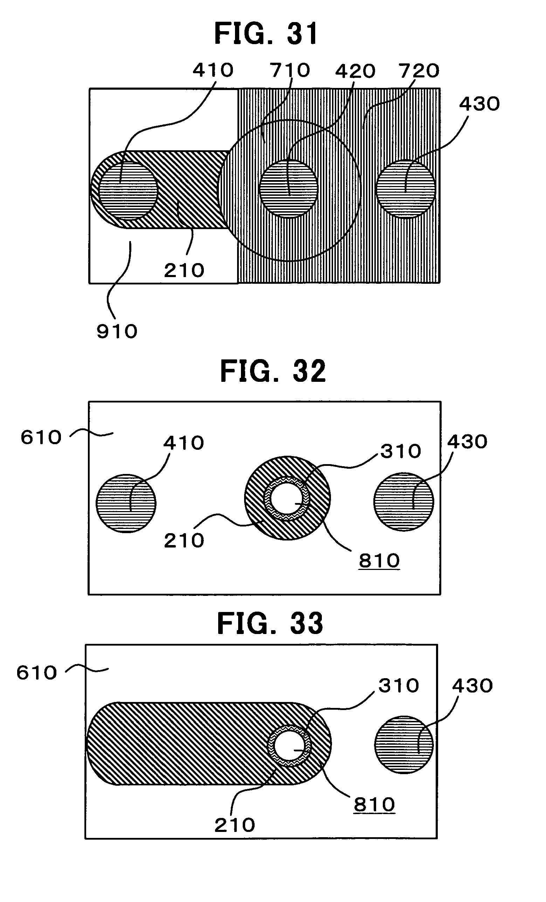

FIG. 29 is a schematic bird's-eye view showing a transistor in a semiconductor device according to the fifth embodiment of the present invention. FIG. 30 is a schematic sectional view taken along the cutting-plane line A-A' in FIG. 29, and FIG. 31 is a top view of the transistor in FIG. 29. FIG. 32 is a schematic sectional view taken along the cutting-plane line B-B' in FIG. 30, and FIG. 33 is a schematic sectional view taken along the cutting-plane line C-C' in FIG. 30. The semiconductor device according to the fifth embodiment comprises a cross-sectionally circular-shaped first silicon pillar 810 formed on a first-conductive type semiconductor substrate 100, a first insulating body 310 surrounding a part of a surface of the first silicon pillar 810, a gate 210 surrounding the first insulating body 310, and a second silicon pillar 820 formed on a top of the first silicon pillar 810. The gate 210 is disposed to be separated from the semiconductor substrate 100 by a second insulating body 610. Further, the gate 210 is disposed to be separated from the second silicon pillar 820 by the second insulating body 610.
The semiconductor device further comprises a second-conductive type high-concentration impurity region 520 formed in a part of the first silicon pillar 810, a second-conductive type high-concentration impurity region 530 formed in a part of the first silicon pillar 810, a second-conductive type high-concentration impurity region 510 formed in a part of the semiconductor substrate 100, a second-conductive type high-concentration impurity region 540 formed in a part of the second silicon pillar 820, a silicide region 720 formed in a part of the second-conductive type high-concentration impurity region 510, a silicide region 710 formed in the second-conductive type high-concentration impurity region 540, a contact 430 formed on the silicide region 720, a contact 420 formed on the silicide region 710, a contact 410 formed on the gate 210, and an element isolation region 910 formed in the semiconductor substrate 100.

In order to reduce a parasitic capacitance in the fifth embodiment, it is desirable that a parasitic capacitance $C_{ov1}$ between the gate 210 and the semiconductor substrate 100 is less than a gate capacitance $C_g$, as shown in the following formula (5-1):

$$C_{ov1} < C_g \qquad (5\text{-}1)$$

Specifically, given that: a length of the gate 210 is 20 nm; a diameter of the first silicon pillar 810 is 10 nm; a film thickness $T_{ox}$ of the gate oxide layer 310 is 1 nm; and the interlayer film is made of $SiO_2$. A relationship of the capacitance $C_{ov1}$ between the gate 210 and the semiconductor substrate 100, a dielectric constant $\varepsilon_x$ of the interlayer film 610, a cross-sectional area S1 of the gate 210, and a distance $T_{space1}$ between the gate 210 and the semiconductor substrate 100, is expressed as the following formula (5-2), and then the formula (5-2) is assigned to the formula (5-1) to obtain the following formula (5-3):

$$C_{ov1} = \frac{\varepsilon_x S1}{T_{space1}} \qquad (5\text{-}2)$$

$$S1 < \frac{C_g}{\varepsilon_x} T_{space1} \qquad (5\text{-}3)$$

The gate capacitance $C_g$ is expressed as the following formula (5-4) which is a relational expression of a dielectric constant $\varepsilon_{0x}$ of the gate oxide layer 310, the length 1 of the gate 210, a radius R of the first silicon pillar 810, and the film thickness $T_{ox}$ of the gate oxide layer 310, and the cross-sectional area S1 of the gate 210 is expressed as the following formula (5-5) which is a relational expression of a gate film thickness $T_{gate1}$ of a first one of opposite ends of the gate, the radius R of the first silicon pillar 810 and the film thickness $T_{ox}$ of the gate oxide layer 310. Thus, the formulas (5-4) and (5-5) are assigned to the formula (5-3) to obtain the following conditional formula (5-6) representing a relationship between the cross-sectional area S1 of the gate 210, and the distance $T_{space1}$ between the gate 210 and the semiconductor substrate 100:

$$C_g = \frac{\varepsilon_{ox} \cdot 2\pi R l}{R \cdot \ln\left(1 + \dfrac{T_{ox}}{R}\right)} \qquad (5\text{-}4)$$

$$S1 = \pi\left(R + T_{ox} + T_{gate1}\right)^2 - \pi\left(R + T_{ox}\right)^2 \qquad (5\text{-}5)$$

$$\pi\left(R + T_{ox} + T_{gate1}\right)^2 - \pi\left(R + T_{ox}\right)^2 < \frac{\varepsilon_{ox} \cdot 2\pi R l}{\varepsilon_{ox} \cdot R \cdot \ln\left(1 + \dfrac{T_{ox}}{R}\right)} T_{space1} \qquad (5\text{-}6)$$

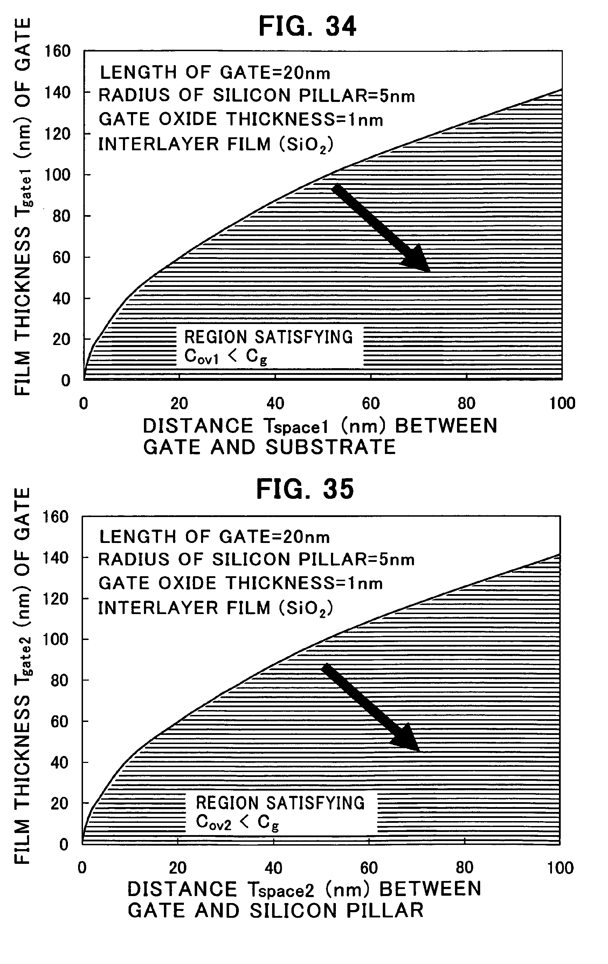

If the conditional formula (5-6) is satisfied, the formula (5-1) is satisfied. Thus, the following formula (5-7) is obtained (unit in the formula (5-7: nm) (FIG. 34):

$$6.9e2 \cdot T_{space1} < \pi(6 + T_{gate1})^2 - 1.1e2 \Rightarrow C_{ov2} < C_g \qquad (5\text{-}7)$$

Typically, the peripheral length of the first silicon pillar 810 is set in the range of 1 nm to 100 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (5-1) will be calculated. Given that: the peripheral length of the first silicon pillar 810 is 100 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (5-8) which is a relational expression of the dielectric constant $\varepsilon_{0X}$ of the gate oxide layer 310, the length 1 of the gate 210, the radius R of the first silicon pillar 810, and the film thickness $T_{ox}$ of the gate oxide layer 310, and the cross-sectional area S 1 of the gate 210 is expressed as the following formula (5-9) which is a relational expression of the gate film thickness $T_{gate1}$, the radius R of the first silicon pillar 810 and the film thickness $T_{ox}$ of the gate oxide layer 310. Thus, the formulas (5-8) and (5-9) are assigned to the formula (5-1) to obtain the following conditional formula (5-10) representing a relationship between the cross-sectional area S1 of the gate 210, and the distance $T_{space1}$ between the gate 210 and the semiconductor substrate 100:

$$S1 = \pi\left(R + T_{ox} + T_{gate2}\right)^2 - \pi\left(R + T_{ox}\right)^2 \qquad (5\text{-}8)$$

$$C_g = \frac{\varepsilon_{ox} \cdot 2\pi R l}{R \cdot \ln\left(1 + \dfrac{T_{ox}}{R}\right)} \qquad (5\text{-}9)$$

$$\pi\left(R + T_{ox} + T_{gate1}\right)^2 - \pi\left(R + T_{ox}\right)^2 < \frac{\varepsilon_{ox} \cdot 2\pi R l}{\varepsilon_{ox} \cdot R \cdot \ln\left(1 + \dfrac{T_{ox}}{R}\right)} T_{space1} \qquad (5\text{-}10)$$

If the conditional formula (5-10) is satisfied, the formula (5-1) is satisfied. Thus, the following formula (5-11) is obtained, and then the following formula (5-12) is obtained from the formula (5-11) (unit in the formulas (5-11) and (5-12): $\mu$m):

$$2.0e6 \cdot T_{space1} < \pi T_{gate1}^2 + 1.0e2 T_{gate1} \Rightarrow C_{ov1} < C_g \qquad (5\text{-}11)$$

$$2.0e6 \cdot T_{space1} \ll \pi T_{gate1}^{\ 2} + 1.0e2 T_{gate1} \Rightarrow C_{ov1} \ll C_g \qquad (5\text{-}12)$$

In FIG. 34, $C_{vo1}$ becomes less than $C_g$ in a region on the side of the arrowed direction.

Further, in order to reduce the parasitic capacitance in the fifth embodiment, it is desirable that a parasitic capacitance $C_{ov2}$ between the gate 210 and the second silicon pillar 820 is less than the gate capacitance $C_g$, as shown in the following formula (5-13):

$$C_{ov2} < C_g \qquad (5\text{-}13)$$

Specifically, given that: the length of the gate 210 is 20 nm; the diameter of the first silicon pillar 810 is 10 nm; the film thickness $T_{ox}$ of the gate oxide layer 310 is 1 nm; and the interlayer film is made of $SiO_2$. A relationship of the capacitance $C_{ov2}$ between the gate 210 and the second silicon pillar 820, the dielectric constant $\varepsilon_X$ of the interlayer film 610, a cross-sectional area S2 of the gate 210, and a distance $T_{space2}$ between the gate 210 and the second silicon pillar 820, is expressed as the following formula (5-14), and then the formula (5-14) is assigned to the formula (5-13) to obtain the following formula (5-15):

$$C_{ov2} = \frac{\varepsilon_x S2}{T_{space2}} \qquad (5\text{-}14)$$

$$S2 < \frac{C_g}{\varepsilon_x} T_{space2} \qquad (5\text{-}15)$$

The gate capacitance $C_g$ is expressed as the following formula (5-16) which is a relational expression of the dielectric constant $\varepsilon_{0X}$ of the gate oxide layer 310, the length 1 of the gate 210, the radius R of the first silicon pillar 810, and the film thickness $T_{ox}$ of the gate oxide layer 310, and the cross-sectional area S2 of the gate 210 is expressed as the following formula (5-17) which is a relational expression of a gate film thickness $T_{gate2}$ of the other, second end of the gate 210, the radius R of the first silicon pillar 810 and the film thickness $T_{ox}$ of the gate oxide layer 310. Thus, the formulas (5-16) and (5-17) are assigned to the formula (5-15) to obtain the following conditional formula (5-18) representing a relationship between the cross-sectional area S2 of the gate 210, and the distance $T_{space2}$ between the gate 210 and the second silicon pillar 820:

$$C_g = \frac{\varepsilon_{ox} \cdot 2\pi R l}{R \cdot \ln\left(1 + \dfrac{T_{ox}}{R}\right)} \qquad (5\text{-}16)$$

$$S2 = \pi\left(R + T_{ox} + T_{gate1}\right)^2 - \pi\left(R + T_{ox}\right)^2 \qquad (5\text{-}17)$$

$$\pi\left(R + T_{ox} + T_{gate2}\right)^2 - \pi\left(R + T_{ox}\right)^2 < \frac{\varepsilon_{ox} \cdot 2\pi R l}{\varepsilon_{ox} \cdot R \cdot \ln\left(1 + \dfrac{T_{ox}}{R}\right)} T_{space2} \qquad (5\text{-}18)$$

If the conditional formula (5-18) is satisfied, the formula (5-13) is satisfied. Thus, the following formula (5-19) is obtained (unit in the formulas (5-19): nm (FIG. 35):

$$6.9e2 \cdot T_{space2} < \pi(6 + T_{gate2})^2 - 1.1e2 \Rightarrow C_{ov2} < C_g \qquad (5\text{-}19)$$

Typically, the peripheral length of the first silicon pillar 810 is set in the range of 1 nm to 100 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (5-13) will be calculated. Given that: the peripheral length of the first silicon pillar 810 is 100 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (5-20) which is a relational expression of the dielectric constant $\varepsilon_{0X}$ of the gate oxide layer 310, the length l of the gate 210, the radius R of the first silicon pillar 810, and the film thickness $T_{ox}$ of the gate oxide layer 310, and the cross-sectional area S2 of the gate 210 is expressed as the following formula (5-21) which is a relational expression of the gate film thickness $T_{gate2}$, the radius R of the first silicon pillar 810 and the film thickness $T_{ox}$ of the gate oxide layer 310. Thus, the formulas (5-20) and (5-21) are assigned to the formula (5-13) to obtain the following conditional formula (5-22) representing a relationship between the cross-sectional area S2 of the gate 210, and the distance $T_{space2}$ between the gate 210 and the second silicon pillar 820:
$$S2 = \pi\left(R + T_{ox} + T_{gate2}\right)^2 - \pi\left(R + T_{ox}\right)^2 \qquad (5\text{-}20)$$

$$C_g = \frac{\varepsilon_{ox} \cdot 2\pi R l}{R \cdot \ln\left(1 + \dfrac{T_{ox}}{R}\right)} \qquad (5\text{-}21)$$

$$\pi\left(R + T_{ox} + T_{gate2}\right)^2 - \pi\left(R + T_{ox}\right)^2 < \frac{\varepsilon_{ox} \cdot 2\pi R l}{\varepsilon_{ox} \cdot R \cdot \ln\left(1 + \dfrac{T_{ox}}{R}\right)} T_{space2} \qquad (5\text{-}22)$$

If the conditional formula (5-22) is satisfied, the formula (5-13) is satisfied. Thus, the following formula (5-23) is obtained, and then the following formula (5-24) is obtained from the formula (5-23) (unit in the formulas (5-23) and (5-24): $\mu$m):

$$2.0e6 \cdot T_{space2} < \pi T_{gate2}^{\,2} + 1.0e2 T_{gate2} \Rightarrow C_{ov2} < C_g \qquad (5\text{-}23)$$

$$2.0e6 \cdot T_{space2} << \pi T_{gate2}^{\,2} + 1.0e2 T_{gate2} \Rightarrow C_{ov2} << C_g \qquad (5\text{-}24)$$

In FIG. 35, $C_{ov2}$ becomes less than $C_g$ in a region on the side of the arrowed direction.

SIXTH EMBODIMENT: SEMICONDUCTOR DEVICE

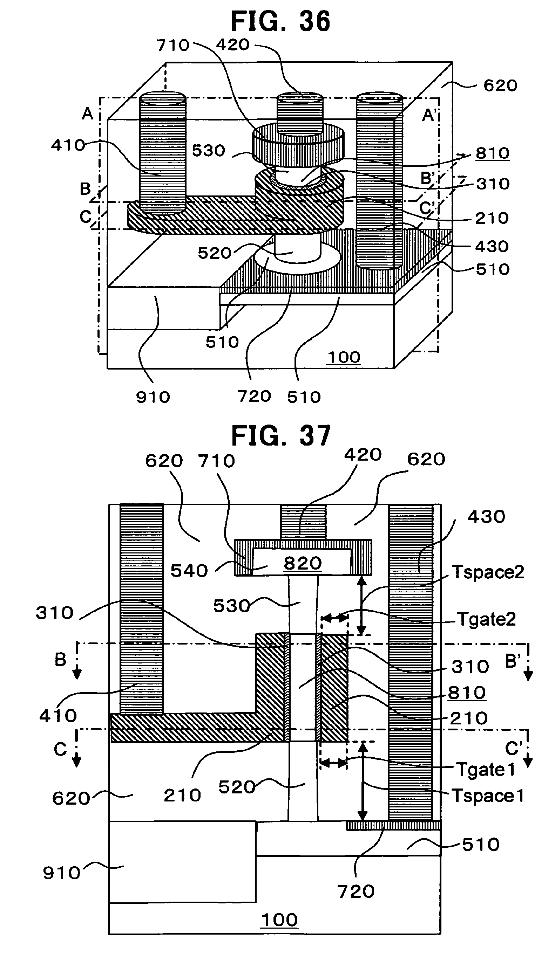

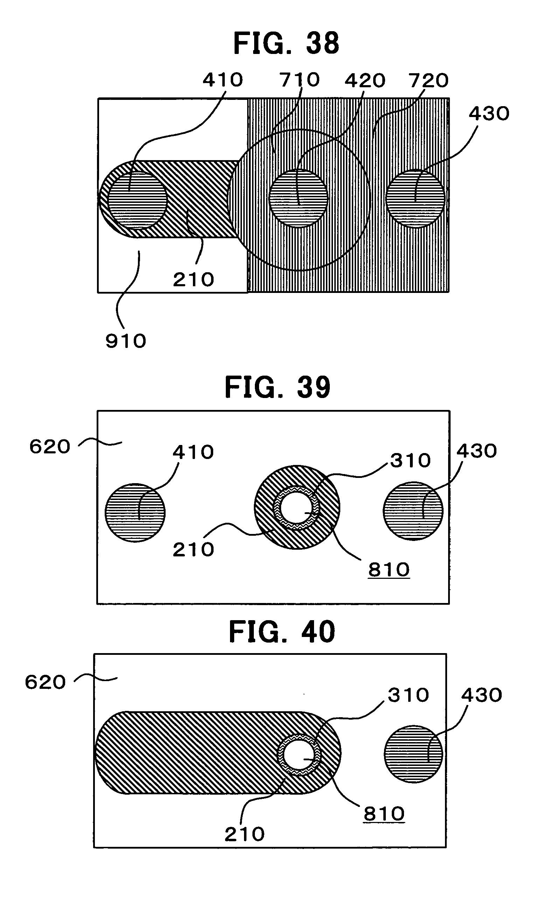

FIG. 36 is a schematic bird's-eye view showing a transistor in a semiconductor device according to the sixth embodiment of the present invention, wherein the semiconductor device according to the sixth embodiment is the same as that in the fifth embodiment, except that the interlayer film 610 made of $SiO_2$ is replaced by an interlayer film 620 made of SiN. FIG. 37 is a schematic sectional view taken along the cutting-plane line A-A' in FIG. 36, and FIG. 38 is a top view of the transistor in FIG. 36. FIG. 39 is a schematic sectional view taken along the cutting-plane line B-B' in FIG. 37, and FIG. 40 is a schematic sectional view taken along the cutting-plane line C-C' in FIG. 37. As with the fifth embodiment, in order to reduce a parasitic capacitance in the sixth embodiment, it is desirable that the parasitic capacitance $C_{ov1}$ between the gate 210 and the semiconductor substrate 100 is less than the gate capacitance $C_g$, as shown in the following formula (6-1):

$$C_{ov1} < C_g \qquad\qquad (6\text{-}1)$$

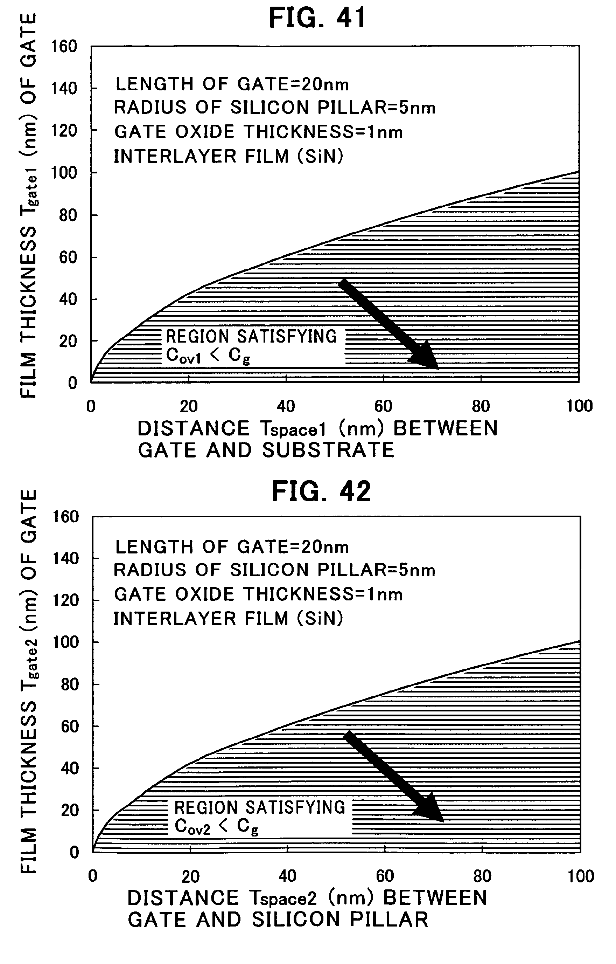

Specifically, given that: the length of the gate 210 is 20 nm; the diameter of the first silicon pillar 810 is 10 nm; and the film thickness $T_{ox}$ of the gate oxide layer 310 made of $SiO_2$ is 1.0 nm. Based on the formula (5-6) in the fifth embodiment, the following conditional formula (6-2) representing a relationship between the film thickness $T_{gate1}$ of the gate 210, and the distance $T_{spacet1}$ between the gate 210 and the semiconductor substrate 100, is obtained (unit in the formulas (6-2): nm) (FIG. 41):

$$3.4e2 \cdot T_{space1} < \pi(6 + T_{gate1})^2 - 1.1e2 \Rightarrow C_{ov1} < C_g \qquad (6\text{-}2)$$

In FIG. 41, $C_{ov1}$ becomes less than $C_g$ in a region on the side of the arrowed direction.

Further, as with the fifth embodiment, in order to reduce the parasitic capacitance in the sixth embodiment where the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (6-3):

$$C_{ov2} < C_g \qquad\qquad (6\text{-}3)$$

Based on the formula (5-18) in the fifth embodiment, the following conditional formula (6-4) representing a relationship between the film thickness $T_{gate2}$ of the gate 210, and the distance $T_{space2}$ between the gate 210 and the second silicon pillar 820, is obtained (unit in the formula (6-4): nm) (FIG. 42):

$$3.4e2 \cdot T_{space2} < \pi(6 + T_{gate2})^2 - 1.1e2 \Rightarrow C_{ov2} < C_g \qquad (6\text{-}4)$$

In FIG. 42, $C_{ov2}$ becomes less than $C_g$ in a region on the side of the arrowed direction.

SEVENTH EMBODIMENT: SEMICONDUCTOR DEVICE

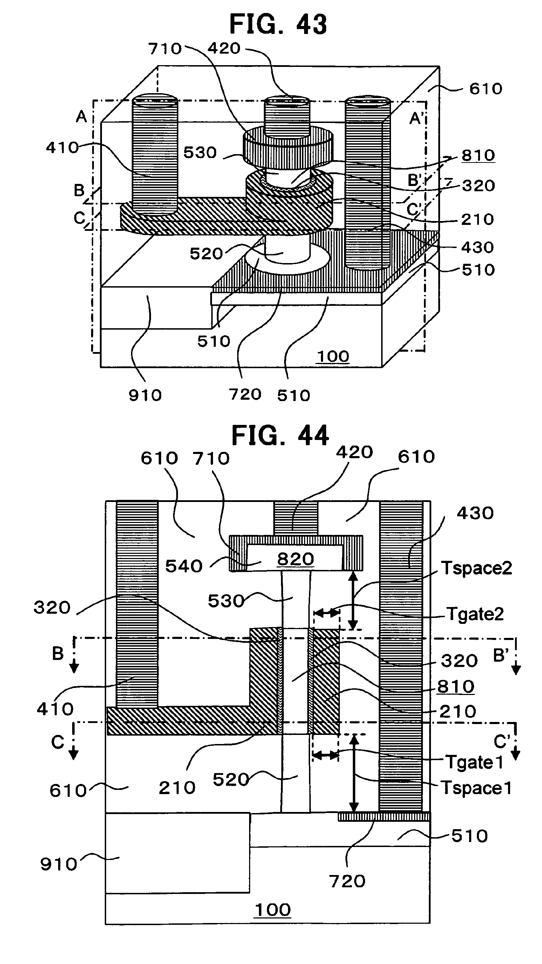

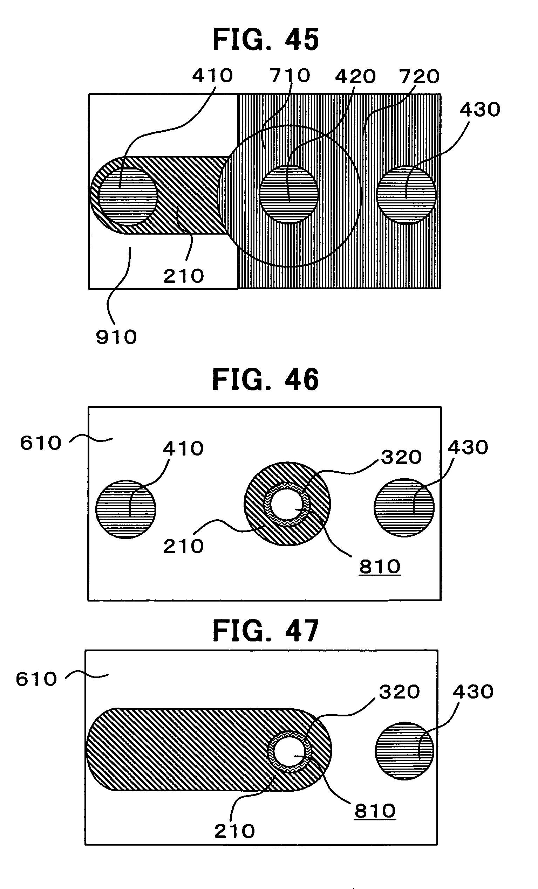

FIG. 43 is a schematic bird's-eye view showing a transistor in a semiconductor device according to the seventh embodiment of the present invention, wherein the semiconductor device according to the seventh embodiment is the same as that in the fifth embodiment, except that the gate oxide layer 310 made of $SiO_2$ is replaced by a gate oxide layer 320 made of $HfO_2$. FIG. 44 is a schematic sectional view taken along the cutting-plane line A-A' in FIG. 43, and FIG. 45 is a top view of the transistor in FIG. 43. FIG. 46 is a schematic sectional view taken along the cutting-plane line B-B' in FIG. 44, and FIG. 47 is a schematic sectional view taken along the cutting-plane line C-C' in FIG. 44. As with the fifth embodiment, in order to reduce a parasitic capacitance in the seventh embodiment, it is desirable that the parasitic capacitance $C_{ov1}$ between the gate 210 and the semiconductor substrate 100 is less than the gate capacitance $C_g$, as shown in the following formula (7-1):

$$C_{ov1} < C_g \qquad\qquad (7\text{-}1)$$

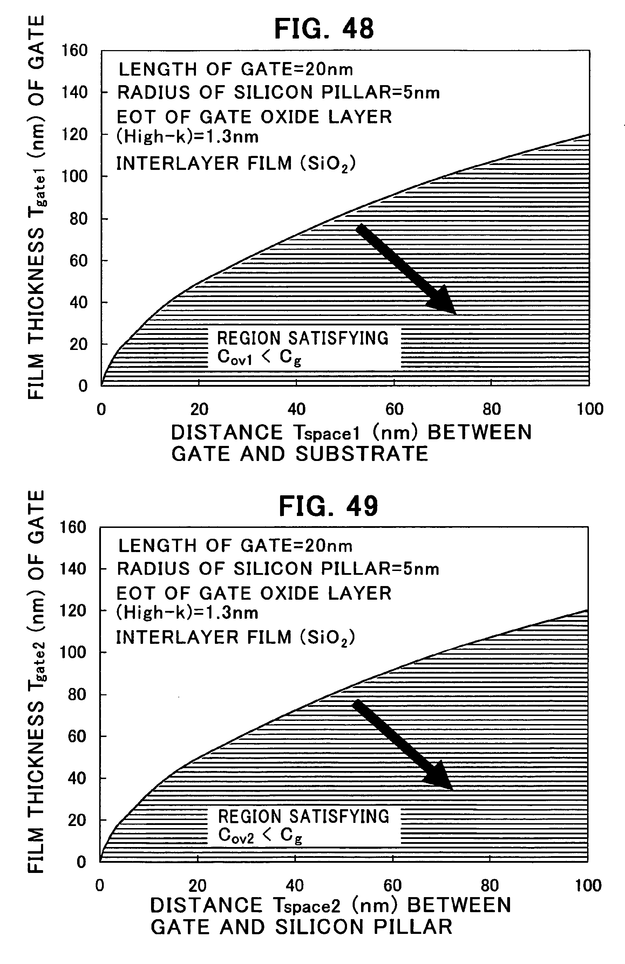

Specifically, given that: the length of the gate 210 is 20 nm; the diameter of the first silicon pillar 810 is 10 nm; and the film thickness $T_{ox}$ of the gate oxide layer 320 made of $HfO_2$ is 1.3 nm (equivalent oxide thickness (EOT)). Based on the formula (5-6) in the fifth embodiment, the following conditional formula (7-2) representing a relationship between the film thickness $T_{gate1}$ of the gate 210, and the distance $T_{space1}$ between the gate 210 and the semiconductor substrate 100, is obtained (unit in the formulas (7-2): nm) (FIG. 48):

$$5.4e2 \cdot T_{space1} < \pi(10 + T_{gate1})^2 - 3.3e2 \Rightarrow C_{ov1} < C_g \qquad\qquad (7\text{-}2)$$

In FIG. 48, $C_{ov1}$ becomes less than $C_g$ in a region on the side of the arrowed direction.
Further, as with the fifth embodiment, in order to reduce the parasitic capacitance in the seventh embodiment where the gate oxide layer 320 is made of $HfO_2$, instead of $SiO_2$, it is desirable that the parasitic capacitance $C_{ov2}$ between the gate 210 and the second silicon pillar 820 is less than the gate capacitance $C_g$, as shown in the following formula (7-3):

$$C_{ov2} < C_g \qquad\qquad (7\text{-}3)$$

Based on the formula (5-18) in the fifth embodiment, the following conditional formula (7-4) representing a relationship between the film thickness $T_{gate2}$ of the gate 210, and the distance $T_{space2}$ between the gate 210 and the second silicon pillar 820, is obtained (unit in the formula (7-4): nm) (FIG. 49):

$$5.4e2 \cdot T_{space2} < \pi(10 + T_{gate2})^2 - 3.3e2 \Rightarrow C_{ov2} < C_g \qquad\qquad (7\text{-}4)$$

In FIG. 49, $C_{ov2}$ becomes less than $C_g$ in a region on the side of the arrowed direction.

EIGHTH EMBODIMENT: SEMICONDUCTOR DEVICE

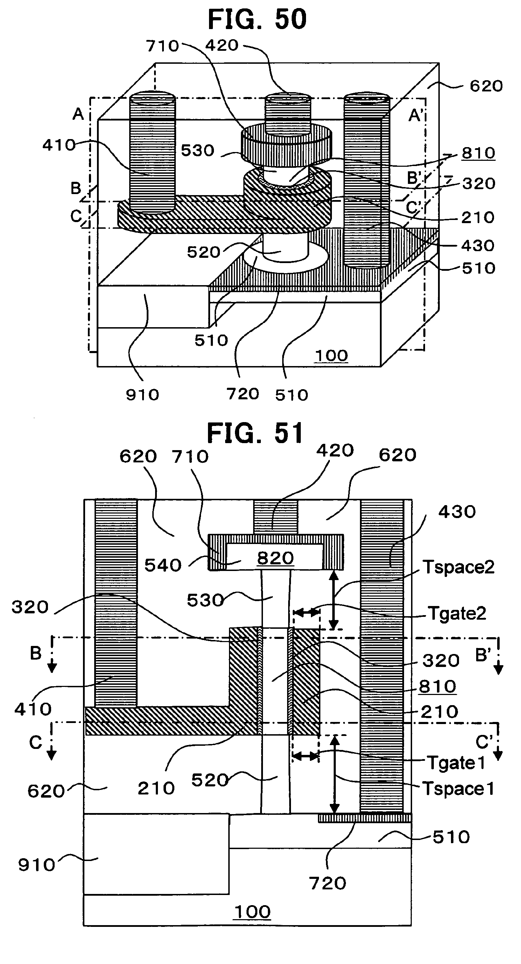

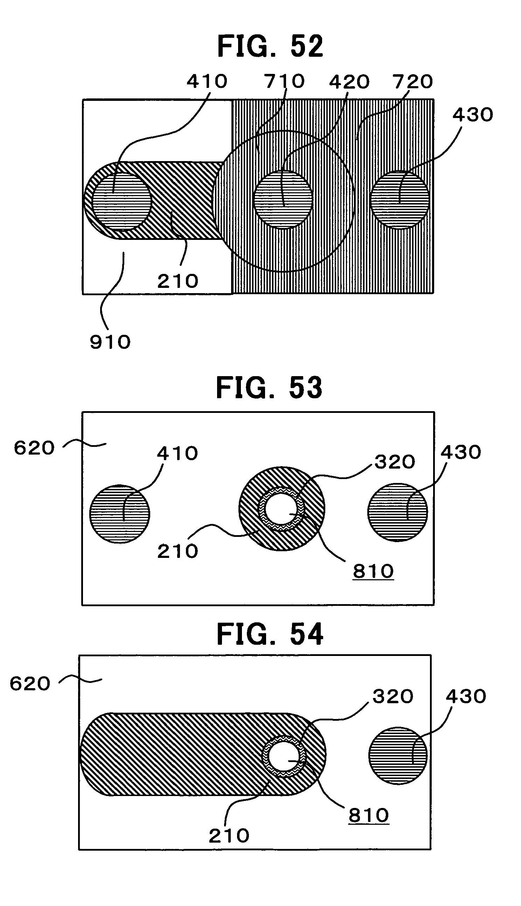

FIG. 50 is a schematic bird's-eye view showing a transistor in a semiconductor device according to the eighth embodiment of the present invention, wherein the semiconductor device according to the eighth embodiment is the same as that in the fifth embodiment, except that the interlayer film 610 made of $SIO_2$ is replaced by an interlayer film 620 made of SiN, and the gate oxide layer 310 made of $SiO_2$ is replaced by a gate oxide layer 320 made of $HfO_2$. FIG. 51 is a schematic sectional view taken along the cutting-plane line A-A' in FIG. 50, and FIG. 52 is a top view of the transistor in FIG. 50. FIG. 53 is a schematic sectional view taken along the cutting-plane line B-B' in FIG. 51, and FIG. 54 is a schematic sectional view taken along the cutting-plane line C-C' in FIG. 51. As with the fifth embodiment, in order to reduce a parasitic capacitance in the eighth embodiment, it is desirable that the parasitic capacitance $C_{ov1}$ between the gate 210 and the semiconductor substrate 100 is less than the gate capacitance $C_g$, as shown in the following formula (8-1):

$$C_{ov1} < C_g \qquad\qquad (8\text{-}1)$$

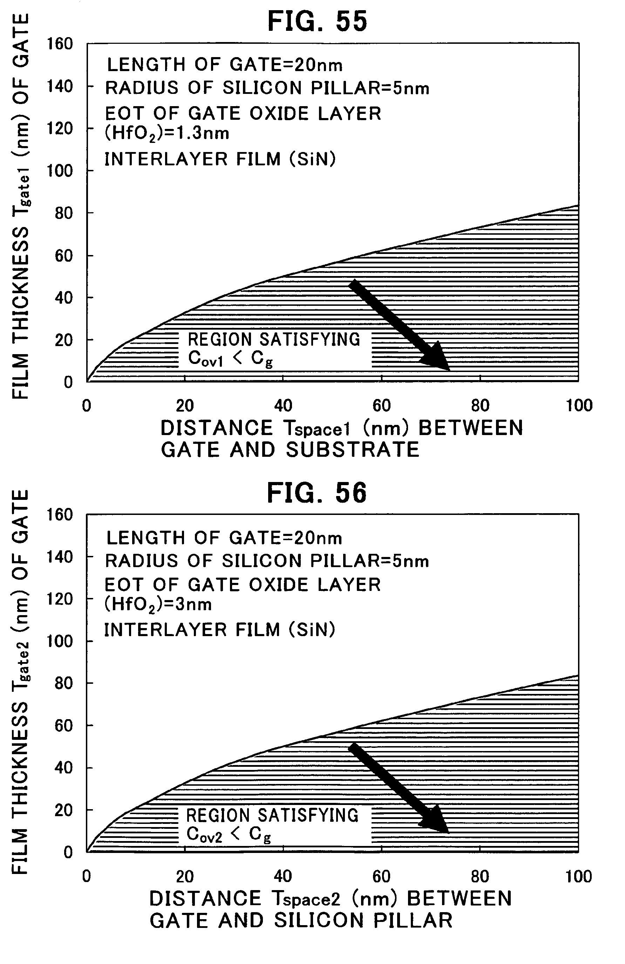

Specifically, given that: the length of the gate 210 is 20 nm; the diameter of the first silicon pillar 810 is 10 nm; and the film thickness $T_{ox}$ of the gate oxide layer 320 made of $HfO_2$ is 1.3 nm (EOT). Based on the formula (5-6) in the fifth embodiment, the following conditional formula (8-2) representing a relationship between the film thickness $T_{gace1}$ of the gate 210, and the distance $T_{space1}$ between the gate 210 and the semiconductor substrate 100, is obtained (unit in the formulas (8-2): nm) (FIG. 55):

$$2.8e2 \cdot T_{space1} < \pi(10 + T_{gate1})^2 - 3.3e2 \Rightarrow C_{ov1} < C_g \qquad (8\text{-}2)$$

In FIG. 55, $C_{ov1}$ becomes less than $C_g$ in a region on the side of the arrowed direction.

Further, as with the fifth embodiment, in order to reduce the parasitic capacitance in the seventh embodiment where the interlayer film 620 is made of SiN, instead of $SiO_2$, and the gate oxide layer 320 is made of $HfO_2$, instead of $SiO_2$, it is desirable that the parasitic capacitance $C_{ov2}$ between the gate 210 and the second silicon pillar 820 is less than the gate capacitance $C_g$, as shown in the following formula (8-3):

$$C_{ov2} < C_g \qquad (8\text{-}3)$$

Based on the formula (5-18) in the fifth embodiment, the following conditional formula (8-4) representing a relationship between the film thickness $T_{gate2}$ of the gate 210, and the distance $T_{space2}$ between the gate 210 and the second silicon pillar 820, is obtained (unit in the formula (8-4): nm) (FIG. 56):

$$2.8e2 \cdot T_{space2} < \pi(10 + T_{gate2})^2 - 3.3e2 \Rightarrow C_{ov2} < C_g \qquad (8\text{-}4)$$

In FIG. 56, $C_{ov2}$ becomes less than $C_g$ in a region on the side of the arrowed direction.

NINTH EMBODIMENT: SEMICONDUCTOR DEVICE

Each of ninth to twelfth embodiments of the present invention is an example where a first silicon pillar 810 has a square shape in cross-section.

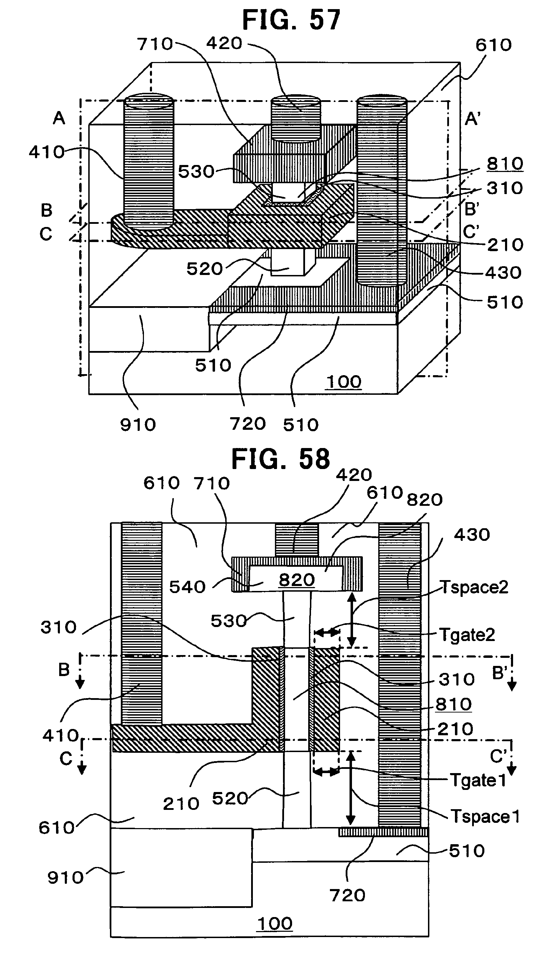

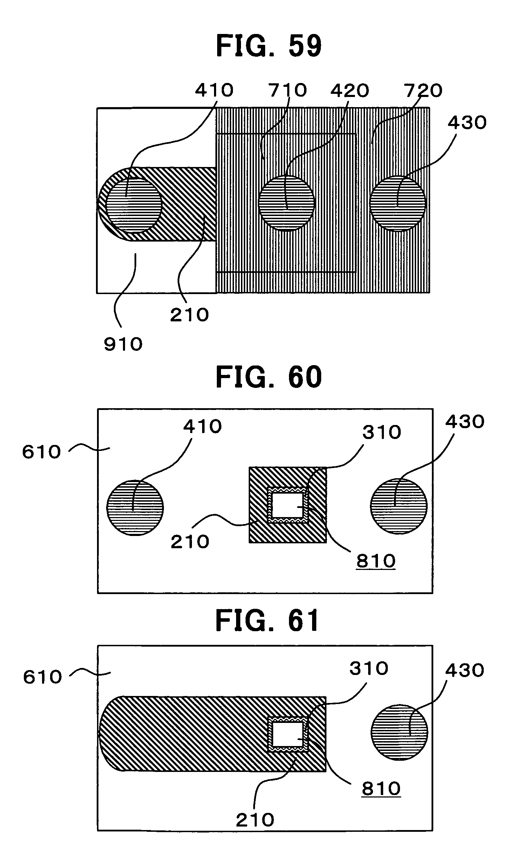

In the ninth embodiment, an after-mentioned first insulating body 310 (gate oxide layer) is made of $SiO_2$, and an after-mentioned second insulating body 610 (interlayer film) is made of $SiO_2$. FIG. 57 is a schematic bird's-eye view showing a transistor in a semiconductor device according to the ninth embodiment of the present invention. FIG. 58 is a schematic sectional view taken along the cutting-plane line A-A' in FIG. 57, and FIG. 59 is a top view of the transistor in FIG. 57. FIG. 60 is a schematic sectional view taken along the cutting-plane line B-B' in FIG. 58, and FIG. 61 is a schematic sectional view taken along the cutting-plane line C-C' in FIG. 58. The semiconductor device according to the ninth embodiment comprises a cross-sectionally square-shaped first silicon pillar 810 formed on a first-conductive type semiconductor substrate 100, a first insulating body 310 surrounding a part of a surface of the first silicon pillar 810, a gate 210 surrounding the first insulating body 310, and a second silicon pillar 820 formed on a top of the first silicon pillar 810. The gate 210 is disposed to be separated from the semiconductor substrate 100 by a second insulating body 610. Further, the gate 210 is disposed to be separated from the second silicon pillar 820 by the second insulating body 610.

The semiconductor device further comprises a second-conductive type high-concentration impurity region 520 formed in a part of the first silicon pillar 810, a second-conductive type high-concentration impurity region 530 formed in a part of the first silicon pillar 810, a second-conductive type high-concentration impurity region 510 formed in a part of the semiconductor substrate 100, a second-conductive type high-concentration impurity region 540 formed in a part of the second silicon pillar 820, a silicide region 720 formed in a part of the second-conductive type high-concentration impurity region 510, a silicide region 710 formed in the second-conductive type high-concentration impurity region 540, a contact 430 formed on the silicide region 720, a contact 420 formed on the silicide region 710, a contact 410 formed on the gate 210, and an element isolation region 910 formed in the semiconductor substrate 100.

In order to reduce a parasitic capacitance in the ninth embodiment, it is desirable that a parasitic capacitance $C_{ov1}$ between the gate 210 and the semiconductor substrate 100 is less than a gate capacitance $C_g$, as shown in the following formula (9-1):

$$C_{ov1} < C_g \qquad (9\text{-}1)$$

Specifically, given that: a length of the gate 210 is 20 nm; one side of the first silicon pillar 810 is 10 nm; a film thickness $T_{ox}$ of the gate oxide layer 310 is 1 nm; and the interlayer film is made of $SiO_2$. A relationship of the capacitance $C_{ov1}$ between the gate 210 and the semiconductor substrate 100, a dielectric constant $\varepsilon_X$ of the interlayer film 610, a cross-sectional area S1 of the gate 210, and a distance $T_{space1}$ between the gate 210 and the semiconductor substrate 100, is expressed as the following formula (9-2), and then the formula (9-2) is assigned to the formula (9-1) to obtain the following formula (9-3):

$$S1 < \frac{C_g}{\varepsilon_x} T_{space1} \quad\quad\quad (9\text{-}2)$$

$$C_{ov1} = \frac{\varepsilon_x S1}{T_{space1}} \quad\quad\quad (9\text{-}3)$$

The gate capacitance $C_g$ is expressed as the following formula (9-4) which is a relational expression of a dielectric constant $\varepsilon_{0X}$ of the gate oxide layer 310, the length l of the gate 210, a length R of one side of the first silicon pillar 810, and the film thickness $T_{ox}$ of the gate oxide layer 310, and the cross-sectional area S 1 of the gate 210 is expressed as the following formula (9-5). Thus, the formulas (9-4) and (9-5) are assigned to the formula (9-1) to obtain the following conditional formula (9-6) representing a relationship between the cross-sectional area S1 of the gate 210, and the distance $T_{space1}$ between the gate 210 and the semiconductor substrate 100:
$$C_g = \frac{\varepsilon_{ox} \cdot 4R \cdot l}{T_{ox}} \quad\quad\quad (9\text{-}4)$$

$$S1 = \left(R + 2T_{ox} + 2T_{gate1}\right)^2 - (R + 2T_{ox})^2 \quad\quad\quad (9\text{-}5)$$

$$\left(R + 2T_{ox} + 2T_{gate1}\right)^2 - (R + 2T_{ox})^2 < \frac{\varepsilon_x \cdot 4Rl}{\varepsilon_x \cdot T_{ox}} \cdot T_{space1} \quad\quad\quad (9\text{-}6)$$

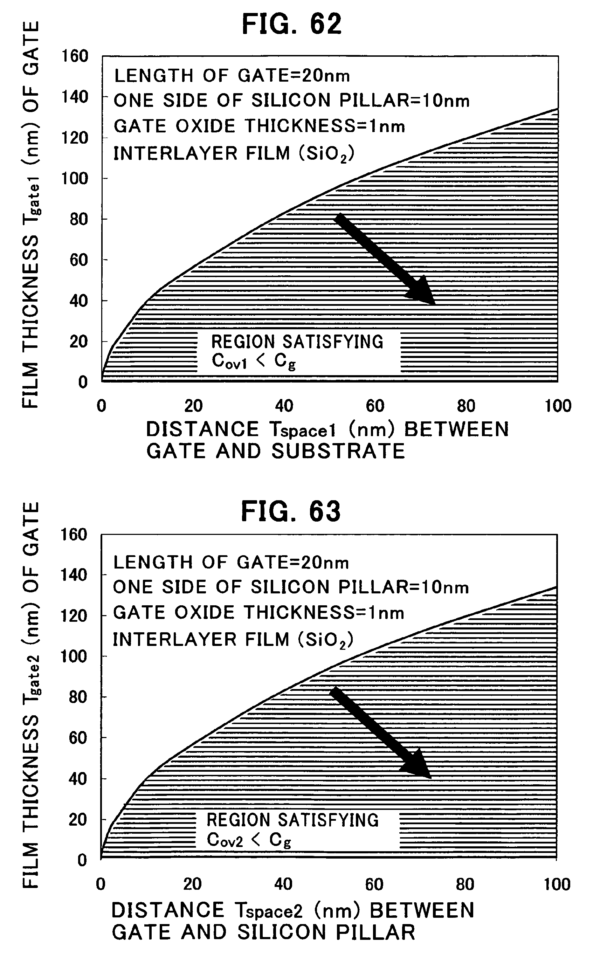

If the conditional formula (9-6) is satisfied, the formula (9-1) is satisfied. Thus, the above values are assigned to the formula (9-6) to obtain the following formula (9-7) (unit in the formula (9-7): nm) (FIG. 62):

$$800 \cdot T_{space1} < 4T_{gate1}^2 + 48T_{gate1} \Rightarrow C_{ov1} < C_g \quad\quad\quad (9\text{-}7)$$

Typically, the length of one side of the first silicon pillar 810 is set in the range of 0.25 nm to 25 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (9-1) will be calculated. Given that: the length R of one side of the first silicon pillar 810 is 25 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (9-8) which is a relational expression of the dielectric constant $\varepsilon_{0X}$ of the gate oxide layer 310, the length l of the gate 210, the length R of one side of the first silicon pillar 810, and the film thickness $T_{ox}$ of the gate oxide layer 310, and the cross-sectional area S1 of the gate 210 is expressed as the following formula (9-9). Thus, the formulas (9-8) and (9-9) are assigned to the formula (9-3) to obtain the following conditional formula (9-10) representing a relationship between a film thickness $T_{gate1}$ of the gate 210, and the distance $T_{space1}$ between the gate 210 and the semiconductor substrate 100:
$$C_g = \frac{\varepsilon_{ox} \cdot 4R \cdot l}{T_{ox}} \qquad (9\text{-}8)$$

$$S1 = \left(R + 2T_{ox} + 2T_{gate1}\right)^2 - (R + 2T_{ox})^2 \qquad (9\text{-}9)$$

$$\left(R + 2T_{ox} + 2T_{gate1}\right)^2 - (R + 2T_{ox})^2 < \frac{\varepsilon_x \cdot 4Rl}{\varepsilon_x \cdot T_{ox}} \cdot T_{space1} \qquad (9\text{-}10)$$

If the conditional formula (9-10) is satisfied, the formula (9-1) is satisfied. Thus, the above values are assigned to the formula (9-10) to obtain the following formula (9-11), and then the following formula (9-12) is obtained from the formula (9-11) (unit in the formulas (9-11) and (9-12): $\mu$m):

$$2.0e6 \cdot T_{space1} < 4T_{gate1}{}^2 + 1.0e2T_{gate1} \Rightarrow C_{ov1} < C_g \qquad (9\text{-}11)$$

$$2.0e6 \cdot T_{space1} << 4T_{gate1}{}^2 + 1.0e2T_{gate1} \Rightarrow C_{ov1} << C_g \qquad (9\text{-}12)$$

In FIG. 62, $C_{ov1}$ becomes less than $C_g$ in a region on the side of the arrowed direction.
Further, in order to reduce the parasitic capacitance in the ninth embodiment, it is desirable that a parasitic capacitance $C_{ov2}$ between the gate 210 and the second silicon pillar 820 is less than the gate capacitance $C_g$, as shown in the following formula (9-13):

$$C_{ov2} < C_g \qquad (9\text{-}13)$$

Specifically, given that: the length of the gate 210 is 20 nm; one side of the first silicon pillar 810 is 10 nm; the film thickness $T_{ox}$ of the gate oxide layer 310 is 1 nm; and the interlayer film is made of $SiO_2$. A relationship of the capacitance $C_{ov2}$ between the gate 210 and the second silicon pillar 820, the dielectric constant $\varepsilon_X$ of the interlayer film 610, a cross-sectional area S2 of the gate 210, and a distance $T_{space2}$ between the gate 210 and the second silicon pillar 820, is expressed as the following formula (9-14), and then the formula (9-14) is assigned to the formula (9-13) to obtain the following formula (9-15):

$$S2 < \frac{C_g}{\varepsilon_x} T_{space2} \qquad (9\text{-}14)$$

$$C_{ov2} = \frac{\varepsilon_x S2}{T_{space2}} \qquad (9\text{-}15)$$

The gate capacitance $C_g$ is expressed as the following formula (9-16) which is a relational expression of the dielectric constant $\varepsilon_{0X}$ of the gate oxide layer 310, the length 1 of the gate 210, a peripheral length w of the first silicon pillar 810, and the film thickness $T_{ox}$ of the gate oxide layer 310, and the cross-sectional area S2 of the gate 210 is expressed as the following formula (9-17). Thus, the formulas (9-16) and (9-17) are assigned to the formula (9-13) to obtain the following conditional formula (9-18) representing a relationship between the cross-sectional area S2 of the gate 210, and the distance $T_{space2}$ between the gate 210 and the second silicon pillar 820:
$$C_g = \frac{\varepsilon_{ox} \cdot 4R \cdot l}{T_{ox}} \quad (9\text{-}16)$$

$$S2 = \left(R + 2T_{ox} + 2T_{gate2}\right)^2 - (R + 2T_{ox})^2 \quad (9\text{-}17)$$

$$\left(R + 2T_{ox} + 2T_{gate2}\right)^2 - (R + 2T_{ox})^2 < \frac{\varepsilon_x \cdot 4Rl}{\varepsilon_x \cdot T_{ox}} \cdot T_{space2} \quad (9\text{-}18)$$

If the conditional formula (9-18) is satisfied, the formula (9-13) is satisfied. Thus, the above values are assigned to the formula (9-18) to obtain the following formula (9-19) (unit in the formulas (9-19): nm (FIG. 63):

$$800 \cdot T_{space2} < 4T_{gate2}^{\ 2} + 48T_{gate2} \Rightarrow C_{ov2} < C_g \quad (9\text{-}19)$$

Typically, the length of one side of the first silicon pillar 810 is set in the range of 0.25 nm to 25 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (9-1) will be calculated. Given that: the peripheral length of the first silicon pillar 810 is 25 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (9-20) which is a relational expression of the dielectric constant $\varepsilon_{0X}$ of the gate oxide layer 310, the length 1 of the gate 210, the peripheral length w of the first silicon pillar 810, and the film thickness $T_{ox}$ of the gate oxide layer 310, and the cross-sectional area S2 of the gate 210 is expressed as the following formula (9-21). Thus, the formulas (9-20) and (9-21) are assigned to the formula (9-13) to obtain the following conditional formula (9-22) representing a relationship between the cross-sectional area S2 of the gate 210, and the distance $T_{space2}$ between the gate 210 and the second silicon pillar 820:
$$C_g = \frac{\varepsilon_{ox} \cdot 4R \cdot l}{T_{ox}} \quad (9\text{-}20)$$

$$S2 = \left(R + 2T_{ox} + 2T_{gate2}\right)^2 - (R + 2T_{ox})^2 \quad (9\text{-}21)$$

$$\left(R + 2T_{ox} + 2T_{gate2}\right)^2 - (R + 2T_{ox})^2 < \frac{\varepsilon_x \cdot 4Rl}{\varepsilon_x \cdot T_{ox}} \cdot T_{space2} \quad (9\text{-}22)$$

If the conditional formula (9-22) is satisfied, the formula (9-13) is satisfied. Thus, the above values are assigned to the formula (9-22) to obtain the following formula (9-23), and then the following formula (9-24) is obtained from the formula (9-23) (unit in the formulas (9-23) and (9-24): $\mu$m):

$$2.0e6 \cdot T_{space2} < 4T_{gate2}^{2} + 1.0e2T_{gate2} \Rightarrow C_{ov2} < C_g \qquad (9\text{-}23)$$

$$2.0e6 \cdot T_{space2} << 4T_{gate2}^{2} + 1.0e2T_{gate2} \Rightarrow C_{ov2} << C_g \qquad (9\text{-}24)$$

In FIG. 63, $C_{ov2}$ becomes less than $C_g$ in a region on the side of the arrowed direction.

TENTH EMBODIMENT: SEMICONDUCTOR DEVICE

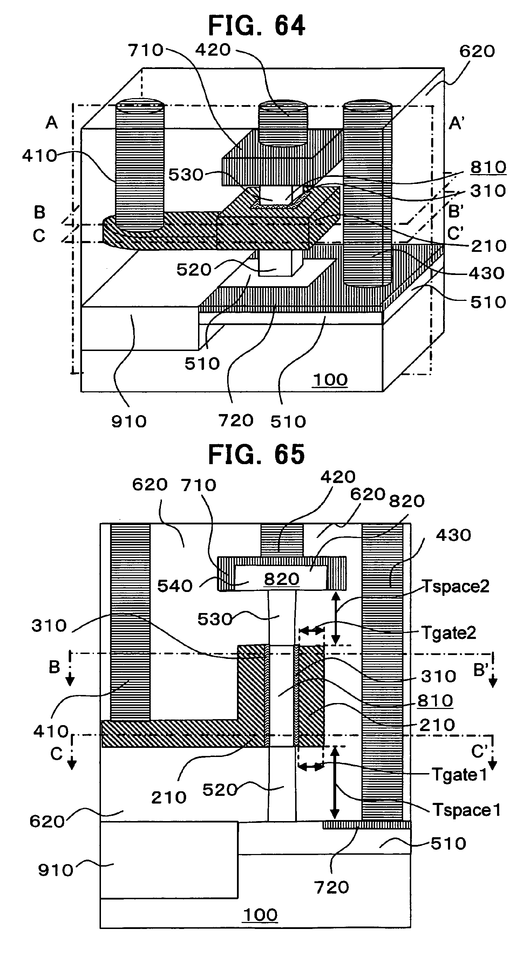

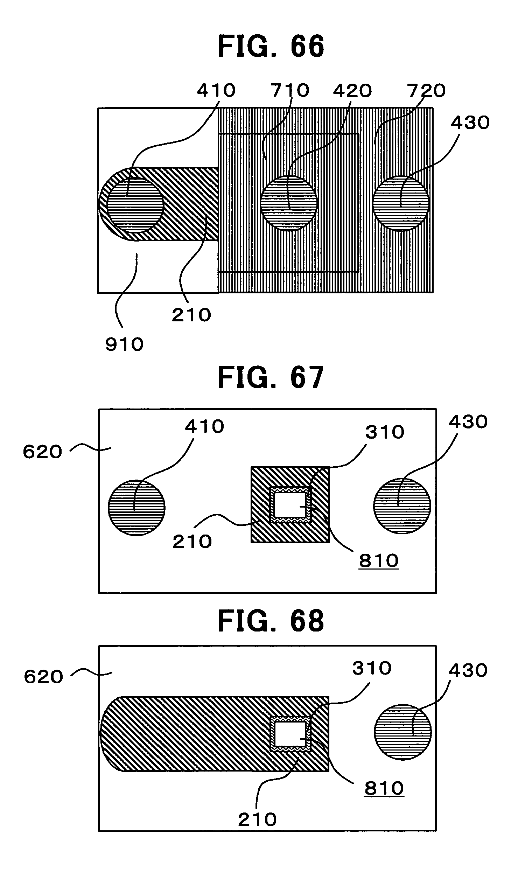

FIG. 64 is a schematic bird's-eye view showing a transistor in a semiconductor device according to the tenth embodiment of the present invention, wherein the semiconductor device according to the tenth embodiment is the same as that in the ninth embodiment, except that the interlayer film 610 made of $SiO_2$ is replaced by an interlayer film 620 made of SiN. FIG. 65 is a schematic sectional view taken along the cutting-plane line A-A' in FIG. 64, and FIG. 66 is a top view of the transistor in FIG. 64. FIG. 67 is a schematic sectional view taken along the cutting-plane line B-B' in FIG. 65, and FIG. 68 is a schematic sectional view taken along the cutting-plane line C-C' in FIG. 65. As with the ninth embodiment, in order to reduce a parasitic capacitance in the tenth embodiment, it is desirable that the parasitic capacitance $C_{ov1}$ between the gate 210 and the semiconductor substrate 100 is less than the gate capacitance $C_g$, as shown in the following formula (10-1):

$$C_{ov1} < C_g \qquad (10\text{-}1)$$

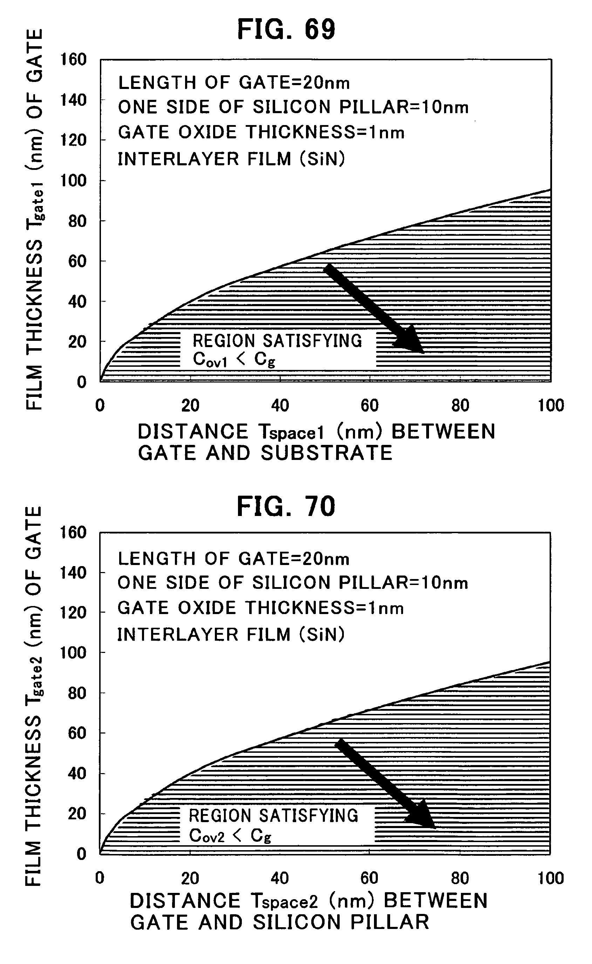

Specifically, given that: the length of the gate 210 is 20 nm; the length of one side of the first silicon pillar 810 is 10 nm; and the film thickness $T_{ox}$ of the gate oxide layer 310 is 1.0 nm (EOT). Based on the formula (9-6) in the ninth embodiment, the following conditional formula (10-2) representing a relationship between the film thickness $T_{gate1}$ of the gate 210, and the distance $T_{space1}$ between the gate 210 and the semiconductor substrate 100, is obtained (unit in the formulas (10-2): nm) (FIG. 69):

$$4.1e2 \cdot T_{space1} < (2T_{gate1} + 12)^{2} - 1.4e2 \Rightarrow C_{ov1} < C_g \qquad (10\text{-}2)$$

In FIG. 69, $C_{ov1}$ becomes less than $C_g$ in a region on the side of the arrowed direction.
Further, as with the ninth embodiment, in order to reduce the parasitic capacitance in the tenth embodiment where the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (10-3):

$$C_{ov2} < C_g \qquad (10\text{-}3)$$

Based on the formula (9-18) in the ninth embodiment, the following conditional formula (10-4) representing a relationship between the film thickness $T_{gate2}$ of the gate 210, and the distance $T_{space2}$ between the gate 210 and the second silicon pillar 820, is obtained (unit in the formula (10-4): nm) (FIG. 70):

$$4.1e2 \cdot T_{space2} < (2T_{gate2} + 12)^{2} - 1.4e2 \Rightarrow C_{ov2} < C_g \qquad (10\text{-}4)$$

In FIG. 70, $C_{ov2}$ becomes less than $C_g$ in a region on the side of the arrowed direction.

ELEVENTH EMBODIMENT: SEMICONDUCTOR DEVICE

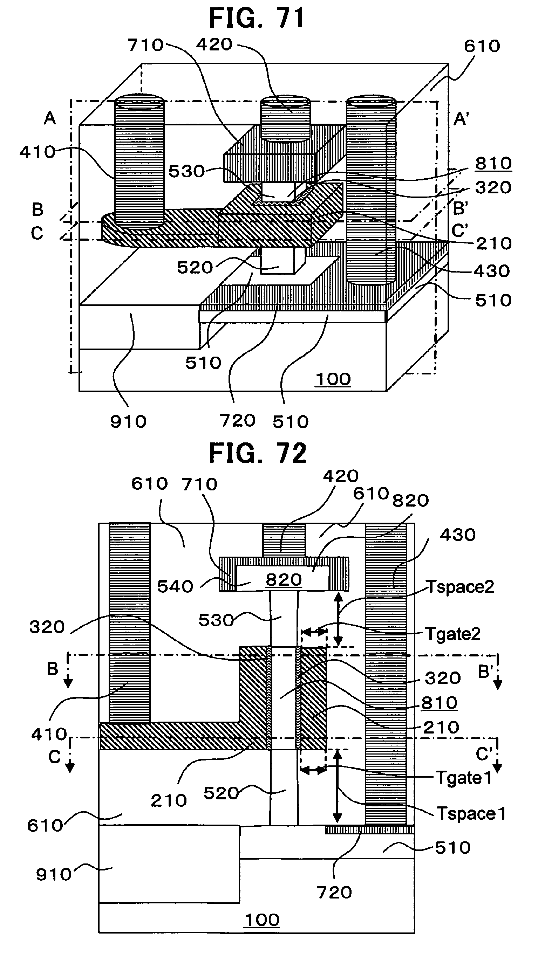

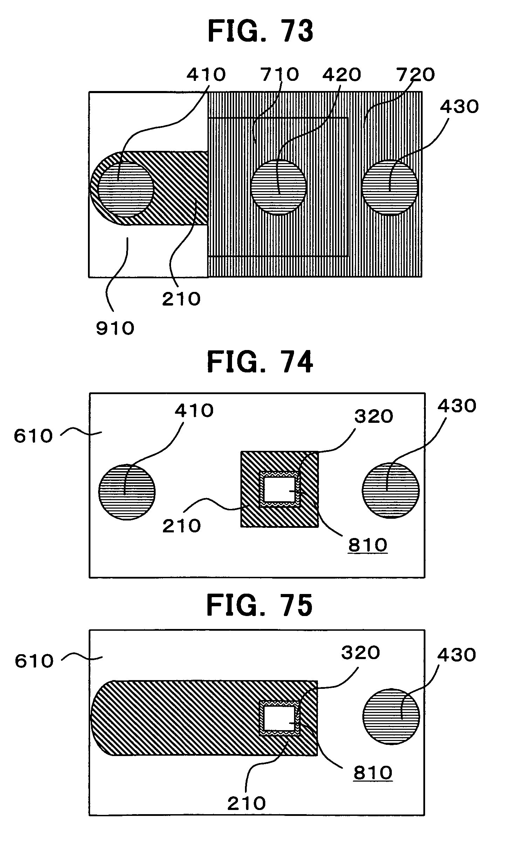

FIG. 71 is a schematic bird's-eye view showing a transistor in a semiconductor device according to the eleventh embodiment of the present invention, wherein the semiconductor device according to the eleventh embodiment is the same as that in the ninth embodiment, except that the gate oxide layer 310 made of $SiO_2$ is replaced by a gate oxide layer 320 made of $HfO_2$. FIG. 72 is a schematic sectional view taken along the cutting-plane line A-A' in FIG. 71, and FIG. 73 is a top view of the transistor in FIG. 71. FIG. 74 is a schematic sectional view taken along the cutting-plane line B-B' in FIG. 72, and FIG. 75 is a schematic sectional view taken along the cutting-plane line C-C' in FIG. 72. As with the ninth embodiment, in order to reduce a parasitic capacitance in the eleventh embodiment, it is desirable that the parasitic capacitance $C_{ov1}$ between the gate 210 and the semiconductor substrate 100 is less than the gate capacitance $C_g$, as shown in the following formula (11-1):

$$C_{ov1} < C_g \qquad\qquad (11\text{-}1)$$

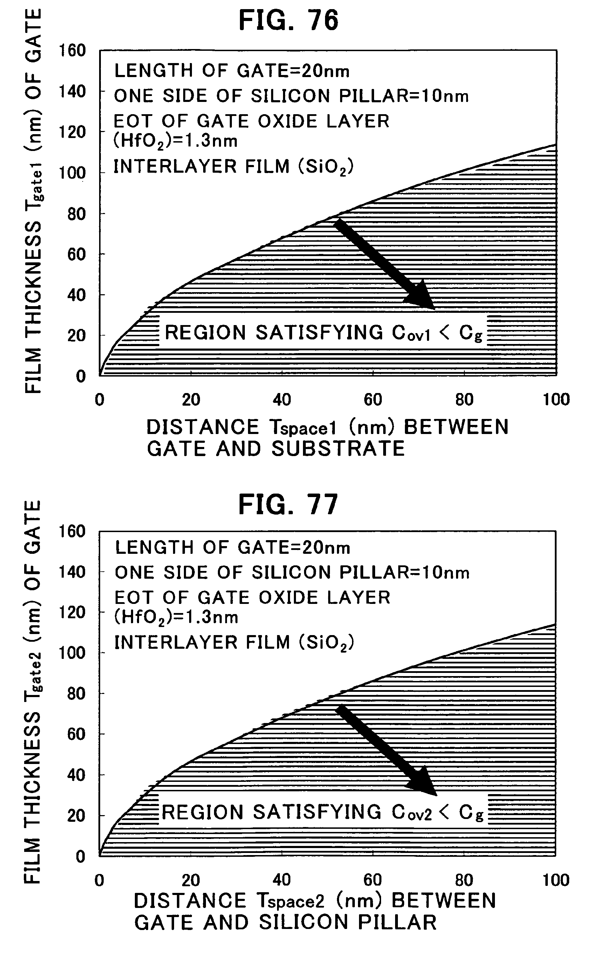

Specifically, given that: the length of the gate 210 is 20 nm; the length of one side of the first silicon pillar 810 is 10 nm; and the film thickness $T_{ox}$ of the gate oxide layer 320 made of $HfO_2$ is 1.3 nm (EOT). Based on the formula (9-6) in the ninth embodiment, the following conditional formula (11-2) representing a relationship between the film thickness $T_{gate1}$ of the gate 210, and the distance $T_{space1}$ between the gate 210 and the semiconductor substrate 100, is obtained (unit in the formulas (11-2): nm) (FIG. 76):

$$5.3e2 \cdot T_{space1} < (2T_{gate1} + 20)^2 - 4.2e2 \Rightarrow C_{ov1} < C_g \qquad (11\text{-}2)$$

In FIG. 76, $C_{ov1}$ becomes less than $C_g$ in a region on the side of the arrowed direction.
Further, as with the ninth embodiment, in order to reduce the parasitic capacitance in the eleventh embodiment where the gate oxide layer 320 is made of $HfO_2$, instead of $SiO_2$, it is desirable that the parasitic capacitance $C_{ov2}$ between the gate 210 and the second silicon pillar 820 is less than the gate capacitance $C_g$, as shown in the following formula (11-3):

$$C_{ov2} < C_g \qquad\qquad (11\text{-}3)$$

Based on the formula (9-18) in the ninth embodiment, the following conditional formula (11-4) representing a relationship between the film thickness $T_{gate2}$ of the gate 210, and the distance $T_{space2}$ between the gate 210 and the second silicon pillar 820, is obtained (unit in the formula (11-4): nm) (FIG. 77):

$$5.3e2 \cdot T_{space2} < (2T_{gate2} + 20)^2 - 4.2e2 \Rightarrow C_{ov1} < C_g \qquad (11\text{-}4)$$

In FIG. 77, $C_{ov2}$ becomes less than $C_g$ in a region on the side of the arrowed direction.

TWELFTH EMBODIMENT: SEMICONDUCTOR DEVICE

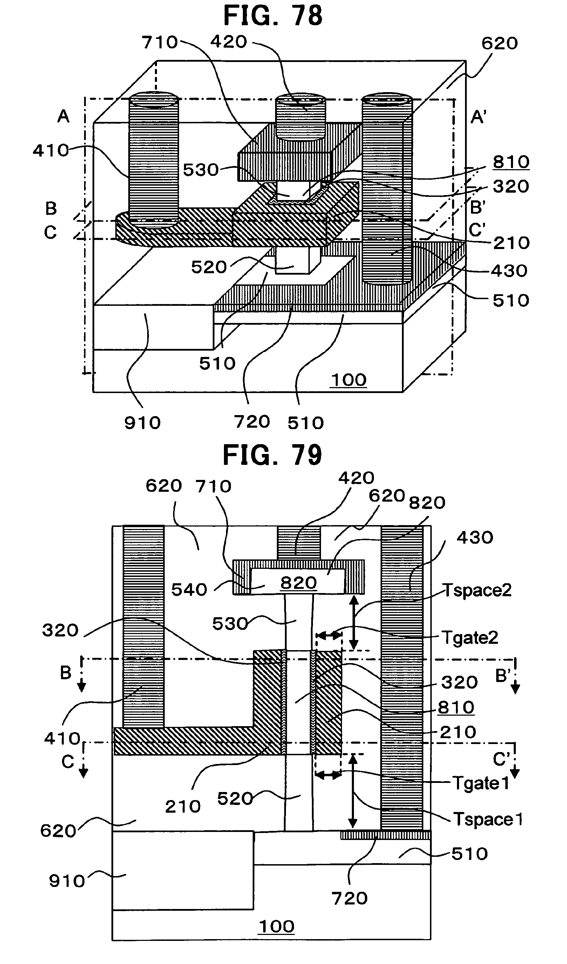

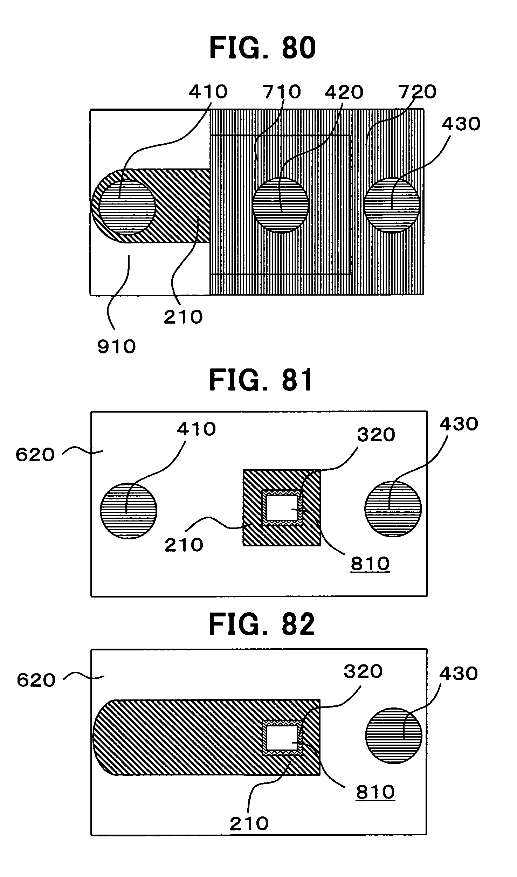

FIG. 78 is a schematic bird's-eye view showing a transistor in a semiconductor device according to the twelfth embodiment of the present invention, wherein the semiconductor device according to the twelfth embodiment is the same as that in the ninth embodiment, except that the gate oxide layer 310 made of $SiO_2$ is replaced by a gate oxide layer 320 made of $HfO_2$ and the interlayer film 610 made of $SiO_2$ is replaced by an interlayer film 620 made of SiN. FIG. 79 is a schematic sectional view taken along the cutting-plane line A-A' in FIG. 78, and FIG. 80 is a top view of the transistor in FIG. 78. FIG. 81 is a schematic sectional view taken along the cutting-plane line B-B' in FIG. 79, and FIG. 82 is a schematic sectional view taken along the cutting-plane line C-C' in FIG. 79. As with the ninth embodiment, in order to reduce a parasitic capacitance in the twelfth embodiment, it is desirable that the parasitic capacitance $C_{ov1}$ between the gate 210 and the semiconductor substrate 100 is less than the gate capacitance $C_g$, as shown in the following formula (12-1):

$$C_{ov1} < C_g \qquad\qquad (12\text{-}1)$$

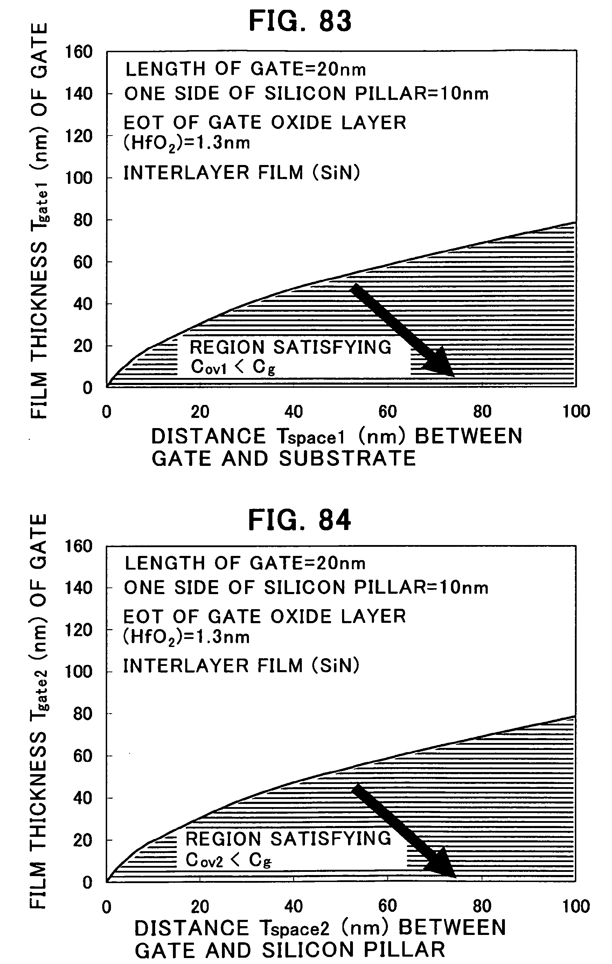

Specifically, given that: the length of the gate 210 is 20 nm; the length of one side of the first silicon pillar 810 is 10 nm; and the film thickness $T_{ox}$ of the gate oxide layer 320 made of $HfO_2$ is 1.3 nm (EOT). Based on the formula (9-6) in the ninth embodiment, the following conditional formula (12-2) representing a relationship between the film thickness $T_{gate1}$ of the gate 210, and the distance $T_{space1}$ between the gate 210 and the semiconductor substrate 100, is obtained (unit in the formulas (12-2): nm) (FIG. 83):

$$2.7e2 \cdot T_{space1} < (2T_{gate1} + 20)^2 - 4.2e2 \Rightarrow C_{ov1} < C_g \qquad\qquad (12\text{-}2)$$

In FIG. 83, $C_{ov1}$ becomes less than $C_g$ in a region on the side of the arrowed direction.

Further, as with the ninth embodiment, in order to reduce the parasitic capacitance in the twelfth embodiment where the gate oxide layer 320 is made of $HfO_2$, instead of $SiO_2$ and the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (12-3):

$$C_{ov2} < C_g \qquad\qquad (12\text{-}3)$$

Based on the formula (9-18) in the ninth embodiment, the following conditional formula (12-4) representing a relationship between the film thickness $T_{gate2}$ of the gate 210, and the distance $T_{space2}$ between the gate 210 and the second silicon pillar 820, is obtained (unit in the formula (12-4): nm) (FIG. 84):

$$2.7e2 \cdot T_{space2} < (2T_{gate2} + 20)^2 - 4.2e2 \Rightarrow C_{ov1} < C_g \qquad\qquad (12\text{-}4)$$

In FIG. 84, $C_{ov2}$ becomes less than $C_g$ in a region on the side of the arrowed direction.

THIRTEENTH EMBODIMENT: SEMICONDUCTOR DEVICE

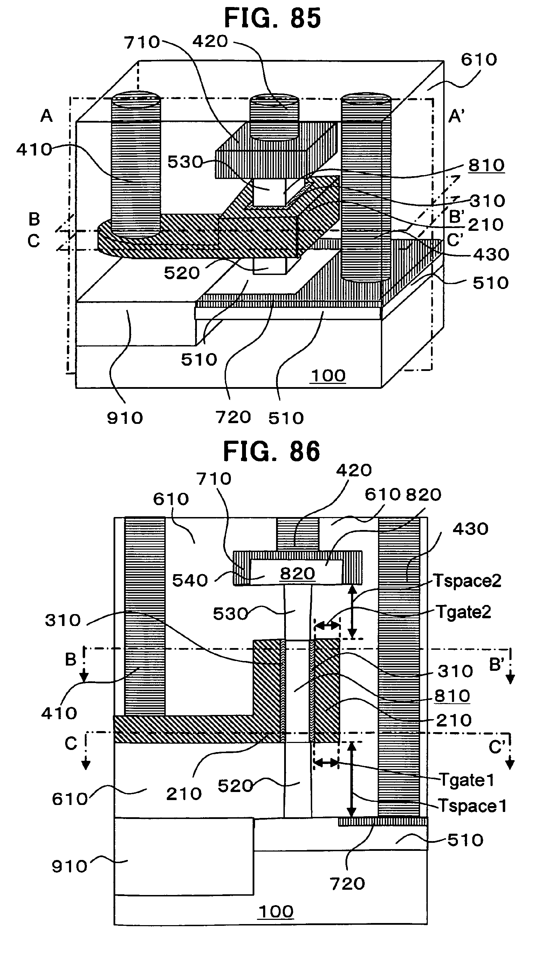

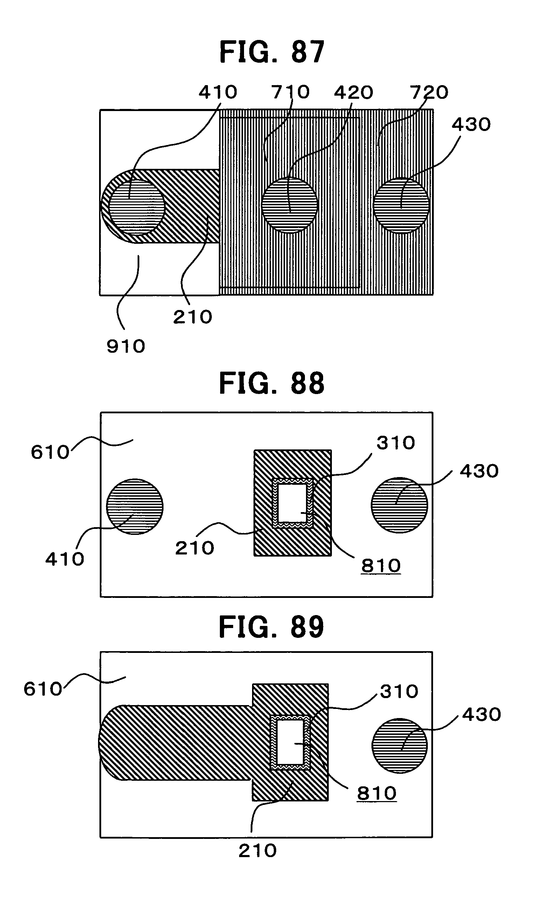

Each of thirteenth to sixteenth embodiments of the present invention is an example where a first silicon pillar 810 has a rectangular shape in cross-section. In the thirteenth embodiment, an after-mentioned first insulating body 310 (gate oxide layer) is made of $SiO_2$, and an after-mentioned second insulating body 610 (interlayer film) is made of $SiO_2$. FIG. 85 is a schematic bird's-eye view showing a transistor in a semiconductor device according to the thirteenth embodiment of the present invention. FIG. 86 is a schematic sectional view taken along the cutting-plane line A-A' in FIG. 85, and FIG. 87 is a top view of the transistor in FIG. 85. FIG. 88 is a schematic sectional view taken along the cutting-plane line B-B' in FIG. 86, and FIG. 89 is a schematic sectional view taken along the cutting-plane line C-C' in FIG. 86. The semiconductor device according to the thirteenth embodiment comprises a cross-sectionally rectangular-shaped first silicon pillar 810 formed on a first-conductive type semiconductor substrate 100, a first insulating body 310 surrounding a part of a surface of the first silicon pillar 810, a gate 210 surrounding the first insulating body 310, and a second silicon pillar 820 formed on a top of the first silicon pillar 810. The gate 210 is disposed to be separated from the semiconductor substrate 100 by a second insulating body 610. Further, the gate 210 is disposed to be separated from the second silicon pillar 820 by the second insulating body 610.

The semiconductor device further comprises a second-conductive type high-concentration impurity region 520 formed in a part of the first silicon pillar 810, a second-conductive type high-concentration impurity region 530 formed in a part of the first silicon pillar 810, a second-conductive type high-concentration impurity region 510 formed in a part of the semiconductor substrate 100, a second-conductive type high-concentration impurity region 540 formed in a part of the second silicon pillar 820, a silicide region 720 formed in a part of the second-conductive type high-concentration impurity region 510, a silicide region 710 formed in the second-conductive type high-concentration impurity region 540, a contact 430 formed on the silicide region 720, a contact 420 formed on the silicide region 710, a contact 410 formed on the gate 210, and an element isolation region 910 formed in the semiconductor substrate 100.

In order to reduce a parasitic capacitance in the thirteenth embodiment, it is desirable that a parasitic capacitance

$C_{ov1}$ between the gate 210 and the semiconductor substrate 100 is less than a gate capacitance $C_g$, as shown in the following formula (13-1):

$$C_{ov1} < C_g \qquad (13\text{-}1)$$

Specifically, given that: a length of the gate 210 is 20 nm; a short side and a long side of the first silicon pillar 810 are 10 nm and 20 nm, respectively; a film thickness $T_{ox}$ of the gate oxide layer 310 is 1 nm; and the interlayer film is made of $SiO_2$. A relationship of the capacitance $C_{vo1}$ between the gate 210 and the semiconductor substrate 100, a dielectric constant $\varepsilon_X$ of the interlayer film 610, a cross-sectional area S1 of the gate 210, and a distance $T_{space1}$ between the gate 210 and the semiconductor substrate 100, is expressed as the following formula (13-2), and then the formula (13-2) is assigned to the formula (13-1) to obtain the following formula (13-3):

$$S1 < \frac{C_g}{\varepsilon_x} T_{space1} \qquad (13\text{-}2)$$

$$C_{ov1} = \frac{\varepsilon_x S1}{T_{space1}} \qquad (13\text{-}3)$$

The gate capacitance $C_g$ is expressed as the following formula (13-4) which is a relational expression of a dielectric constant $\varepsilon_{0X}$ of the gate oxide layer 310, the length l of the gate 210, respective lengths R, 2R of the short and long sides of the first silicon pillar 810, and the film thickness $T_{ox}$ of the gate oxide layer 310, and the cross-sectional area S 1 of the gate 210 is expressed as the following formula (13-5). Thus, the formulas (13-4) and (13-5) are assigned to the formula (13-1) to obtain the following conditional formula (13-6) representing a relationship between the cross-sectional area S 1 of the gate 210, and the distance $T_{space1}$ between the gate 210 and the semiconductor substrate 100:

$$C_g = \frac{\varepsilon_{ox} \cdot 6R \cdot l}{T_{ox}} \qquad (13\text{-}4)$$

$$S1 = \left(R + 2T_{ox} + 2T_{gate1}\right)\left(2R + 2T_{ox} + 2T_{gate1}\right) - \left(R + 2T_{ox}\right)\left(2R + 2T_{ox}\right) \qquad (13\text{-}5)$$

$$\left(R + 2T_{ox} + 2T_{gate1}\right)\left(2R + 2T_{ox} + 2T_{gate1}\right) - \left(R + 2T_{ox}\right)\left(2R + 2T_{ox}\right) < \frac{\varepsilon_{ox} \cdot 6Rl}{\varepsilon_x \cdot T_{ox}} \cdot T_{space1} \qquad (13\text{-}6)$$

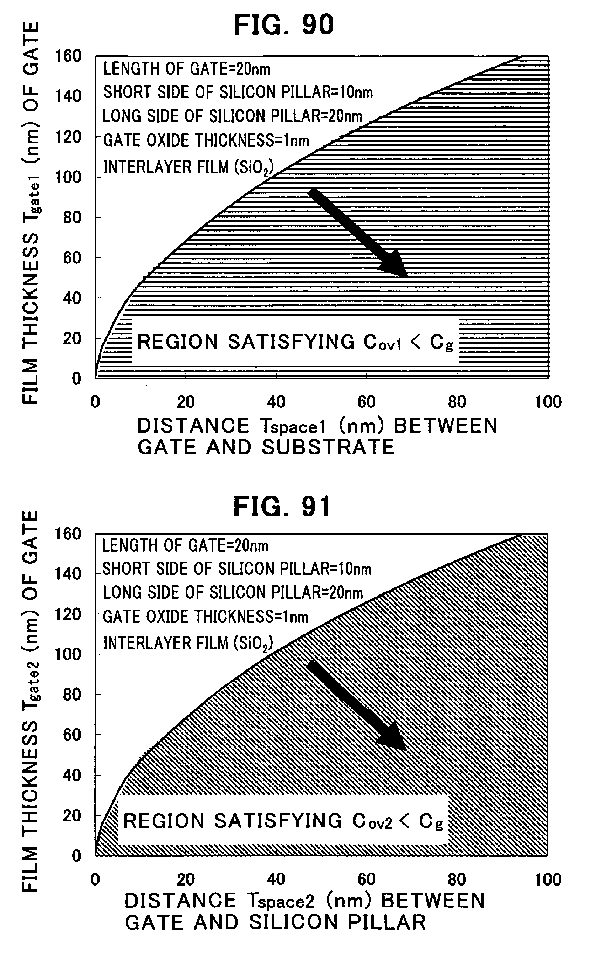

If the conditional formula (13-6) is satisfied, the formula (13-1) is satisfied. Thus, the above values are assigned to the formula (13-6) to obtain the following formula (13-7) (unit in the formula (13-7): nm) (FIG. 90):

$$1.2e3 \cdot T_{space1} < 4T_{gate1}^{\ 2} + 68T_{gate1} \Rightarrow C_{ov1} < C_g \qquad (13\text{-}7)$$

Typically, the length of one side of the first silicon pillar 810 is set in the range of 0.25 nm to 25 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (13-1) will be calculated. Given that: the length R of the short side of the first silicon pillar 810 is 25 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (13-8) which is a relational expression of the dielectric constant $\varepsilon_{0X}$ of the gate oxide layer 310, the length 1 of the gate 210, the length R of the short side of the first silicon pillar 810, and the film thickness $T_{ox}$ of the gate oxide layer 310, and the cross-sectional area S1 of the gate 210 is expressed as the following formula (13-9). Thus, the formulas (13-8) and (13-9) are assigned to the formula (13-3) to obtain the following conditional formula (13-10) representing a relationship between a film thickness $T_{gate1}$ of the gate 210, and the distance $T_{space1}$ between the gate 210 and the semiconductor substrate 100:

$$C_g = \frac{\varepsilon_{ox} \cdot 6R \cdot l}{T_{ox}} \qquad (13\text{-}8)$$

$$S1 = \left(R + 2T_{ox} + 2T_{gate1}\right)\left(2R + 2T_{ox} + 2T_{gate1}\right) - (R + 2T_{ox})(2R + 2T_{ox}) \qquad (13\text{-}9)$$

$$\left(R + 2T_{ox} + 2T_{gate1}\right)\left(2R + 2T_{ox} + 2T_{gate1}\right) - (R + 2T_{ox})(2R + 2T_{ox}) < \frac{\varepsilon_{ox} \cdot 6Rl}{\varepsilon_x \cdot T_{ox}} \cdot T_{space1} \qquad (13\text{-}10)$$

If the conditional formula (13-10) is satisfied, the formula (13-1) is satisfied. Thus, the above values are assigned to the formula (13-10) to obtain the following formula (13-11), and then the following formula (13-12) is obtained from the formula (13-11) (unit in the formulas (13-11) and (13-12): $\mu$m):

$$3.0e6 \cdot T_{space1} < 4T_{gate1}^{2} + 1.5e2T_{gate1} \Rightarrow C_{ov1} < C_g \qquad (13\text{-}11)$$

$$3.0e6 \cdot T_{space1} << 4T_{gate1}^{2} + 1.5e2T_{gate1} \Rightarrow C_{ov1} << C_g \qquad (13\text{-}12)$$

In FIG. 90, $C_{ov1}$ becomes less than $C_g$ in a region on the side of the arrowed direction.
Further, in order to reduce the parasitic capacitance in the thirteenth embodiment, it is desirable that a parasitic capacitance $C_{ov2}$ between the gate 210 and the second silicon pillar 820 is less than the gate capacitance $C_g$, as shown in the following formula (13-13):

$$C_{ov2} < C_g \qquad (13\text{-}13)$$

Specifically, given that: the length of the gate 210 is 20 nm; the length R of the short side of the first silicon pillar 810 is 10 nm; the film thickness $T_{ox}$ of the gate oxide layer 310 is 1 nm; and the interlayer film is made of $SiO_2$. A relationship of the capacitance $C_{ov2}$ between the gate 210 and the second silicon pillar 820, the dielectric constant $\varepsilon_X$ of the interlayer film 610, a cross-sectional area S2 of the gate 210, and a distance $T_{space2}$ between the gate 210 and the second silicon pillar 820, is expressed as the following formula (13-14), and then the formula (13-14) is assigned to the formula (13-13) to obtain the following formula (13-15):

$$S2 < \frac{C_g}{\varepsilon_x} T_{space2} \qquad (13\text{-}14)$$

$$C_{ov2} = \frac{\varepsilon_x S2}{T_{space2}} \qquad (13\text{-}15)$$

The gate capacitance $C_g$ is expressed as the following formula (13-16) which is a relational expression of the dielectric constant $\varepsilon_{0x}$ of the gate oxide layer 310, the length 1 of the gate 210, a peripheral length w (6R) of the first silicon pillar 810, and the film thickness $T_{ox}$ of the gate oxide layer 310, and the cross-sectional area S2 of the gate 210 is expressed as the following formula (13-17). Thus, the formulas (13-16) and (13-17) are assigned to the formula (13-16) to obtain the following conditional formula (13-18) representing a relationship between the cross-sectional area S2 of the gate 210, and the distance $T_{space2}$ between the gate 210 and the second silicon pillar 820:

$$C_g = \frac{\varepsilon_{ox} \cdot 6R \cdot l}{T_{ox}} \qquad (13\text{-}16)$$

$$S2 = \left(R + 2T_{ox} + 2T_{gate2}\right)\left(2R + 2T_{ox} + 2T_{gate2}\right) - (R + 2T_{ox})(2R + 2T_{ox})$$

$$(13\text{-}17)$$

$$\left(R + 2T_{ox} + 2T_{gate2}\right)\left(2R + 2T_{ox} + 2T_{gate2}\right) - (R + 2T_{ox})(2R + 2T_{ox}) < \frac{\varepsilon_{ox} \cdot 6Rl}{\varepsilon_x \cdot T_{ox}} \cdot T_{space2}$$

$$(13\text{-}18)$$

If the conditional formula (13-18) is satisfied, the formula (13-13) is satisfied. Thus, the above values are assigned to the formula (13-18) to obtain the following formula (13-19) (unit in the formulas (13-19): nm (FIG. 91):

$$1.2e3 \cdot T_{space2} < 4T_{gate2}^{\ 2} + 68T_{gate2} \Rightarrow C_{ov2} < C_g \qquad (13\text{-}19)$$

Typically, the length of one side of the first silicon pillar 810 is set in the range of 0.25 nm to 25 $\mu$m, and the film thickness of the gate oxide layer 310 is set in the range of 0.5 to 100 nm. Further, the length of the gate 210 is set in the range of 5 nm to 10 $\mu$m, and the dielectric constant $\varepsilon_X$ of the interlayer film is set in the range of 3.9 to 7.6. In this structure, conditions satisfying the formula (13-1) will be calculated. Given that: the peripheral length of the first silicon pillar 810 is 25 $\mu$m; the film thickness of the gate oxide layer 310 is 0.5 nm; the length of the gate 210 is 10 $\mu$m, and the dielectric constant $\varepsilon_X$ of the interlayer film is 3.9. The gate capacitance $C_g$ is expressed as the following formula (13-20) which is a relational expression of the dielectric constant $\varepsilon_{0x}$ of the gate oxide layer 310, the length 1 of the gate 210, the peripheral length w of the first silicon pillar 810, and the film thickness $T_{ox}$ of the gate oxide layer 310, and the cross-sectional area S2 of the gate 210 is expressed as the following formula (13-21). Thus, the formulas (13-20) and (13-21) are assigned to the formula (13-15) to obtain the following conditional formula (13-22) representing a relationship between the cross-sectional area S2 of the gate 210, and the distance $T_{space2}$ between the gate 210 and the second silicon pillar 820:

$$C_g = \frac{\varepsilon_{ox} \cdot 4R \cdot l}{T_{ox}} \tag{13-20}$$

$$S2 = (R + 2T_{ox} + 2T_{gate2})(2R + 2T_{ox} + 2T_{gate2}) - (R + 2T_{ox})(2R + 2T_{ox}) \tag{13-21}$$

$$(R + 2T_{ox} + 2T_{gate2})(2R + 2T_{ox} + 2T_{gate2}) - (R + 2T_{ox})(2R + 2T_{ox}) < \frac{\varepsilon_{ox} \cdot 6Rl}{\varepsilon_x \cdot T_{ox}} \cdot T_{space2} \tag{13-22}$$

If the conditional formula (13-22) is satisfied, the formula (13-23) is satisfied. Thus, the above values are assigned to the formula (13-22) to obtain the following formula (13-23), and then the following formula (13-24) is obtained from the formula (13-23) (unit in the formulas (13-23) and (13-24): μm):

$$3.0e6 \cdot T_{space2} < 4T_{gate2}{}^2 + 1.5e2T_{gate2} \Rightarrow C_{ov2} < C_g \tag{13-23}$$

$$3.0e6 \cdot T_{space2} << 4T_{gate2}{}^2 + 1.5e2T_{gate2} \Rightarrow C_{ov2} << C_g \tag{13-24}$$

In FIG. 91, $C_{ov2}$ becomes less than $C_g$ in a region on the side of the arrowed direction.

FOURTEENTH EMBODIMENT: SEMICONDUCTOR DEVICE

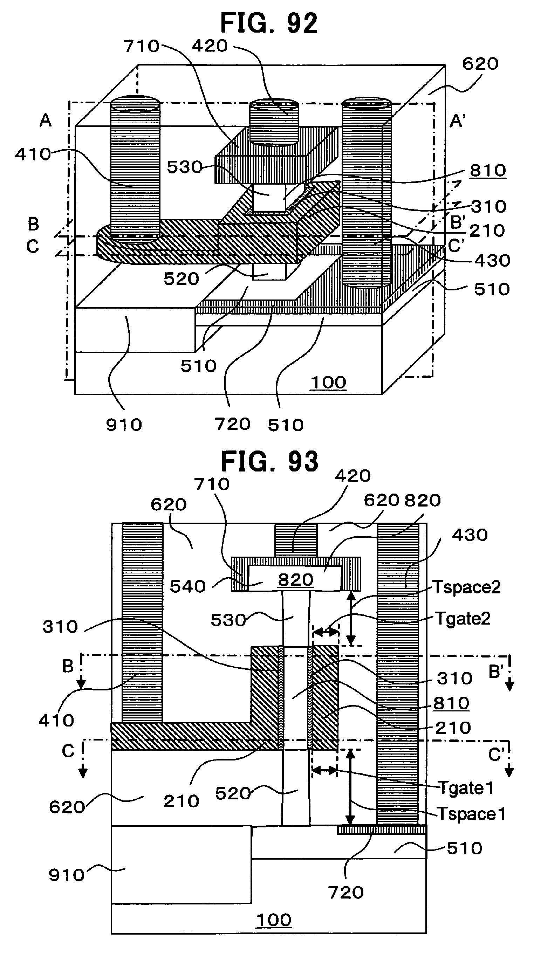

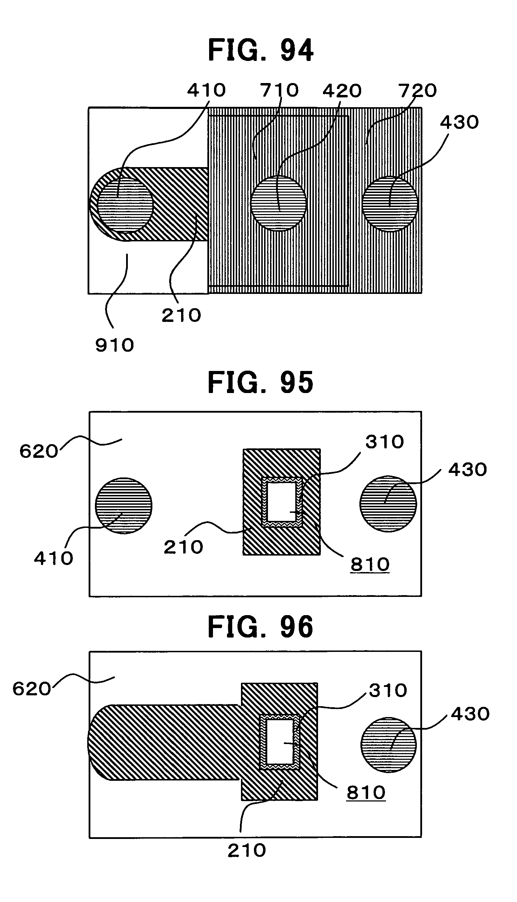

FIG. 92 is a schematic bird's-eye view showing a transistor in a semiconductor device according to the fourteenth embodiment of the present invention, wherein the semiconductor device according to the fourteenth embodiment is the same as that in the thirteenth embodiment, except that the interlayer film 610 made of $SiO_2$ is replaced by an interlayer film 620 made of SiN. FIG. 93 is a schematic sectional view taken along the cutting-plane line A-A' in FIG. 92, and FIG. 94 is a top view of the transistor in FIG. 92. FIG. 95 is a schematic sectional view taken along the cutting-plane line B-B' in FIG. 93, and FIG. 96 is a schematic sectional view taken along the cutting-plane line C-C' in FIG. 93. As with the thirteenth embodiment, in order to reduce a parasitic capacitance in the fourteenth embodiment, it is desirable that the parasitic capacitance $C_{ov1}$ between the gate 210 and the semiconductor substrate 100 is less than the gate capacitance $C_g$, as shown in the following formula (14-1):

$$C_{ov1} < C_g \tag{14-1}$$

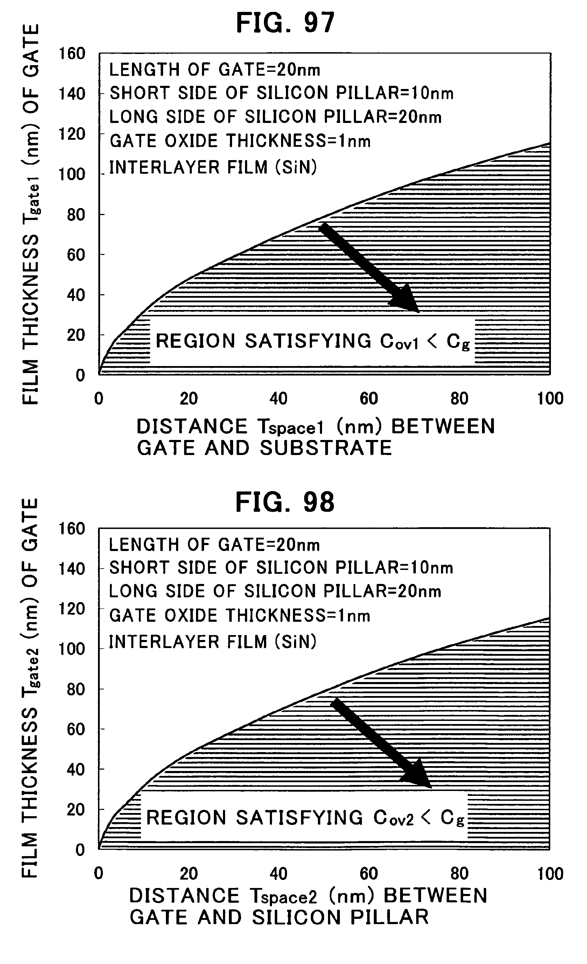

Specifically, given that: the length of the gate 210 is 20 nm; the short and long sides of the first silicon pillar 810 are 10 nm and 20 nm, respectively; and the film thickness $T_{ox}$ of the gate oxide layer 310 is 1.0 nm (EOT). Based on the formula (13-6) in the thirteenth embodiment, the following conditional formula (14-2) representing a relationship between the film thickness $T_{gate1}$ of the gate 210, and the distance $T_{space1}$ between the gate 210 and the semiconductor substrate 100, is obtained (unit in the formulas (14-2): nm) (FIG. 97):

$$6.2e2 \cdot T_{space1} < 4T_{gate1}^{2} + 68T_{gate1} \Rightarrow C_{ov1} < C_{g} \qquad (14\text{-}2)$$

In FIG. 97, $C_{ov1}$ becomes less than $C_g$ in a region on the side of the arrowed direction.

Further, as with the thirteenth embodiment, in order to reduce the parasitic capacitance in the fourteenth embodiment where the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (14-3):

$$C_{ov2} < C_{g} \qquad (14\text{-}3)$$

Based on the formula (13-18) in the thirteenth embodiment, the following conditional formula (14-4) representing a relationship between the film thickness $T_{gate2}$ of the gate 210, and the distance $T_{space2}$ between the gate 210 and the second silicon pillar 820, is obtained (unit in the formula (14-4): nm) (FIG. 98):

$$6.2e2 \cdot T_{space2} < 4T_{gate2}^{2} + 68T_{gate2} \Rightarrow C_{ov2} < C_{g} \qquad (14\text{-}4)$$

In FIG. 98, $C_{ov2}$ becomes less than $C_g$ in a region on the side of the arrowed direction.

FIFTEENTH EMBODIMENT: SEMICONDUCTOR DEVICE

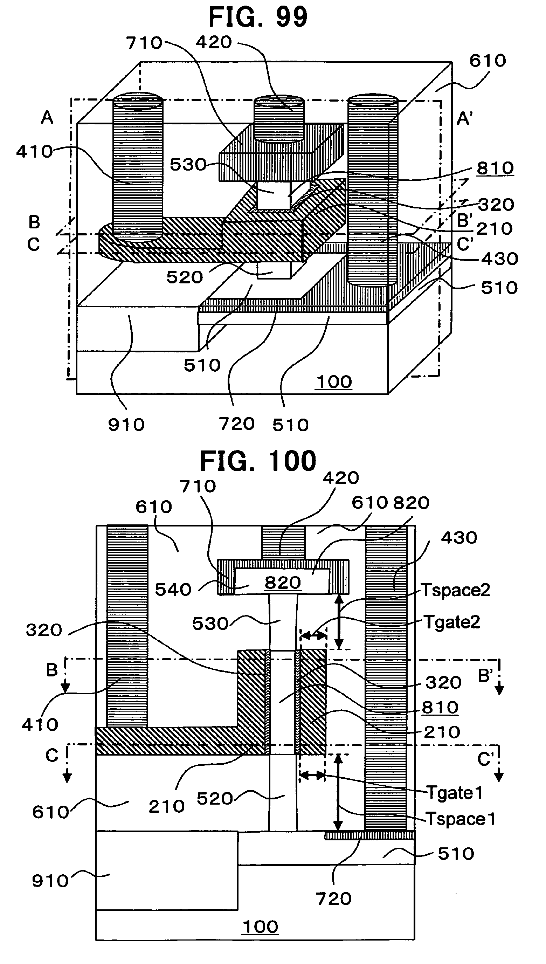

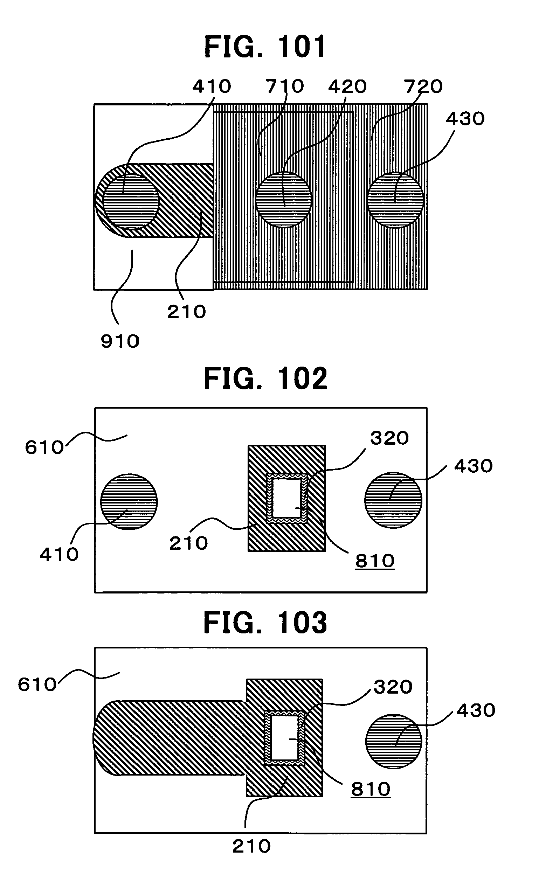

FIG. 99 is a schematic bird's-eye view showing a transistor in a semiconductor device according to the fifteenth embodiment of the present invention, wherein the semiconductor device according to the fifteenth embodiment is the same as that in the thirteenth embodiment, except that the gate oxide layer 310 made of $SiO_2$ is replaced by a gate oxide layer 320 made of $HfO_2$. FIG. 100 is a schematic sectional view taken along the cutting-plane line A-A' in FIG. 99, and FIG. 101 is a top view of the transistor in FIG. 99. FIG. 102 is a schematic sectional view taken along the cutting-plane line B-B' in FIG. 100, and FIG. 103 is a schematic sectional view taken along the cutting-plane line C-C' in FIG. 100. As with the thirteenth embodiment, in order to reduce a parasitic capacitance in the fifteenth embodiment, it is desirable that the parasitic capacitance $C_{ov1}$ between the gate 210 and the semiconductor substrate 100 is less than the gate capacitance $C_g$, as shown in the following formula (15-1):

$$C_{ov1} < C_{g} \qquad (15\text{-}1)$$

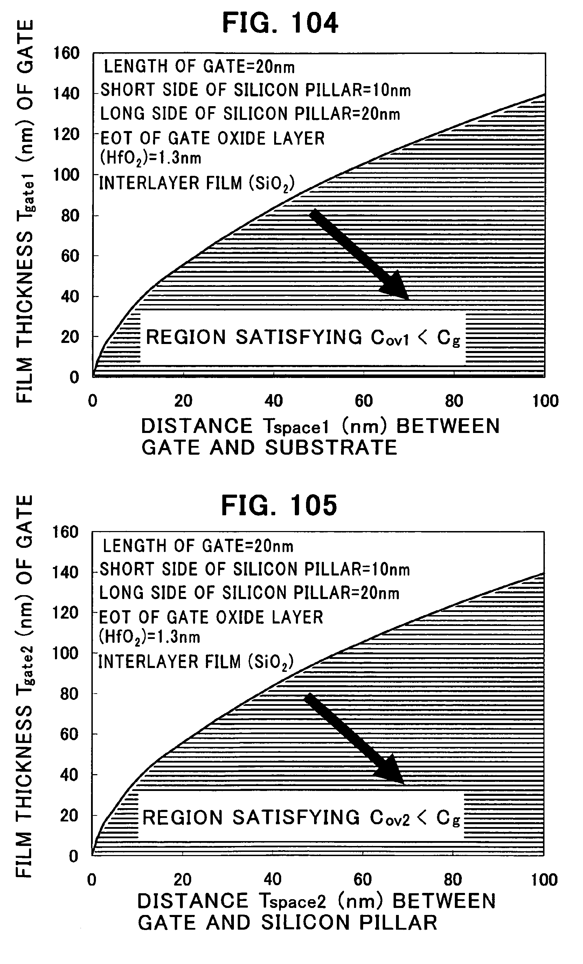

Specifically, given that: the length of the gate 210 is 20 nm; the length R of the short side of the first silicon pillar 810 is 10 nm; and the film thickness $T_{ox}$ of the gate oxide layer 320 made of $HfO_2$ is 1.3 nm (EOT). Based on the formula (13-6) in the thirteenth embodiment, the following conditional formula (15-2) representing a relationship between the film thickness $T_{gate1}$ of the gate 210, and the distance $T_{space1}$ between the gate 210 and the semiconductor substrate 100, is obtained (unit in the formulas (15-2): nm) (FIG. 104):

$$8.0e2 \cdot T_{space1} < 4T_{gate1}^{2} + 1.0e2T_{gate1} \Rightarrow C_{ov1} < C_{g} \qquad (15\text{-}2)$$

In FIG. 104, $C_{ov1}$ becomes less than $C_g$ in a region on the side of the arrowed direction.

Further, as with the thirteenth embodiment, in order to reduce the parasitic capacitance in the fifteenth embodiment where the gate oxide layer 320 is made of SiN, instead of $SiO_2$, it is desirable that the parasitic capacitance $C_{ov2}$ between the gate 210 and the second silicon pillar 820 is less than the gate capacitance $C_g$, as shown in the following formula (15-3):

$$C_{ov2} < C_g \qquad\qquad (15\text{-}3)$$

Based on the formula (13-18) in the thirteenth embodiment, the following conditional formula (15-4) representing a relationship between the film thickness $T_{gate2}$ of the gate 210, and the distance $T_{space2}$ between the gate 210 and the second silicon pillar 820, is obtained (unit in the formula (15-4): nm) (FIG. 105):

$$8.0e2 \cdot T_{space2} < 4T_{gate2}{}^2 + 1.0e2T_{gate2} \Rightarrow C_{ov2} < C_g \qquad\qquad (15\text{-}4)$$

In FIG. 105, $C_{ov2}$ becomes less than $C_g$ in a region on the side of the arrowed direction.

SIXTEENTH EMBODIMENT: SEMICONDUCTOR DEVICE

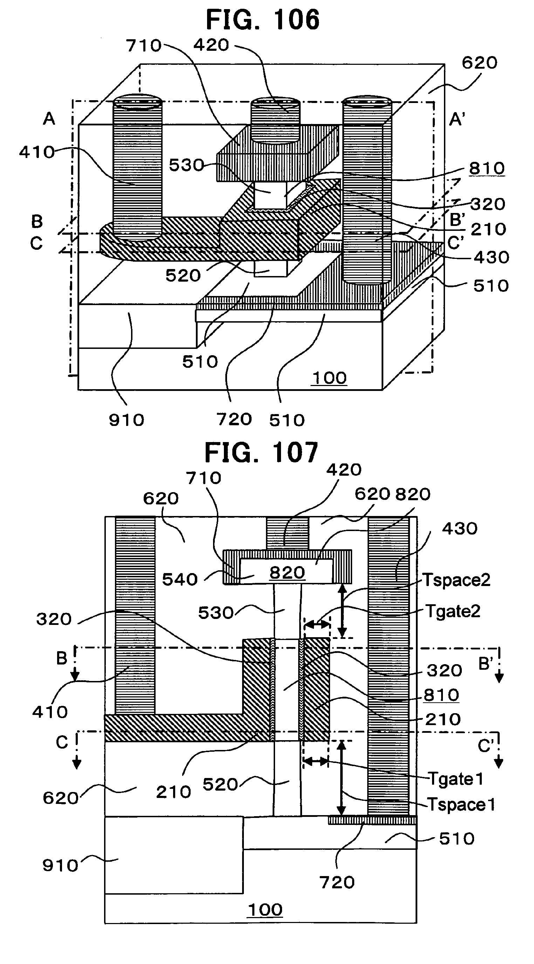

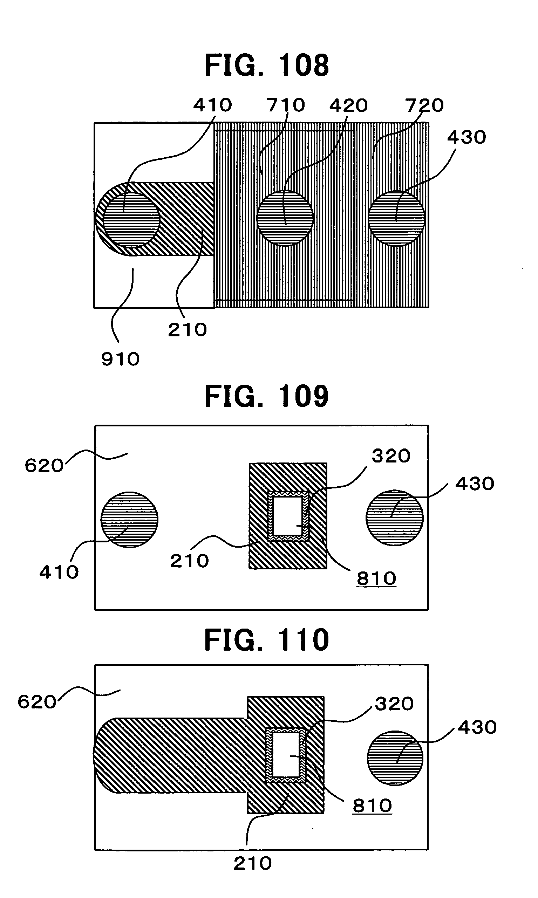

FIG. 106 is a schematic bird's-eye view showing a transistor in a semiconductor device according to the sixteenth embodiment of the present invention, wherein the semiconductor device according to the sixteenth embodiment is the same as that in the thirteenth embodiment, except that the gate oxide layer 310 made of $SiO_2$ is replaced by a gate oxide layer 320 made of $HfO_2$, and the interlayer film 610 made of $SiO_2$ is replaced by an interlayer film 620 made of SiN. FIG. 107 is a schematic sectional view taken along the cutting-plane line A-A' in FIG. 106, and FIG. 108 is a top view of the transistor in FIG. 106. FIG. 109 is a schematic sectional view taken along the cutting-plane line B-B' in FIG. 107, and FIG. 110 is a schematic sectional view taken along the cutting-plane line C-C' in FIG. 107. As with the thirteenth embodiment, in order to reduce a parasitic capacitance in the sixteenth embodiment, it is desirable that the parasitic capacitance $C_{ov1}$ between the gate 210 and the semiconductor substrate 100 is less than the gate capacitance $C_g$, as shown in the following formula (16-1):

$$C_{ov1} < C_g \qquad\qquad (16\text{-}1)$$

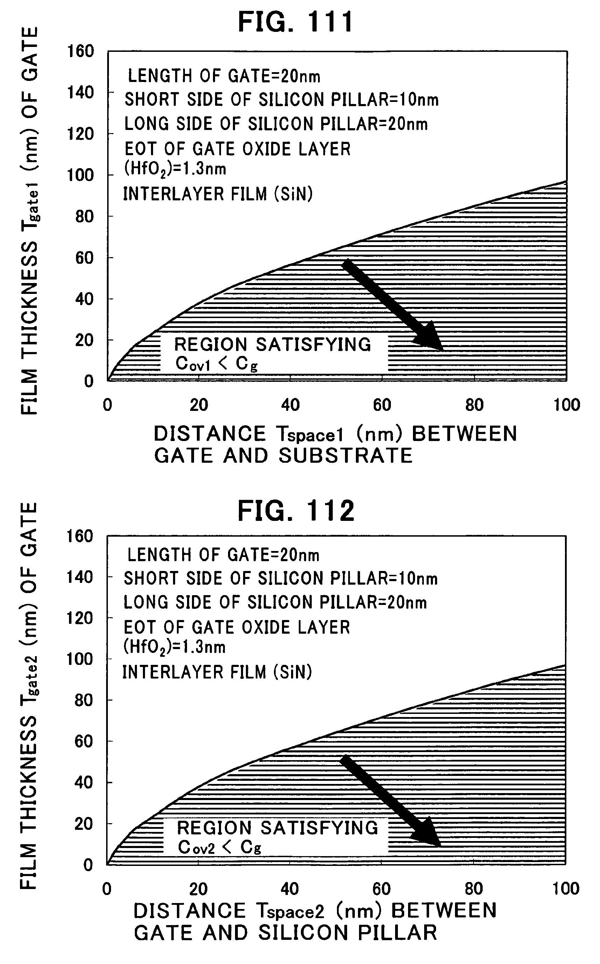

Specifically, given that: the length of the gate 210 is 20 nm; the length R of the short side of the first silicon pillar 810 is 10 nm; and the film thickness $T_{ox}$ of the gate oxide layer 320 made of $HfO_2$ is 1.3 nm (EOT). Based on the formula (13-6) in the thirteenth embodiment, the following conditional formula (16-2) representing a relationship between the film thickness $T_{gate1}$ of the gate 210, and the distance $T_{space1}$ between the gate 210 and the semiconductor substrate 100, is obtained (unit in the formulas (16-2): nm) (FIG. 111):

$$4.1e2 \cdot T_{space1} < 4T_{gate1}{}^2 + 1.0e2T_{gate1} \Rightarrow C_{ov1} < C_g \qquad\qquad (16\text{-}2)$$

In FIG. 111, $C_{ov1}$ becomes less than $C_g$ in a region on the side of the arrowed direction.
Further, as with the thirteenth embodiment, in order to reduce the parasitic capacitance in the sixteenth embodiment where the gate oxide layer 320 is made of SiN, instead of $SiO_2$, and the interlayer film 620 is made of SiN, instead of $SiO_2$, it is desirable that the parasitic capacitance $C_{ov2}$ between the gate 210 and the second silicon pillar 820 is less than the gate capacitance $C_g$, as shown in the following formula (16-3):

$$C_{ov2} < C_g \qquad\qquad (16\text{-}3)$$

Based on the formula (13-18) in the thirteenth embodiment, the following conditional formula (16-4) representing a relationship between the film thickness $T_{gate2}$ of the gate 210, and the distance $T_{space2}$ between the gate 210 and the second silicon pillar 820, is obtained (unit in the formula (16-4): nm) (FIG. 112):

$$4.1e2 \cdot T_{space2} < 4T_{gate2}{}^2 + 1.0e2T_{gate2} \Rightarrow C_{ov2} < C_g \qquad\qquad (16\text{-}4)$$

In FIG. 112, $C_{ov2}$ becomes less than $C_g$ in a region on the side of the arrowed direction.

As above, the present invention provides a semiconductor device which comprises a second-conductive type impurity region formed in a part of a first-conductive type semiconductor substrate, a first silicon pillar of an arbitrary cross-sectional shape formed on the second-conductive type impurity region, a first insulating body surrounding a part of a surface of the first silicon pillar, a gate surrounding the first insulating body, and a second silicon pillar which is formed on the first silicon pillar and which includes a second-conductive type impurity region, wherein: the gate is disposed to be separated from the semiconductor substrate by the first insulating body and is disposed to be separated from the second silicon pillar by a second insulating body; and each of the capacitance between the gate and the semiconductor substrate, and the capacitance between the gate and the second silicon pillar, is less than a gate capacitance.

Thus, the present invention can reduce a parasitic capacitance of a semiconductor device to provide a semiconductor device for a high-speed and low-power consumption ULSI (ultra large-scale integration) circuit.

BRIEF DESCRIPTION OF THE DRAWINGS

FIG. 1 is a bird's-eye view showing a semiconductor device according to a first embodiment of the present invention.
FIG. 2 is a sectional view of the semiconductor device, taken along the line A-A' in FIG. 1.
FIG. 3 is a top view of the semiconductor device in FIG. 1.
FIG. 4 is a sectional view of the semiconductor device, taken along the line B-B' in FIG. 2.
FIG. 5 is a sectional view of the semiconductor device, taken along the line C-C' in FIG. 2.
FIG. 6 is a graph showing a relationship between a cross-sectional area S 1 of a gate, and a distance $T_{space1}$ between the gate and a semiconductor substrate, which is required for satisfying the condition: $C_{ov1} < C_g$, in the semiconductor device in FIG. 1.
FIG. 7 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 1.
FIG. 8 is a bird's-eye view showing a semiconductor device according to a second embodiment of the present invention.
FIG. 9 is a sectional view of the semiconductor device, taken along the line A-A' in FIG. 8.
FIG. 10 is a top view of the semiconductor device in FIG. 8.
FIG. 11 is a sectional view of the semiconductor device, taken along the line B-B' in FIG. 9.
FIG. 12 is a sectional view of the semiconductor device, taken along the line C-C' in FIG. 9.
FIG. 13 is a graph showing a relationship between a cross-sectional area S 1 of a gate, and a distance $T_{space1}$ between the gate and a semiconductor substrate, which is required for satisfying the condition: $C_{ov1} < C_g$, in the semiconductor device in FIG. 9 where an interlayer film is made of SiN.
FIG. 14 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 9 where an interlayer film is made of SiN.
FIG. 15 is a bird's-eye view showing a semiconductor device according to a third embodiment of the present invention.
FIG. 16 is a sectional view of the semiconductor device, taken along the line A-A' in FIG. 15.
FIG. 17 is a top view of the semiconductor device in FIG. 15.
FIG. 18 is a sectional view of the semiconductor device, taken along the line B-B' in FIG. 16.
FIG. 19 is a sectional view of the semiconductor device, taken along the line C-C' in FIG. 16.
FIG. 20 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 15 where a gate oxide layer is made of $HfO_2$.
FIG. 21 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 15 where a gate oxide layer is made of $HfO_2$.
FIG. 22 is a bird's-eye view showing a semiconductor device according to a fourth embodiment of the present invention.
FIG. 23 is a sectional view of the semiconductor device, taken along the line A-A' in FIG. 22.
FIG. 24 is a top view of the semiconductor device in FIG. 22.
FIG. 25 is a sectional view of the semiconductor device, taken along the line B-B' in FIG. 23.
FIG. 26 is a sectional view of the semiconductor device, taken along the line C-C' in FIG. 23.
FIG. 27 is a graph showing a relationship between a cross-sectional area S1 of a gate, and a distance $T_{space1}$

between the gate and a semiconductor substrate, which is required for satisfying the condition: $C_{ov1} < C_g$, in the semiconductor device in FIG. 22 where a gate oxide layer is made of $HfO_2$ and an interlayer film is made of SiN

FIG. 28 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 22 where a gate oxide layer is made of $HfO_2$ and an interlayer film is made of SiN.

FIG. 29 is a bird's-eye view showing a semiconductor device according to a fifth embodiment of the present invention.

FIG. 30 is a sectional view of the semiconductor device, taken along the line A-A' in FIG. 29.

FIG. 31 is a top view of the semiconductor device in FIG. 29.

FIG. 32 is a sectional view of the semiconductor device, taken along the line B-B' in FIG. 30.

FIG. 33 is a sectional view of the semiconductor device, taken along the line C-C' in FIG. 30.

FIG. 34 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 29.

FIG. 35 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 29.

FIG. 36 is a bird's-eye view showing a semiconductor device according to a sixth embodiment of the present invention.

FIG. 37 is a sectional view of the semiconductor device, taken along the line A-A' in FIG. 36.

FIG. 38 is a top view of the semiconductor device in FIG. 36.

FIG. 39 is a sectional view of the semiconductor device, taken along the line B-B' in FIG. 37.

FIG. 40 is a sectional view of the semiconductor device, taken along the line C-C' in FIG. 37.

FIG. 41 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 36 where an interlayer film is made of SiN.

FIG. 42 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 36 where an interlayer film is made of SiN.

FIG. 43 is a bird's-eye view showing a semiconductor device according to a seventh embodiment of the present invention.

FIG. 44 is a sectional view of the semiconductor device, taken along the line A-A' in FIG. 43.

FIG. 45 is a top view of the semiconductor device in FIG. 43.

FIG. 46 is a sectional view of the semiconductor device, taken along the line B-B' in FIG. 44.

FIG. 47 is a sectional view of the semiconductor device, taken along the line C-C' in FIG. 44.

FIG. 48 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 43 where a gate oxide layer is made of $HfO_2$.

FIG. 49 is a graph showing a relationship between a cross-sectional area S2 of the gate, and a distance $T_{opace2}$ between the gate and a second silicon pillar, which is required for satisfying the condition: $C_{ov2} < C_g$, in the semiconductor device in FIG. 43 where a gate oxide layer is made of $HfO_2$.

FIG. 50 is a bird's-eye view showing a semiconductor device according to an eighth embodiment of the present invention.

FIG. 51 is a sectional view of the semiconductor device, taken along the line A-A' in FIG. 50.

FIG. 52 is a top view of the semiconductor device in FIG. 50.

FIG. 53 is a sectional view of the semiconductor device, taken along the line B-B' in FIG. 51.

FIG. 54 is a sectional view of the semiconductor device, taken along the line C-C' in FIG. 51.

FIG. 55 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 50 where a gate oxide layer is made of $HfO_2$ and an interlayer film is made of SiN

FIG. 56 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 50 where a gate oxide layer is made of $HfO_2$, and an interlayer film is made of SiN.

FIG. 57 is a bird's-eye view showing a semiconductor device according to a ninth embodiment of the present invention.

FIG. 58 is a sectional view of the semiconductor device, taken along the line A-A' in FIG. 57.

FIG. 59 is a top view of the semiconductor device in FIG. 57.

FIG. 60 is a sectional view of the semiconductor device, taken along the line B-B' in FIG. 58.

FIG. 61 is a sectional view of the semiconductor device, taken along the line C-C' in FIG. 58.

FIG. 62 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 57.

FIG. 63 is a graph showing a relationship between a cross-sectional area S2 of the gate, and a distance $T_{opace2}$ between the gate and a second silicon pillar, which is required for satisfying the condition: $C_{ov2} < C_g$, in the semiconductor device in FIG. 57.

FIG. 64 is a bird's-eye view showing a semiconductor device according to a tenth embodiment of the present invention.

FIG. 65 is a sectional view of the semiconductor device, taken along the line A-A' in FIG. 64.

FIG. 66 is a top view of the semiconductor device in FIG. 64.

FIG. 67 is a sectional view of the semiconductor device, taken along the line B-B' in FIG. 65.

FIG. 68 is a sectional view of the semiconductor device, taken along the line C-C' in FIG. 65.

FIG. 69 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 64 where an interlayer film is made of SiN.

FIG. 70 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 64 where an interlayer film is made of SiN.

FIG. 71 is a bird's-eye view showing a semiconductor device according to an eleventh embodiment of the present invention.

FIG. 72 is a sectional view of the semiconductor device, taken along the line A-A' in FIG. 71.

FIG. 73 is a top view of the semiconductor device in FIG. 71.

FIG. 74 is a sectional view of the semiconductor device, taken along the line B-B' in FIG. 72.

FIG. 75 is a sectional view of the semiconductor device, taken along the line C-C' in FIG. 72.

FIG. 76 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 71 where a gate oxide layer is made of $HfO_2$.

FIG. 77 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 71 where a gate oxide layer is made of $HfO_2$.

FIG. 78 is a bird's-eye view showing a semiconductor device according to a twelfth embodiment of the present invention.

FIG. 79 is a sectional view of the semiconductor device, taken along the line A-A' in FIG. 78.

FIG. 80 is a top view of the semiconductor device in FIG. 78.

FIG. 81 is a sectional view of the semiconductor device, taken along the line B-B' in FIG. 79.

FIG. 82 is a sectional view of the semiconductor device, taken along the line C-C' in FIG. 79.

FIG. 83 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 78 where a gate oxide layer is made of $HfO_2$ and an interlayer film is made of SiN

FIG. 84 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 78 where a gate oxide layer is made of $HfO_2$, and an interlayer film is made of SiN.

FIG. 85 is a bird's-eye view showing a semiconductor device according to a thirteenth embodiment of the present invention.

FIG. 86 is a sectional view of the semiconductor device, taken along the line A-A' in FIG. 85.

FIG. 87 is a top view of the semiconductor device in FIG. 85.

FIG. 88 is a sectional view of the semiconductor device, taken along the line B-B' in FIG. 86.

FIG. 89 is a sectional view of the semiconductor device, taken along the line C-C' in FIG. 86.

FIG. 90 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 85.

FIG. 91 is a graph showing a relationship between a cross-sectional area S2 of the gate, and a distance $T_{opace2}$ between the gate and a second silicon pillar, which is required for satisfying the condition: $C_{ov2} < C_g$, in the semiconductor device in FIG. 85.

FIG. 92 is a bird's-eye view showing a semiconductor device according to a fourteenth embodiment of the present invention.

FIG. 93 is a sectional view of the semiconductor device, taken along the line A-A' in FIG. 92.

FIG. 94 is a top view of the semiconductor device in FIG. 92.

FIG. 95 is a sectional view of the semiconductor device, taken along the line B-B' in FIG. 93.

FIG. 96 is a sectional view of the semiconductor device, taken along the line C-C' in FIG. 93.

FIG. 97 is a graph showing a relationship between a cross-sectional area S1 of a gate, and a distance $T_{space1}$

between the gate and a semiconductor substrate, which is required for satisfying the condition: $C_{ov1} < C_g$, in the semiconductor device in FIG. 92 where an interlayer film is made of SiN.

FIG. 98 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 92 where an interlayer film is made of SiN.

FIG. 99 is a bird's-eye view showing a semiconductor device according to a fifteenth embodiment of the present invention.

FIG. 100 is a sectional view of the semiconductor device, taken along the line A-A' in FIG. 99.

FIG. 101 is a top view of the semiconductor device in FIG. 99.

FIG. 102 is a sectional view of the semiconductor device, taken along the line B-B' in FIG. 100.

FIG. 103 is a sectional view of the semiconductor device, taken along the line C-C' in FIG. 100.

FIG. 104 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 99 where a gate oxide layer is made of $HfO_2$.

FIG. 105 is a graph showing a relationship between a cross-sectional area S2 of the gate, and a distance $T_{space2}$ between the gate and a second silicon pillar, which is required for satisfying the condition: $C_{ov2} < C_g$, in the semiconductor device in FIG. 99 where a gate oxide layer is made of $HfO_2$.

FIG. 106 is a bird's-eye view showing a semiconductor device according to a sixteenth embodiment of the present invention.

FIG. 107 is a sectional view of the semiconductor device, taken along the line A-A' in FIG. 106.

FIG. 108 is a top view of the semiconductor device in FIG. 106.

FIG. 109 is a sectional view of the semiconductor device, taken along the line B-B' in FIG. 107.

FIG. 110 is a sectional view of the semiconductor device, taken along the line C-C' in FIG. 107.

FIG. 111 is a graph showing a relationship between a cross-sectional area S1 of a gate, and a distance $T_{space1}$ between the gate and a semiconductor substrate, which is required for satisfying the condition: $C_{ov1} < C_g$, in the semiconductor device in FIG. 106 where a gate oxide layer is made of $HfO_2$ and an interlayer film is made of SiN

FIG. 112 is a graph showing a relationship between a cross-sectional area S2 of the gate, and a distance $T_{opace2}$ between the gate and a second silicon pillar, which is required for satisfying the condition: $C_{ov2} < C_g$, in the semiconductor device in FIG. 106 where a gate oxide layer is made of $HfO_2$, and an interlayer film is made of SiN.

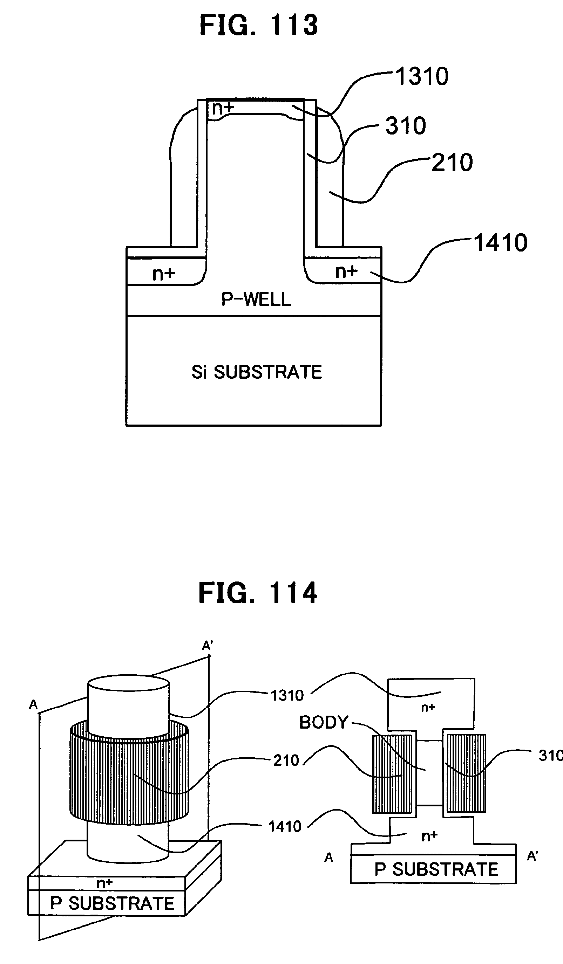

FIG. 113 is a sectional view showing one example of a conventional SGT.

FIG. 114 is a bird's-eye view showing one example of a conventional SGT, and a sectional view taken along the line A-A' therein

FIG. 115 is a sectional view showing one example of a conventional SGT designed to reduce a parasitic capacitance.

FIG. 116 is a sectional view showing another example of the conventional SGT designed to reduce a parasitic capacitance.

EXPLANATION OF CODES

| | |
|---|---|
| 100: | semiconductor substrate |
| 210: | gate |
| 310: | gate oxide layer $SiO_2$ |
| 320: | gate oxide layer $HfO_2/SiO_2$ |
| 410, 420, 430: | contact |
| 510, 520, 530, 540: | high-concentration impurity diffusion region |
| 610: | interlayer insulating film ($SiO_2$) |
| 620: | interlayer insulating film (SiN) |
| 710, 720: | silicide |
| 810, 820: | silicon pillar |
| 910: | element isolation film |
| 1010: | high-resistance region |
| 1110: | sidewall oxide film |
| 1210: | contact-hole etching-stopper layer |
| 1310: | source |
| 1410: | drain |
| 1510: | CMP-stopper layer |
| 1610: | channel region |

$T_{space1}$:         distance between gate and semiconductor substrate
$T_{gate1}$:         film thickness of first end of gate
$T_{gate1}$:         film thickness of second end of gate
$T_{space2}$:         distance between gate and second silicon pillar
S 1:         cross-sectional area of first end of gate
S2:         cross-sectional area of second end of gate

**Claims**

1.  A semiconductor device comprising:

    a second-conductive type impurity region formed in a part of a first-conductive type semiconductor substrate;
    a first silicon pillar of an arbitrary cross-sectional shape formed on the second-conductive type impurity region;
    a first insulating body surrounding a part of a surface of the first silicon pillar;
    a gate surrounding the first insulating body; and
    a second silicon pillar which is formed on the first silicon pillar and which includes a second-conductive type impurity region,
    wherein:

    the gate is disposed to be separated from the semiconductor substrate by the first insulating body and is disposed to be separated from the second silicon pillar by a second insulating body; and
    the capacitance between the gate and the semiconductor substrate is less than a gate capacitance, and the capacitance between the gate and the second silicon pillar is less than the gate capacitance.

2.  A semiconductor device comprising:

    a second-conductive type impurity region formed in a part of a first-conductive type semiconductor substrate;
    a first silicon pillar of an arbitrary cross-sectional shape formed on the second-conductive type impurity region;
    a first insulating body surrounding a part of a surface of the first silicon pillar;
    a gate surrounding the first insulating body; and
    a second silicon pillar which is formed on the first silicon pillar and which includes a second-conductive type impurity region,
    wherein:

    the gate is disposed to be separated from the semiconductor substrate by the first insulating body and is disposed to be separated from the second silicon pillar by a second insulating body; and
    the capacitance between the gate and the semiconductor substrate is sufficiently less than a gate capacitance, and the capacitance between the gate and the second silicon pillar is sufficiently less than the gate capacitance.

3.  The semiconductor device according to claim 1, wherein the cross-sectional area (unit: nm$^2$) of the gate is less than the value derived by multiplying a distance (unit: nm) between the gate and the semiconductor substrate separated by the second insulating body, by $2 \times 10^9$, and is less than the value derived by multiplying the distance (unit: nm) between the gate and the second silicon pillar separated by the second insulating body, by $2 \times 10^9$.

4.  The semiconductor device according to claim 2, wherein the cross-sectional area (unit: nm$^2$) of the gate is sufficiently less than the value derived by multiplying a distance (unit: nm) between the gate and the semiconductor substrate separated by the second insulating body, by $2 \times 10^9$, and is sufficiently smaller than the value derived by multiplying a distance (unit: nm) between the gate and the second silicon pillar separated by the second insulating body, by $2 \times 10^9$.

5.  The semiconductor device according to claim 1, wherein:

    the first silicon pillar is comprised of a cross-sectionally circular-shaped silicon pillar; and
    each of the first insulating body surrounding the part of the surface of the first silicon pillar and the gate surrounding the first insulating body has a cross-sectionally circular ring shape.

6. The semiconductor device according to claim 5, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$2.0e6 \cdot T_{space1} < \pi T_{gate1}^{\ 2} + 1.0e2 T_{gate1} \ ;$$

and
the thickness $T_{gate2}$ (unit: $\mu$m) of the other end of the gate, and a distance $T_{space2}$ (unit: $\mu$m) between the gate and the second silicon pillar separated by the second insulating body, satisfy the following relational expression:

$$2.0e6 \cdot T_{space2} < \pi T_{gate2}^{\ 2} + 1.0e2 T_{gate2} \ .$$

7. The semiconductor device according to claim 2, wherein:

the first silicon pillar is comprised of a cross-sectionally circular-shaped silicon pillar; and
each of the first insulating body surrounding the part of the surface of the first silicon pillar and the gate surrounding the first insulating body has a cross-sectionally circular ring shape.

8. The semiconductor device according to claim 7, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$2.0e6 \cdot T_{space1} << \pi T_{gate1}^{\ 2} + 1.0e2 T_{gate1} \ ;$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$2.0e6 \cdot T_{space2} << \pi T_{gate2}^{\ 2} + 1.0e2 T_{gate2} \ .$$

9. The semiconductor device according to claim 1, wherein:

the first silicon pillar is comprised of a cross-sectionally square-shaped silicon pillar; and
each of the first insulating body surrounding the part of the surface of the first silicon pillar and the gate surrounding the first insulating body has a cross-sectionally square shape.

10. The semiconductor device according to claim 9, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$2.0e6 \cdot T_{space1} < 4 T_{gate1}^{\ 2} + 1.0e2 T_{gate1} \ ;$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$2.0e6 \cdot T_{space2} < 4T_{gate2}^{2} + 1.0e2T_{gate2} .$$

11. The semiconductor device according to claim 2, wherein:

the first silicon pillar is comprised of a cross-sectionally square-shaped silicon pillar; and
each of the first insulating body surrounding the part of the surface of the first silicon pillar and the gate surrounding the first insulating body has a cross-sectionally square shape.

12. The semiconductor device according to claim 11, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$2.0e6 \cdot T_{space1} << 4T_{gate1}^{2} + 1.0e2T_{gate1} ; \,$$

and
the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$2.0e6 \cdot T_{space2} << 4T_{gate2}^{2} + 1.0e2T_{gate2} .$$

13. The semiconductor device according to claim 1, wherein:

the first silicon pillar is comprised of a cross-sectionally rectangular-shaped silicon pillar; and
each of the first insulating body surrounding the part of the surface of the first silicon pillar and the gate surrounding the first insulating body has a cross-sectionally rectangular shape.

14. The semiconductor device according to claim 13, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$3.0e6 \cdot T_{space1} < 4T_{gate1}^{2} + 1.5e2T_{gate1} ;$$

and
the thickness $T_{gate2}$ (unit: $\mu$m) of the other end of the gate, and a distance $T_{space2}$ (unit: $\mu$m) between the gate and the second silicon pillar separated by the second insulating body, satisfy the following relational expression:

$$3.0e6 \cdot T_{space2} < 4T_{gate2}^{2} + 1.5e2T_{gate2} .$$

15. The semiconductor device according to claim 2, wherein:

the first silicon pillar is comprised of a cross-sectionally rectangular-shaped silicon pillar; and

each of the first insulating body surrounding the part of the surface of the first silicon pillar and the gate surrounding the first insulating body has a cross-sectionally rectangular shape.

16. The semiconductor device according to claim 15, wherein:

the thickness $T_{gate1}$ (unit: $\mu$m) of one of opposite ends of the gate and a distance $T_{space1}$ (unit: $\mu$m) between the gate and the semiconductor substrate separated by the second insulating body satisfy the following relational expression:

$$3.0e6 \cdot T_{space1} << 4T_{gate1}^{\;2} + 1.5e2T_{gate1} \; ;$$

and

the thickness $T_{gate2}$ (unit: $\mu$m) of the other end of the gate and a distance $T_{space2}$ (unit: $\mu$m) between the gate and the second silicon pillar separated by the second insulating body satisfy the following relational expression:

$$3.0e6 \cdot T_{space2} << 4T_{gate2}^{\;2} + 1.5e2T_{gate2} \; .$$

17. The semiconductor device according to any one of claims 1 to 16, wherein the second insulating body is made of $SiO_2$ or SiN, or has a layered structure of $SiO_2$ and SiN.

18. The semiconductor device according to any one of claims 1 to 17, wherein the first insulating body is made of one selected from the group consisting of $SiO_2$, $HfO_2$, and SiON.

19. The semiconductor device according to any one of claims 1 to 18, wherein the gate is made of a material selected from the group consisting of TaN, TiN, NiSi, $Ni_3Si$, $Ni_2Si$, PtSi, $Pt_3Si$, and W.

20. The semiconductor device according to any one of claims 1 to 19, wherein the first silicon pillar includes a second-conductive type high-concentration impurity region adjacent the second-conductive type impurity region formed in the part of the semiconductor substrate, and a second-conductive type high-concentration impurity region adjacent the second silicon pillar.

21. The semiconductor device according to any one of claims 1 to 20, which further comprises a second-conductive type high-concentration impurity region formed in a part of the second silicon pillar.

22. The semiconductor device according to claim 21, which further comprises a silicide region formed in a part of the second-conductive type impurity region formed in the part of the semiconductor substrate, and a silicide region formed in a part of a second-conductive type high-concentration impurity region of the second silicon pillar.

# FIG. 1

# FIG. 2

# FIG. 3

# FIG. 4

# FIG. 5

## FIG. 6

LENGTH OF GATE=20nm

PERIPHERAL LENGTH OF
SILICON PILLAR=31.4nm

GATE OXIDE THICKNESS=1nm

INTERLAYER FILM ($SiO_2$)

REGION SATISFYING
$C_{ov1} < C_g$

CROSS-SECTIONAL AREA S1 ($nm^2$) OF GATE

DISTANCE $T_{space1}$ (nm) BETWEEN
GATE AND SUBSTRATE

## FIG. 7

LENGTH OF GATE=20nm

PERIPHERAL LENGTH OF
SILICON PILLAR=31.4nm

GATE OXIDE THICKNESS=1nm

INTERLAYER FILM ($SiO_2$)

REGION SATISFYING
$C_{ov2} < C_g$

CROSS-SECTIONAL AREA S2 ($nm^2$) OF GATE

DISTANCE $T_{space2}$ (nm) BETWEEN
GATE AND SILICON PILLAR

# FIG. 8

# FIG. 9

# FIG. 10

# FIG. 11

# FIG. 12

## FIG. 13

CROSS-SECTIONAL AREA S1 ($nm^2$) OF GATE

LENGTH OF GATE=20nm
PERIPHERAL LENGTH OF
SILICON PILLAR=31.4nm
GATE OXIDE THICKNESS=1nm
INTERLAYER FILM (SiN)

REGION SATISFYING
$C_{ov1} < C_g$

DISTANCE $T_{space1}$ (nm) BETWEEN
GATE AND SUBSTRATE

## FIG. 14

CROSS-SECTIONAL AREA S2 ($nm^2$) OF GATE

LENGTH OF GATE=20nm
PERIPHERAL LENGTH OF
SILICON PILLAR=31.4nm
GATE OXIDE THICKNESS=1nm
INTERLAYER FILM (SiN)

REGION SATISFYING
$C_{ov2} < C_g$

DISTANCE $T_{space2}$ (nm) BETWEEN
GATE AND SILICON PILLAR

## FIG. 15

## FIG. 16

# FIG. 17

410   710   420   720
430
210
910

# FIG. 18

610
410
320   430
210
810

# FIG. 19

610
320   430
810
210

## FIG. 20

LENGTH OF GATE=20nm
PERIPHERAL LENGTH OF SILICON PILLAR=31.4nm
EOT OF GATE OXIDE LAYER (High-k)=1nm
INTERLAYER FILM ($SiO_2$)

REGION SATISFYING $C_{ov1} < C_g$

CROSS-SECTIONAL AREA S1 ($nm^2$) OF GATE

DISTANCE $T_{space1}$ (nm) BETWEEN GATE AND SUBSTRATE

## FIG. 21

LENGTH OF GATE=20nm
PERIPHERAL LENGTH OF SILICON PILLAR=31.4nm
EOT OF GATE OXIDE LAYER (High-k)=1nm
INTERLAYER FILM ($SiO_2$)

REGION SATISFYING $C_{ov2} < C_g$

CROSS-SECTIONAL AREA S2 ($nm^2$) OF GATE

DISTANCE $T_{space2}$ (nm) BETWEEN GATE AND SILICON PILLAR

# FIG. 22

# FIG. 23

# FIG. 24

# FIG. 25

# FIG. 26

## FIG. 27

LENGTH OF GATE=20nm

PERIPHERAL LENGTH OF SILICON PILLAR=31.4nm

EOT OF GATE OXIDE LAYER (High-k)=1nm

INTERLAYER FILM (SiN)

REGION SATISFYING $C_{ov1} < C_g$

CROSS-SECTIONAL AREA S1 ($nm^2$) OF GATE

DISTANCE Tspace1 (nm) BETWEEN GATE AND SUBSTRATE

## FIG. 28

LENGTH OF GATE=20nm

PERIPHERAL LENGTH OF SILICON PILLAR=31.4nm

EOT OF GATE OXIDE LAYER (High-k)=1nm

INTERLAYER FILM (SiN)

REGION SATISFYING $C_{ov2} < C_g$

CROSS-SECTIONAL AREA S2 ($nm^2$) OF GATE

DISTANCE Tspace2 (nm) BETWEEN GATE AND SILICON PILLAR

# FIG. 29

710   420

610

A                    A'

410        530        810

B                    B'   310

C                    C'   210

520                       430
                          510

510

910    720   510    100

# FIG. 30

610  710        420    610

                              430

540    820              Tspace2

310                     Tgate2

B                    B'
                          310
410                       810
                          210
C                    C'
                          Tgate1
610    210  520           Tspace1

910                       510

            720

100

# FIG. 31

410   710   420   720

430

910

210

# FIG. 32

610

410   310   430

210   810

# FIG. 33

610

310   430

210   810

## FIG. 34

LENGTH OF GATE=20nm
RADIUS OF SILICON PILLAR=5nm
GATE OXIDE THICKNESS=1nm
INTERLAYER FILM ($SiO_2$)

REGION SATISFYING
$C_{ov1} < C_g$

FILM THICKNESS $T_{gate1}$ (nm) OF GATE

DISTANCE $T_{space1}$ (nm) BETWEEN
GATE AND SUBSTRATE

## FIG. 35

LENGTH OF GATE=20nm
RADIUS OF SILICON PILLAR=5nm
GATE OXIDE THICKNESS=1nm
INTERLAYER FILM ($SiO_2$)

REGION SATISFYING
$C_{ov2} < C_g$

FILM THICKNESS $T_{gate2}$ (nm) OF GATE

DISTANCE $T_{space2}$ (nm) BETWEEN
GATE AND SILICON PILLAR

# FIG. 36

# FIG. 37

## FIG. 38

## FIG. 39

## FIG. 40

## FIG. 41

FILM THICKNESS $T_{gate1}$ (nm) OF GATE

LENGTH OF GATE=20nm
RADIUS OF SILICON PILLAR=5nm
GATE OXIDE THICKNESS=1nm
INTERLAYER FILM (SiN)

REGION SATISFYING
$C_{ov1} < C_g$

DISTANCE $T_{space1}$ (nm) BETWEEN
GATE AND SUBSTRATE

## FIG. 42

FILM THICKNESS $T_{gate2}$ (nm) OF GATE

LENGTH OF GATE=20nm
RADIUS OF SILICON PILLAR=5nm
GATE OXIDE THICKNESS=1nm
INTERLAYER FILM (SiN)

REGION SATISFYING
$C_{ov2} < C_g$

DISTANCE $T_{space2}$ (nm) BETWEEN
GATE AND SILICON PILLAR

# FIG. 43

# FIG. 44

# FIG. 45

# FIG. 46

# FIG. 47

## FIG. 48

LENGTH OF GATE=20nm
RADIUS OF SILICON PILLAR=5nm
EOT OF GATE OXIDE LAYER
(High-k)=1.3nm
INTERLAYER FILM ($SiO_2$)

REGION SATISFYING
$C_{ov1} < C_g$

FILM THICKNESS $T_{gate1}$ (nm) OF GATE

DISTANCE $T_{space1}$ (nm) BETWEEN
GATE AND SUBSTRATE

## FIG. 49

LENGTH OF GATE=20nm
RADIUS OF SILICON PILLAR=5nm
EOT OF GATE OXIDE LAYER
(High-k)=1.3nm
INTERLAYER FILM ($SiO_2$)

REGION SATISFYING
$C_{ov2} < C_g$

FILM THICKNESS $T_{gate2}$ (nm) OF GATE

DISTANCE $T_{space2}$ (nm) BETWEEN
GATE AND SILICON PILLAR

# FIG. 50

710 420 620

A A'

410 530 810

B B' 320

C C' 210

520 430

510

510 100

910 720 510

# FIG. 51

620 710 420 620

430

540 820 Tspace2

320 Tgate2

530

B B'

320

410 810

210

C C' Tgate1

620 210 520 Tspace1

510

910 720

100

## FIG. 52

## FIG. 53

## FIG. 54

## FIG. 55

Graph — Y-axis: FILM THICKNESS $T_{gate1}$ (nm) OF GATE; X-axis: DISTANCE $T_{space1}$ (nm) BETWEEN GATE AND SUBSTRATE

LENGTH OF GATE=20nm
RADIUS OF SILICON PILLAR=5nm
EOT OF GATE OXIDE LAYER ($HfO_2$)=1.3nm
INTERLAYER FILM (SiN)

REGION SATISFYING $C_{ov1} < C_g$

## FIG. 56

Graph — Y-axis: FILM THICKNESS $T_{gate2}$ (nm) OF GATE; X-axis: DISTANCE $T_{space2}$ (nm) BETWEEN GATE AND SILICON PILLAR

LENGTH OF GATE=20nm
RADIUS OF SILICON PILLAR=5nm
EOT OF GATE OXIDE LAYER ($HfO_2$)=3nm
INTERLAYER FILM (SiN)

REGION SATISFYING $C_{ov2} < C_g$

# FIG. 57

# FIG. 58

# FIG. 59

# FIG. 60

# FIG. 61

## FIG. 62

FILM THICKNESS $T_{gate1}$ (nm) OF GATE

LENGTH OF GATE=20nm
ONE SIDE OF SILICON PILLAR=10nm
GATE OXIDE THICKNESS=1nm
INTERLAYER FILM $(SiO_2)$

REGION SATISFYING
$C_{ov1} < C_g$

DISTANCE $T_{space1}$ (nm) BETWEEN
GATE AND SUBSTRATE

## FIG. 63

FILM THICKNESS $T_{gate2}$ (nm) OF GATE

LENGTH OF GATE=20nm
ONE SIDE OF SILICON PILLAR=10nm
GATE OXIDE THICKNESS=1nm
INTERLAYER FILM $(SiO_2)$

REGION SATISFYING
$C_{ov2} < C_g$

DISTANCE $T_{space2}$ (nm) BETWEEN
GATE AND SILICON PILLAR

## FIG. 64

## FIG. 65

# FIG. 66

# FIG. 67

# FIG. 68

## FIG. 69

FILM THICKNESS $T_{gate1}$ (nm) OF GATE

DISTANCE $T_{space1}$ (nm) BETWEEN GATE AND SUBSTRATE

LENGTH OF GATE=20nm
ONE SIDE OF SILICON PILLAR=10nm
GATE OXIDE THICKNESS=1nm
INTERLAYER FILM (SiN)

REGION SATISFYING
$C_{ov1} < C_g$

## FIG. 70

FILM THICKNESS $T_{gate2}$ (nm) OF GATE

DISTANCE $T_{space2}$ (nm) BETWEEN GATE AND SILICON PILLAR

LENGTH OF GATE=20nm
ONE SIDE OF SILICON PILLAR=10nm
GATE OXIDE THICKNESS=1nm
INTERLAYER FILM (SiN)

REGION SATISFYING
$C_{ov2} < C_g$

# FIG. 71

710  420                          610

A                                A'

410
    530                          810
                                 320
B                                B'
C                                C'  210

520                              430
    510                          510

910        720  510

100

# FIG. 72

610  710           420    610  820

540        820                430

320                          Tspace2

530                          Tgate2

B                            B'
                             320
                             810
410                          210
C                            C'
                             Tgate1
610  210  520

                             Tspace1

910                          510

                    720

100

## FIG. 73

## FIG. 74

## FIG. 75

## FIG. 76

FILM THICKNESS $T_{gate1}$ (nm) OF GATE

LENGTH OF GATE=20nm
ONE SIDE OF SILICON PILLAR=10nm
EOT OF GATE OXIDE LAYER
($HfO_2$)=1.3nm
INTERLAYER FILM ($SiO_2$)

REGION SATISFYING $C_{ov1} < C_g$

DISTANCE $T_{space1}$ (nm) BETWEEN
GATE AND SUBSTRATE

## FIG. 77

FILM THICKNESS $T_{gate2}$ (nm) OF GATE

LENGTH OF GATE=20nm
ONE SIDE OF SILICON PILLAR=10nm
EOT OF GATE OXIDE LAYER
($HfO_2$)=1.3nm
INTERLAYER FILM ($SiO_2$)

REGION SATISFYING $C_{ov2} < C_g$

DISTANCE $T_{space2}$ (nm) BETWEEN
GATE AND SILICON PILLAR

# FIG. 78

# FIG. 79

## FIG. 80

410    710    420    720
430
210
910

## FIG. 81

620    410    320    430
210    810

## FIG. 82

620    320    430
210    810

## FIG. 83

LENGTH OF GATE=20nm

ONE SIDE OF SILICON PILLAR=10nm

EOT OF GATE OXIDE LAYER
($HfO_2$)=1.3nm

INTERLAYER FILM (SiN)

REGION SATISFYING
$C_{ov1} < C_g$

FILM THICKNESS $T_{gate1}$ (nm) OF GATE

DISTANCE $T_{space1}$ (nm) BETWEEN
GATE AND SUBSTRATE

## FIG. 84

LENGTH OF GATE=20nm

ONE SIDE OF SILICON PILLAR=10nm

EOT OF GATE OXIDE LAYER
($HfO_2$)=1.3nm

INTERLAYER FILM (SiN)

REGION SATISFYING
$C_{ov2} < C_g$

FILM THICKNESS $T_{gate2}$ (nm) OF GATE

DISTANCE $T_{space2}$ (nm) BETWEEN
GATE AND SILICON PILLAR

EP 2 219 210 A1

# FIG. 85

# FIG. 86

# FIG. 87

# FIG. 88

# FIG. 89

## FIG. 90

FILM THICKNESS $T_{gate1}$ (nm) OF GATE

LENGTH OF GATE=20nm
SHORT SIDE OF SILICON PILLAR=10nm
LONG SIDE OF SILICON PILLAR=20nm
GATE OXIDE THICKNESS=1nm
INTERLAYER FILM (SiO$_2$)

REGION SATISFYING $C_{ov1} < C_g$

DISTANCE $T_{space1}$ (nm) BETWEEN GATE AND SUBSTRATE

## FIG. 91

FILM THICKNESS $T_{gate2}$ (nm) OF GATE

LENGTH OF GATE=20nm
SHORT SIDE OF SILICON PILLAR=10nm
LONG SIDE OF SILICON PILLAR=20nm
GATE OXIDE THICKNESS=1nm
INTERLAYER FILM (SiO$_2$)

REGION SATISFYING $C_{ov2} < C_g$

DISTANCE $T_{space2}$ (nm) BETWEEN GATE AND SILICON PILLAR

## FIG. 92

710 420 620
A A'
410 530
810
310
B B' 210
C C' 430
520 510
510 100
910 720 510

## FIG. 93

620 710 420 620 820
540 820 430
Tspace2
310 Tgate2
B B'
410 310
810
C C' 210
620 210 520 Tgate1
Tspace1
510
910 720
100

# FIG. 94

410    710    420    720    430

910    210

# FIG. 95

620    310    430

410    210    810

# FIG. 96

620    310    430

210    810

## FIG. 97

LENGTH OF GATE=20nm
SHORT SIDE OF SILICON PILLAR=10nm
LONG SIDE OF SILICON PILLAR=20nm
GATE OXIDE THICKNESS=1nm
INTERLAYER FILM (SiN)

REGION SATISFYING $C_{ov1} < C_g$

FILM THICKNESS $T_{gate1}$ (nm) OF GATE

DISTANCE $T_{space1}$ (nm) BETWEEN GATE AND SUBSTRATE

## FIG. 98

LENGTH OF GATE=20nm
SHORT SIDE OF SILICON PILLAR=10nm
LONG SIDE OF SILICON PILLAR=20nm
GATE OXIDE THICKNESS=1nm
INTERLAYER FILM (SiN)

REGION SATISFYING $C_{ov2} < C_g$

FILM THICKNESS $T_{gate2}$ (nm) OF GATE

DISTANCE $T_{space2}$ (nm) BETWEEN GATE AND SILICON PILLAR

# FIG. 99

710    420    610

A                              A'

410

530                                    810
                                       320
                                       210
B                              B'
C                              C'    430

520                                  510

510

910    720    510    100

# FIG. 100

710    420    610 820

610                          430

540    820
                             Tspace2
                             Tgate2
320    530

B                              B'
                             320
410                          810
                             210
C                              C'
                             Tgate1
610    210    520            Tspace1

910                          510
                      720
                      100

# FIG. 101

410   710   420   720

430

210

910

# FIG. 102

610

320

430

210

410

810

# FIG. 103

610

320

430

810

210

## FIG. 104

FILM THICKNESS $T_{gate1}$ (nm) OF GATE

LENGTH OF GATE=20nm
SHORT SIDE OF SILICON PILLAR=10nm
LONG SIDE OF SILICON PILLAR=20nm
EOT OF GATE OXIDE LAYER ($HfO_2$)=1.3nm
INTERLAYER FILM ($SiO_2$)

REGION SATISFYING $C_{ov1} < C_g$

DISTANCE $T_{space1}$ (nm) BETWEEN GATE AND SUBSTRATE

## FIG. 105

FILM THICKNESS $T_{gate2}$ (nm) OF GATE

LENGTH OF GATE=20nm
SHORT SIDE OF SILICON PILLAR=10nm
LONG SIDE OF SILICON PILLAR=20nm
EOT OF GATE OXIDE LAYER ($HfO_2$)=1.3nm
INTERLAYER FILM ($SiO_2$)

REGION SATISFYING $C_{ov2} < C_g$

DISTANCE $T_{space2}$ (nm) BETWEEN GATE AND SILICON PILLAR

# FIG. 106

# FIG. 107

# FIG. 108

# FIG. 109

# FIG. 110

## FIG. 111

FILM THICKNESS $T_{gate1}$ (nm) OF GATE

LENGTH OF GATE=20nm
SHORT SIDE OF SILICON PILLAR=10nm
LONG SIDE OF SILICON PILLAR=20nm
EOT OF GATE OXIDE LAYER
$(HfO_2)$=1.3nm
INTERLAYER FILM (SiN)

REGION SATISFYING
$C_{ov1} < C_g$

DISTANCE $T_{space1}$ (nm) BETWEEN
GATE AND SUBSTRATE

## FIG. 112

FILM THICKNESS $T_{gate2}$ (nm) OF GATE

LENGTH OF GATE=20nm
SHORT SIDE OF SILICON PILLAR=10nm
LONG SIDE OF SILICON PILLAR=20nm
EOT OF GATE OXIDE LAYER
$(HfO_2)$=1.3nm
INTERLAYER FILM (SiN)

REGION SATISFYING
$C_{ov2} < C_g$

DISTANCE $T_{space2}$ (nm) BETWEEN
GATE AND SILICON PILLAR

# FIG. 113

1310

310

210

n+

1410

n+                    n+

P-WELL

Si SUBSTRATE

# FIG. 114

A'

A

1310

n+

BODY

210

310

1410

n+

n+

A        P SUBSTRATE        A'

P SUBSTRATE

# FIG. 115

210
1610 1310 610 410
310
610
210
610
1510
1510
1410

Si SUBSTRATE

# FIG. 116

1210
1110
410 410 410
610
610
210
310
210 410
210 N+ N− N− N+
N+
N−
P

P-WELL

<div align="center">

### INTERNATIONAL SEARCH REPORT

</div>

| | International application No. |
|---|---|
| | PCT/JP2007/073452 |

**A. CLASSIFICATION OF SUBJECT MATTER**
*H01L21/336*(2006.01)i, *H01L29/78*(2006.01)i

According to International Patent Classification (IPC) or to both national classification and IPC

**B. FIELDS SEARCHED**

Minimum documentation searched (classification system followed by classification symbols)
H01L21/336, H01L29/78

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 7-99311 A (Mitsubishi Electric Corp.), 11 April, 1995 (11.04.95), Par. Nos. [0077] to [0092]; Figs. 1, 2, 13 & US 5994735 A  & US 6127209 A & US 6420751 B1  & US 2002/0195652 A1 & JP 3403231 B2  & US 6882006 B2 | 1-22 |
| Y | JP 2000-91578 A (Lucent Technologies Inc.), 31 March, 2000 (31.03.00), Par. Nos. [0019] to [0037]; Fig. 2 & EP 989599 A1  & US 6027975 A & KR 2000017583 A  & EP 989599 B1 & DE 69909205 E  & KR 572647 B1 | 1-22 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 February, 2008 (21.02.08) | 04 March, 2008 (04.03.08) |

| Name and mailing address of the ISA/ Japanese Patent Office | Authorized officer |
|---|---|
| Facsimile No. | Telephone No. |

Form PCT/ISA/210 (second sheet) (April 2007)

**INTERNATIONAL SEARCH REPORT**

International application No.

PCT/JP2007/073452

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2004/021445 A1  (National Institute of Advanced Industrial Science and Technology), 11 March, 2004 (11.03.04), Page 18, lines 2 to 13; Figs. 1 to 4, 7 & AU 2003264342 A1     & JP 2004-532752 A | 1-22 |
| Y | JP 6-69441 A  (Motorola, Inc.), 11 March, 1994 (11.03.94), Par. Nos. [0008] to [0020], [0074]; Figs. 1 to 4 & US 5308782 A          & KR 306095 B | 1-22 |
| Y | JP 2003-101012 A  (Sony Corp.), 04 April, 2003 (04.04.03), Par. Nos. [0014] to [0051]; Figs. 1 to 7 (Family: none) | 1-22 |
| Y | JP 2001-102573 A  (Toshiba Corp.), 13 April, 2001 (13.04.01), Par. Nos. [0003] to [0006] & EP 1089344 A2          & CN 1290040 A & KR 2001039928 A        & TW 469651 A & US 6495890 B1          & CN 1560926 A & CN 1262017 C | 1-22 |
| A | JP 8-227997 A  (Hitachi, Ltd.), 03 September, 1996 (03.09.96), Par. Nos. [0010] to [0011]; Figs. 1, 2 (Family: none) | 1-22 |
| A | JP 2000-022145 A  (Toshiba Corp.), 21 January, 2000 (21.01.00), Fig. 14 & US 6724025 B1 | 1-22 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6027975 A, John M. Hergenrother
- US 5504359 A, Mark S. Rodder

**Non-patent literature cited in the description**

- **H. Takato et al.** *IEEE transaction on electron devices,* March 1991, vol. 38 (3), 573-578
- **M. Iwai et al.** *Extended Abstracts of the 2003 International Conference on Solid State Devices and Materials,* 2003, 630-631